(19) Europäisches Patentamt / European Patent Office / Office européen des brevets

(11) **EP 3 449 177 B1**

(12) **EUROPEAN PATENT SPECIFICATION**

(45) Date of publication and mention of the grant of the patent:
**16.08.2023   Bulletin 2023/33**

(21) Application number: **17788802.1**

(22) Date of filing: **27.04.2017**

(51) International Patent Classification (IPC):
**F21K 9/232** *(2016.01)*          **F21Y 107/00** *(2016.01)*
**F21Y 115/10** *(2016.01)*          **H01L 25/075** *(2006.01)*

(52) Cooperative Patent Classification (CPC):
(C-Sets available)
**F21K 9/232; H01L 25/0753;** F21Y 2107/00;
H01L 2224/48091; H01L 2924/19107          (Cont.)

(86) International application number:
**PCT/CN2017/082278**

(87) International publication number:
**WO 2017/186150 (02.11.2017 Gazette 2017/44)**

(54) **LED LIGHT BULB**

LED-GLÜHLAMPE

AMPOULE À DEL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.04.2016   CN 201610272153**
**29.04.2016   CN 201610281600**
**03.06.2016   CN 201610394610**
**07.07.2016   CN 201610544049**
**22.07.2016   CN 201610586388**
**01.11.2016   CN 201610936171**
**06.12.2016   CN 201611108722**
**13.01.2017   CN 201710024877**
**14.02.2017   CN 201710079423**
**09.03.2017   CN 201710138009**
**23.03.2017   CN 201710180574**
**11.04.2017   CN 201710234618**

(43) Date of publication of application:
**06.03.2019   Bulletin 2019/10**

(73) Proprietor: **Jiaxing Super Lighting Electric Appliance Co., Ltd.**
**Jiaxing, Zhejiang 314031 (CN)**

(72) Inventors:
• **JIANG, Tao**
 **Jiaxing**
 **Zhejiang 314031 (CN)**
• **LI, Liqin**
 **Jiaxing**
 **Zhejiang 314031 (CN)**

(74) Representative: **John, Stefano Pasquale**
**6 Chalfont Road**
**Oxford OX2 6TH (GB)**

(56) References cited:
**CN-A- 103 542 308          CN-A- 104 075 169**
**CN-A- 105 020 612          CN-A- 105 226 167**
**CN-U- 203 585 912          CN-U- 203 907 265**
**CN-U- 204 986 570          TW-A- 201 501 358**
**US-A1- 2012 281 411      US-A1- 2015 069 442**
**US-A1- 2015 070 871**

**(Cont. next page)**

(52) Cooperative Patent Classification (CPC): (Cont.)

C-Sets
H01L 2224/48091, H01L 2924/00014

## Description

### RELATED APPLICATIONS

The present application claims priority to CN201610281600.9 filed April 29, 2016, CN201610272153.0 filed April 27, 2016, CN201610394610.3 filed June 3, 2016, CN201610586388.7 filed July 22, 2016, CN201610544049.2 filed July 7, 2016, CN201610936171.4 filed November 1, 2016 and CN201611108722.4 filed December 6, 2016, CN201710024877.8 filed January 13, 2017, CN201710079423.0 filed February 14, 2017, CN201710138009.2 filed March 9, 2017, CN201710180574.5 filed March 23, 2017, CN 201710234618.8 filed April 11, 2017, each of which is incorporated herein by reference in its entirety.

If (1) a term in the present application conflicts with the term used in a previous application to which the present application claims priority, or (2) conflicts with a term in an application incorporated by reference (2a) into the present application or into (2b) an application to which the present application claims priority, a construction based on the term as used or defined in the present application prevails

### FIELD OF THE INVENTION

The present invention relates to LED luminaries. More particularly, this invention describes an LED light bulb having an LED filament.

### BACKGROUND OF THE INVENTION

Incandescent light bulbs are a source of electric light that creates light by running electricity through a resistive filament, thereby heating the filament to a very high temperature, so that it glows and produces visible light. Incandescent bulbs are made in a wide range of sizes and voltages, from 1.5 volts to about 300 volts. The bulbs consist of a generally glass or plastic enclosure with a filament of tungsten wire inside the bulb through which an electrical current is passed. Incandescent lamps are designed as direct "plug-in" components that mate with a lampholder via a threaded Edison base connector (sometimes referred to as an "Edison base" in the context of an incandescent light bulb), a bayonet-type base connector (i.e., bayonet base in the case of an incandescent light bulb), or other standard base connector to receive standard electrical power (e.g., 120 volts A.C., 60 Hz in the United States, or 230V A.C., 50 Hz in Europe, or 12 or 24 or other D.C. voltage). The base provides electrical connections to the filament. Usually a stem or glass mount anchors to the base, allowing the electrical contacts to run through the envelope without gas or air leaks.

Incandescent light bulbs are widely used in household and commercial lighting, for portable lighting, such as table lamps, car headlamps, flashlights, and for decorative and advertising lighting. However, incandescent light bulbs are generally inefficient in terms of energy use and are subject to frequent replacement due to their limited lifetime (about 1,000 hours). Approximately 90% of the energy input is emitted as heat. These lamps are gradually being replaced by other, more efficient types of electric light such as fluorescent lamps, high-intensity discharge lamps, light emitting diodes (LEDs), etc. For the same energy input, these technologies give more visible light and generate much less heat. Particularly, LEDs consume a fraction of the energy used to illuminate incandescent bulbs and have a much longer lifetime (e.g. 50,000 to 75,000 hours). Furthermore, LED light sources are a very clean "green" light source and also provide good color reproduction.

LED light bulbs are far more efficient than traditional incandescent lamps, most notably because they use only a small fraction of the electricity of an incandescent. As traditional incandescent bulbs continue to be phased out, LED has become the mainstream light sources used on a variety of indoor and outdoor lighting fixtures. However, traditional LED light bulbs are not without its disadvantages, for example, the complicated designs which incorporate the heavy aluminum heat sinks and an electronic circuit for power conversion. Consequently, the cost is high and the shape is somewhat strange compared with the elegant incandescent bulbs people are accustomed to.

An LED filament bulb is a light bulb that uses LEDs as its filaments. Accordingly, it is desirable to provide a novel LED filament light bulb with improved performance and aesthetics that may be used as a better replacement for a typical incandescent light bulb than traditional LED light bulbs.

The LED has advantages of environmental protection, energy saving, high efficiency and long lifespan, and therefore it attracts widespread attention in recent years and gradually replaces traditional lighting lamps. However, due that the luminescence of the LED has directivity, current LED lamps is unable to provide with an illumination with a wide angle range like traditional lamps. Accordingly, how to design LED lamps with similar wide range of illumination to the traditional lamps challenges the industries.

Recently, an LED light bulb has been provided and gradually replaces the use of incandescent light bulbs. The kind of the LED light bulbs is provided with multiple LED filaments due to the limited illuminating angle of LED light sources. The LED filaments are aligned in a circle in the LED light bulb, and each of the LED filaments faces different angles for illumination, such that the illuminating angle of the LED light bulb could be increased in general. The manufacturing process of the LED filament includes: fixing multiple LED chips in series to a long, narrow glass substrate, enclosing the whole glass substrate by silicone gel mixed with phosphor powders, and processing electrical connection of the LED filament. When the LED filaments are welded to a stand in the LED light bulb, the LED filaments have to be welded one by one, which is numerous and complicated. Further, the LED filaments are welded in a spot welding manner, which requires high standard regarding property and size of materials, and has a risk of faulty welded joint. In appearance, the LED filaments are hard and straight and lack flexibility and variation. The conventional LED light bulb gives people nothing more than a visually stiff feeling and cannot provide an aesthetic appearance.

In addition, the color temperature of light generated by the LED filaments is usually too high such that the use of the LED filaments is only suitable for limited environments. In a comfort and relax occasion, using conventional tungsten filament bulbs with low color temperature of light for illumination is much better.

Further, the LED filaments generate a large amount of heat during operation. Heat may damage components in the LED light bulb such as LED chips and a driving circuit and lower the efficiency of the LED filaments.

## OBJECTS AND SUMMARY OF THE INVENTION

It is an object of the present invention that light is emitted from one or more LED filaments uniformly and evenly in all directions, instead of beaming in a direction while leaving everywhere else dark the way that many traditional LED light bulbs do. Thus, the LED filament light bulb features a close resemblance with the traditional incandescent bulb. Desirably, the visually unpleasant aluminum die cast for heat dissipation in traditional LED light bulbs is no longer required in the LED filament light bulb. Thus, the LED filament light bulb is perfect for homes, hotels, restaurants, bars and places where classic style and appearance is critical. Desirably, all electronics of the LED filament light bulb is nestled inside the light bulb which is almost not visible. Desirably, light produced by the LED filament light bulb is similar to natural light. It does not have any infrared or ultraviolet radiation and it is uniform and soft on the eyes. After the regulations that banned the sale of the traditional light bulbs, many homeowners could not put in compact fluorescent bulbs or other bogus LED lights into most of these old fixtures and chandeliers. Desirably, the LED filament light bulb fits well into all the lighting fixtures that used the outdated incandescent light bulbs. Desirably, the LED filament light bulb makes it easy to reuse these old and attractive lighting fixtures. Desirably, the LED filament light bulb have remarkable energy efficiency. Desirably, the LED filament has a long service life. This extended lifespan is enhanced by a constant current source that ensures stability of parameters and prolongs the life of the light bulb. Hence, the cost of investing in these bulbs will provide cost savings for up to a few decades in some cases. Desirably, the LED filament light bulb can be placed in places where dimming of lights is necessary. The LED filament light bulb gives off a warm inviting golden soft glow when used in table lamps or as accent lights. The LED filament light bulb is perfect for creating a very pleasant atmosphere in sitting rooms or bedrooms.

Therefore, it is an object of the claimed invention to provide a significantly improved LED filament for using with an LED light bulb. In accordance with an embodiment with the present invention, the LED filament configured for emitting omnidirectional light, comprising: a linear array of LED chips operably interconnected to emit light upon energization; a conductive electrode; the linear array of LED chips is electrically connected with the conductive electrode; and a light conversion coating enclosing the linear array of the LED chip and the conductive electrode, wherein: the light conversion layer includes a top layer and a base layer conformally interconnected to form a unitary enclosure; the top layer is coated on a first side of the linear array of LED chips and the conductive electrode; and the base layer is coated on a second side of the linear array of LED chips and the conductive electrode.

It is an object of the claimed invention to provide an improved LED light bulb, which is easily manufactured, has a wide angle for illumination, and provides an aesthetic appearance.

The invention is an LED light bulb according to claim 1.

In accordance with an embodiment with the present invention, cross sections of the bulb shell on the horizontal plane from the bottom to the top of the bulb shell along the height direction have varied radii, r is the largest value of the varied radii, wherein m1 is set as : $0.8*r \leq m1 \leq 0.9*r$.

In accordance with an embodiment with the present invention, cross sections of the bulb shell on the horizontal plane from the bottom to the top of the bulb shell along the height direction have varied radii, r is the largest value of the varied radii, wherein m2 is set as : $0.8*r \leq m2 \leq 0.9*r$.

In accordance with an embodiment with the present invention, cross sections of the bulb shell on the horizontal plane from the bottom to the top of the bulb shell along the height direction have varied radii, r is the largest value of the varied radii, wherein n is set as : $0 G n \leq 0.47*r$.

According to the embodiments of the instant disclosure, the LED light bulb includes many advantages. For example, the manufacturing of the product is simplified, the angle of emitting light is wide, the color temperature of light could be easily adjusted, the strength of the filament is better, and the whole of the product has a better aesthetic appearance. The LED light lamp is capable to emit omnidirectional light. Moreover, The LED light lamp may also need the least length and the least number of the LED chips while emitting omnidirectional light. As a result, the cost of materials for the manufacture of the LED light bulb may reduce, and the temperature of the LED light bulb during operation can be suppressed.

Various other objects, advantages and features of the present invention will become readily apparent from the ensuing detailed description, and the novel features will be particularly pointed out in the appended claims.

## BRIEF DESCRIPTION OF FIGURES

The following detailed descriptions, given by way of example, and not intended to limit the present invention solely thereto, will be best be understood in conjunction with the accompanying figures:

FIG. 1 is a see-through view of the LED filament in accordance with an embodiment of the present invention;

FIG. 2 is a see-through view of the LED filament in accordance with an embodiment of the present invention;

FIG. 3 is a see-through view of the LED filament in accordance with an embodiment of the present invention;

FIG. 4 includes a see-through view and a cut-open view of the LED filament in accordance with an embodiment of the present invention;

FIGs. 7A to 7D are schematic views of the linear array of LED devices in accordance with an embodiment of the present invention;

FIGs. 8A to 8F are schematic views of the linear array of LED devices in accordance with an embodiment of the present invention;

FIGs. 9A and 9B are schematic views of the LED filament in accordance with an embodiment of the present invention;

FIGs. 10A to 10C are schematic views of the LED filament in accordance with an embodiment of the present invention;

FIGs. 11A to 11C are schematic views of the LED filament in accordance with an embodiment of the present invention;

FIGs. 12A to 12D are schematic views of the LED filament in accordance with an embodiment of the present invention;

FIG. 13 is a front view of the LED light bulb in accordance with an embodiment of the present invention;

FIG. 33 illustrates a perspective view of an LED light bulb with partial sectional view according to a first embodiment of the LED filament;

FIG. 34 illustrates a partial cross-sectional view at section 34-34 of FIG. 33;

FIGs. 35A and 35B illustrate disposition of the metal electrodes and the plurality of LED chips according to other embodiments of the LED filament;

FIG. 36 illustrates a perspective view of an LED filament with partial sectional view according to a second embodiment of the present disclosure;

FIG. 37 illustrates a partial cross-sectional view at section 37-37 of FIG. 36;

FIG. 38A illustrates a first embodiment of the uncut circuit film according to the second embodiment of the LED filament;

FIG. 38B illustrates the alignment between the LED chips and the first embodiment of the uncut circuit film of FIG. 38A;

FIG. 39A illustrates a second embodiment of the uncut circuit film according to the second embodiment of the LED filament;

FIG. 39B illustrates the alignment between the LED chips and the second embodiment of the uncut circuit film of FIG. 39A;

FIG. 40A illustrates a third embodiment of the uncut circuit film according to the second embodiment of the LED filament;

FIG. 40B illustrates the alignment between the LED chips and the third embodiment of the uncut circuit film of FIG. 40A;

FIGs. 41A to 41E illustrate a manufacturing method of an LED filament according to a first embodiment of the present disclosure;

FIG. 42 illustrates a manufacturing method of an LED filament according to a second embodiment of the present disclosure;

FIGs. 43A to 43E illustrate a manufacturing method of an LED filament according to a third embodiment of the present disclosure;

FIGs. 44A and 44B illustrate a perspective view of an LED light bulb according to a first and a second embodiments of the present disclosure;

FIG. 45A illustrates a perspective view of an LED light bulb according to a third embodiment of the present disclosure;

FIG. 45B illustrates an enlarged cross-sectional view of the dashed-line circle of FIG. 45A;

FIG. 45C is a perspective view of an LED light bulb according to an embodiment of the present invention;

FIG. 45D is a projection of a top view of an LED filament of an LED light bulb of FIG. 45C;

FIG. 45E is a perspective view of an LED light bulb according to an embodiment of the present invention;

FIG. 45F is a front view of an LED light bulb of FIG. 45E;

FIG. 45G is a side view of an LED light bulb of FIG. 45E;

FIG. 45H is a top view of an LED light bulb of FIG. 45E;

FIG. 45I is a partially enlarged, cross-sectional view of a bulb shell of an LED light bulb according to a first embodiment of the present invention;

FIG. 45J is a partially enlarged, cross-sectional view of a bulb shell of an LED light bulb according to a second embodiment of the present invention;

FIG. 45K is a partially enlarged, cross-sectional view of a bulb shell of an LED light bulb according to a third embodiment of the present invention;
FIG. 45L is a perspective view of an LED light bulb according to another embodiment of the present invention;
FIG. 45M is a side view of an LED light bulb according to yet another embodiment of the present invention;
FIG. 45N is a perspective view of a bulb shell of an LED light bulb according to an embodiment of the present invention;
FIG. 46A illustrates a cross-sectional view of an LED light bulb according to a fourth embodiment of the present disclosure;
FIG. 46B illustrates the circuit board of the driving circuit of the LED light bulb according to the fourth embodiment of the present disclosure;

## DETAILED DESCRIPTION OF THE EMBODIMENTS

The invention will be described more fully hereinafter with reference to the accompanying drawings, in which example embodiments of the invention are shown. This invention may, however, be embodied in many different forms and should not be construed as limited to the example embodiments set forth herein. Rather, the disclosed embodiments are provided so that this disclosure will be thorough and complete, and will fully convey the scope of the invention to those skilled in the art. In the drawings, the size and relative sizes of layers and regions may be exaggerated for clarity. Like numbers refer to like elements throughout.

It will be understood that when an element or layer is referred to as being "on," "connected to," "coupled to" or "responsive to" (and/or variants thereof) another element, it can be directly on or directly connected, coupled or responsive to the other element or intervening elements may be present. In contrast, when an element is referred to as being "directly on," "directly connected to," "directly coupled to" or "directly responsive to" (and/or variants thereof) another element, there are no intervening elements present. As used herein, the term "and/or" includes any and all combinations of one or more of the associated listed items and may be abbreviated as "/".

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

The terminology used herein is for purposes of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising" (and/or variants thereof), when used in this specification, specify the presence of stated features, integers, steps, operations, elements, and/or components, but do not preclude the presence or addition of one or more other features, integers, steps, operations, elements, components, and/or groups thereof. In contrast, the term "consisting of" (and/or variants thereof) when used in this specification, specifies the stated number of features, integers, steps, operations, elements, and/or components, and precludes additional features, integers, steps, operations, elements, and/or components.

The present invention is described below with reference to block diagrams and/or flowchart illustrations of methods and/or apparatus (systems) according to embodiments of the invention. It is understood that a block of the block diagrams and/or flowchart illustrations, and combinations of blocks in the block diagrams and/or flowchart illustrations, can embody apparatus/systems (structure), means (function) and/or steps (methods) for implementing the functions/acts specified in the block diagrams and/or flowchart block or blocks. It should also be noted that in some alternate implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Example embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, may be expected. Thus, the disclosed example embodiments of the invention should not be construed as limited to the particular shapes of regions illustrated herein unless expressly so defined herein, but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention, unless expressly so defined herein.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and the present application, and will not be interpreted in an idealized or overly formal sense unless expressly so defined herein.

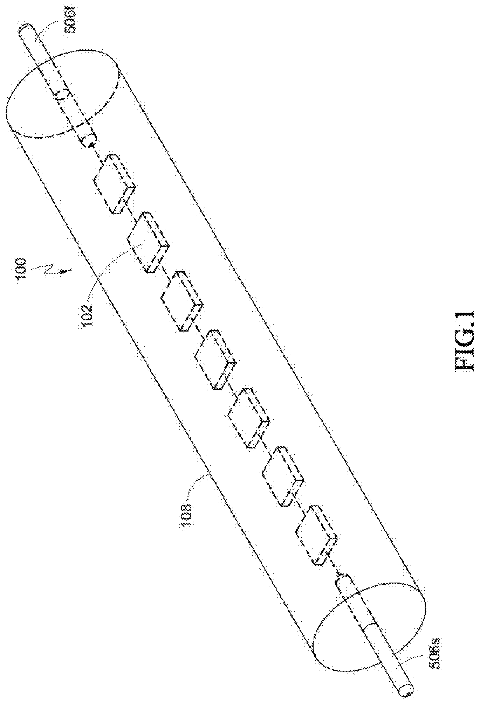

Fig. 1 is a see-through view of the LED filament 100 according to an embodiment of the invention. The LED filament 100 includes an enclosure 108, a linear array of LED devices (e.g. LED chips) 102 and an electrical connector 506. The linear array of LED devices 102 is disposed in the enclosure 108 to be operable to emit light when energized through the electrical connector 506. The enclosure is either straight or curvaceous. The enclosure has a cross section in any regular shapes (e.g. circle and polygon) or irregular shapes (e.g. petal and star). In Fig. 1, the enclosure 108 is a straight cylinder having a circular cross section. The enclosure 108 is made of any optically transmissive materials through which optical radiation from the LED device 102 can pass without being totally absorbed or reflected, e.g. glass, plastic, resin and silicone.

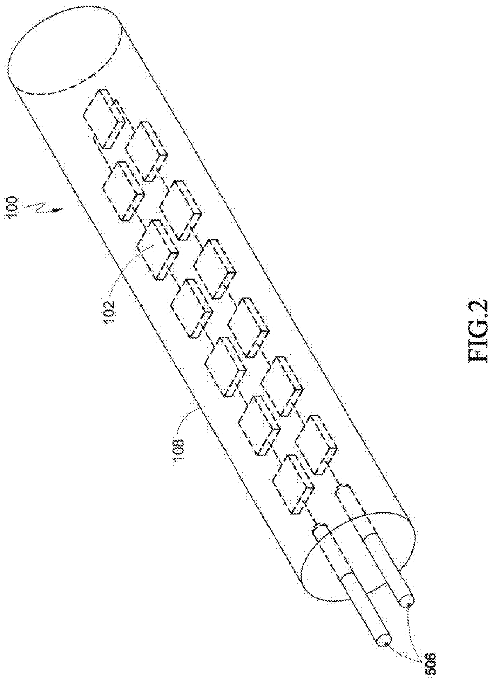

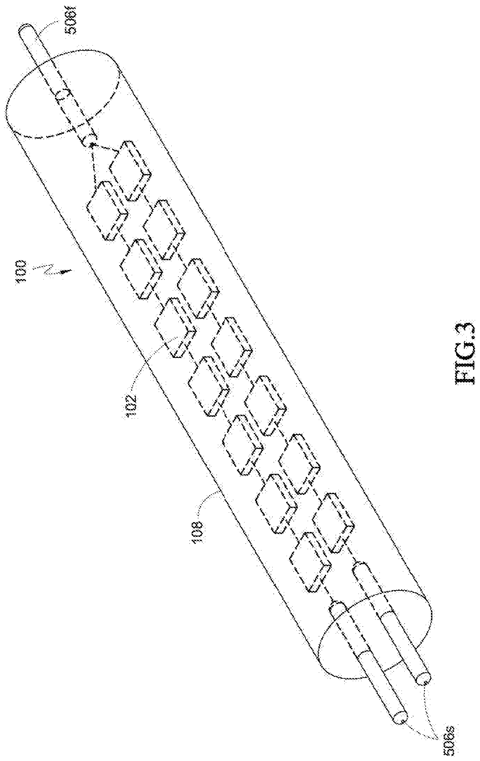

The linear array of LED devices 102 includes a plurality of LED devices 102 electrically coupled in parallel, in series or in a combination of both ways. In Figs. 1 and 2, the linear array of LED devices 102 is formed by serially coupling a plurality of LED devices 102. In Fig. 1, the linear array of LED devices 102 defines a straight line in the enclosure 108 along the longitudinal axis. In Fig. 2, the linear array of LED devices 102 defines a U-shaped curve extending axially in the enclosure 108. In Fig. 3, the linear array of LED devise 102 includes a first set of serially coupled LED devices 102 and a second set of serially coupled LED devices 102. The first set of LED devices 102 is in parallel connection with the second set of LED devices 102. The linear array of LED devices 102 defines a straight pair of parallel lines extending axially in the enclosure 108. Because there is only one path in which the current can flow in a series circuit, opening or breaking the circuit at any point causes the entire array of LED devices 102 to stop operating. By contrast, the same voltage is applicable to all circuit components connected in parallel. The total current is the sum of the currents through the individual components. Other things equal including luminary output, lower current in an individual LED device 102 results in better thermal performance.

The linear array of LED devices includes a liner array of single-die devices, multi-die devices or both to enable the LED filament 100 to glow across a broad field of angle. Going back to Fig. 1, in some embodiments, the linear array of LED devices 102 includes a plurality of individual LED dies connected by conductive glue, solder or welds. LED devices 102 having different colors can be mixed together to create white light. In other embodiments, the linear array of LED devices 102 includes a plurality of multi-die LED devices coupled together by a wire frame structure or in some other manner. The linear array of LED devices 102 emits light in a substantially omnidirectional or 360-degree pattern from the LED filament 100. Light is given off around the enclosure roughly perpendicular to the envelope of the enclosure in all directions. While the desired light intensity distribution may comprise any light intensity distribution, in one embodiment, the desired light intensity distribution conforms to the JEL801 standards or ENERGY STAR® Partnership Agreement Requirements for Luminous Intensity Distribution, each of which is incorporated herein by reference. Under ENERGY STAR® standards, an omnidirectional lamp is one configured to emit "an even distribution of luminous intensity (candelas) within the 0° to 135° zone (vertically axially symmetrical). Luminous intensity at any angle within this zone shall not differ from the mean luminous intensity for the entire 0° to 135° zone by more than 20%. At least 5% of total flux (lumens) must be emitted in the 135°-180° zone. Distribution shall be vertically symmetrical as measures in three vertical planes at 0°, 45°, and 90°." The Japanese standard JEL 801 stipulates that the luminary flux within 120 degrees from the beaming axis must be equal to or greater than 70% of the total flux of the light bulb.

Staying on Fig. 1, the linear array of LED devices 102 is made to be enclosed by the enclosure 108 in a variety of ways. In some embodiments, the enclosure 108 is formed directly on the linear array of LED devices 102 by dispensing a binder material such as liquid polymer coating containing various particles on the LED device 102. Simple as this may seem, the coating formed this way, could be unduly thick or undesirably nonuniform. In other embodiments, the enclosure 108 is fabricated and tested independently of the linear array of LED devices 102. Subsequently, the enclosure 108 is adhesively bonded to the linear array of LED devices 102. Bonding may be direct via a single adhesive layer or via one or more intermediate adhesive layers to form the LED filament 100 in a unitary structure comprising the linear array of LED devices 102 and the enclosure 108. In an embodiment, the enclosure 108 is combined with the LED device 102 at the wafer level. Alternatively, the enclosure 108 is mounted onto individual LED dice. The cost for making the LED filament 100 decreases when we form the enclosure 108 separately because defective enclosures 108 can be identified and discarded before packaging. Optionally, the enclosure 108 is sized to fit the lighting surface of the LED device 102.

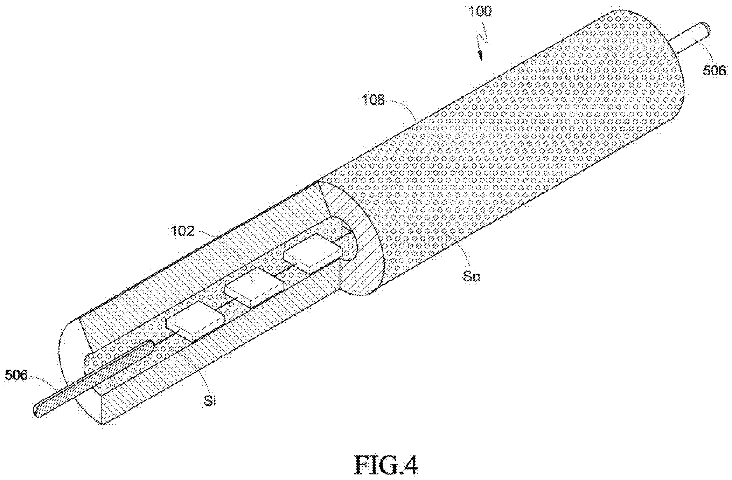

In Fig. 4, the LED filament 100 is radially severed into two sections. One of the sections is further axially sliced and disemboweled to show the inner surface Si of the enclosure 108. The outer surface So interfaces the air and the enclosure 108. When the linear array of LED devices 102 is conformally wrapped around by the enclosure 108, the inner surface Si interfaces the enclosure 108 and the LED device 102. When the linear array of LED devices 102 is spaced apart from the enclosure 108, the inner surface Si interfaces the enclosure 108 and the filler in the space such as the air. In an embodiment, the enclosure 108 includes a texturized or patterned surface So, Si for improving light extraction. In some embodiments, the enclosure 108 includes an outer surface So texturized to interface the air and the enclosure 108. In other embodiments, the enclosure 108 includes an inner surface Si texturized to interface the enclosure 108 and the adjacent media such as the LED device 102 or the air.

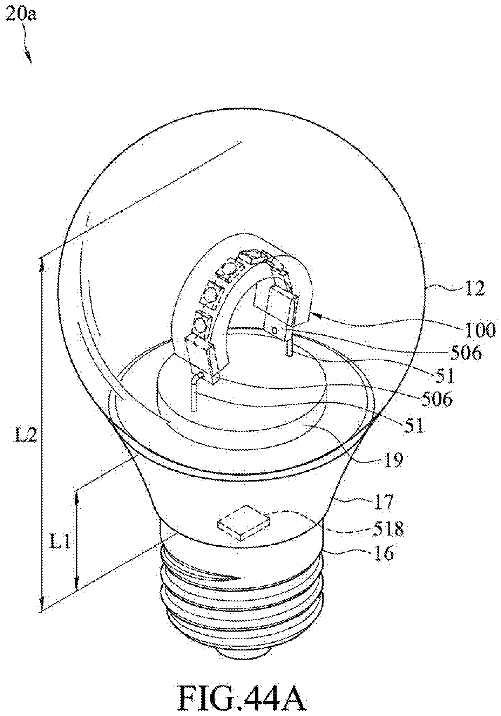

Going back to Fig. 1, the electrical connector 506, which is electrically connected to the linear array of LED devices 102, is configured to receive electrical power for energizing the linear array of LED devices 102. In Fig. 1, the LED filament 100 includes exactly two electrical connectors 506. A first electrical connector 506f, which is attached to a first end of the enclosure 108, is positive. A second electrical connector 506s, which is attached to a second end of the enclosure 108, is negative. In Fig. 2, the enclosure 108 includes exactly two electrical connectors 506. A first electrical connector 506f is positive and a second electrical connectors 506 is negative. However, both electrical connectors 506 are attached to a same end of the enclosure 108. In Fig. 3, the enclosure 108 includes exactly three electrical connectors 506. A first electrical connector 506f, which is attached to a first end of the enclosure 108, is the common ground. A second electrical connector 506s, which is attached to a second end of the enclosure 108, is positive. A third electrical connector 506s, which is also attached to the second end of the enclosure 108, is positive. In some embodiments, the LED filament 100 is configured to maintain the desired posture by and only by physically attaching the electrical conductors 506 of the LED filament 100 to the lead wire of the LED light bulb (e.g. FIG. 44A). The LED filament 100 is like an arch bridge and the lead wire abutment. The LED filament 100 maintains its posture in the LED light bulb by pressing its compression forces against the lead wire.

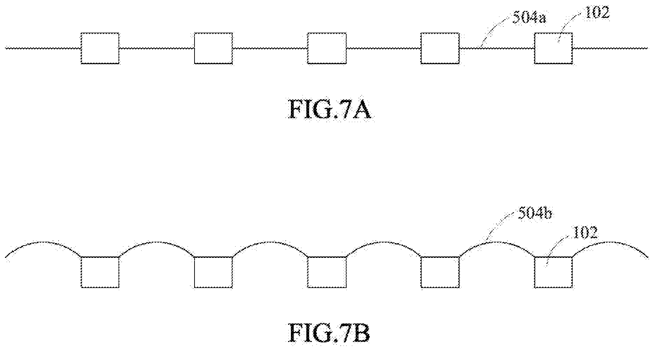

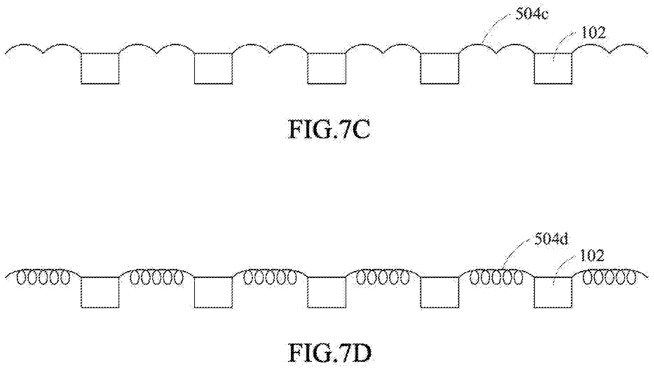

Going back to Fig. 1, the linear array of LED devices is electrically connected to emit light upon energization by applying a voltage through the electrical connectors 506. Electrical connections between the LED devices and the electrical connector can be made in a variety of ways depending on the advantages an LED filament is expected to pursue. Examples include wire bonding, conductive glue, flexible printed circuit (FPC) film and any combination of the above. In Fig. 7A, interconnections between the LED devices 102 are made by wire bonding. Wire bonding is a method known in the art for making interconnections between electronic components. The bonding wire 504a is made of copper, gold or any suitable alloy. In some embodiments, the bonding wire 504a includes a spring between the LED devices 102 it connects. When the linear array of LED devices 102 is stretched or compressed in the LED filament, the bonding wire 504a, when shaped like a spring, absorbs the mechanical energy that could otherwise open the circuit or damage the structure of the linear array of LED devices 102. Generally, the greater the sinuosity of the bond wire 504a, the more mechanical energy the bond wire 504a is capable of storing. The sinuosity is the ratio of the curvilinear length along the bond wire 504a and the Euclidean distance between the end points of the bond wire 504a. Preferably, the sinuosity is from 2 to 8. Most preferably, the sinuosity is from 3 to 6. In Figs. 7B and 7C, the bonding wire 504b/504c includes a bow-shaped spring between the LED devices 102 it connects. In Fig. 7D, the bonding wire 504d includes a helical spring between the LED devices 102 it connects.

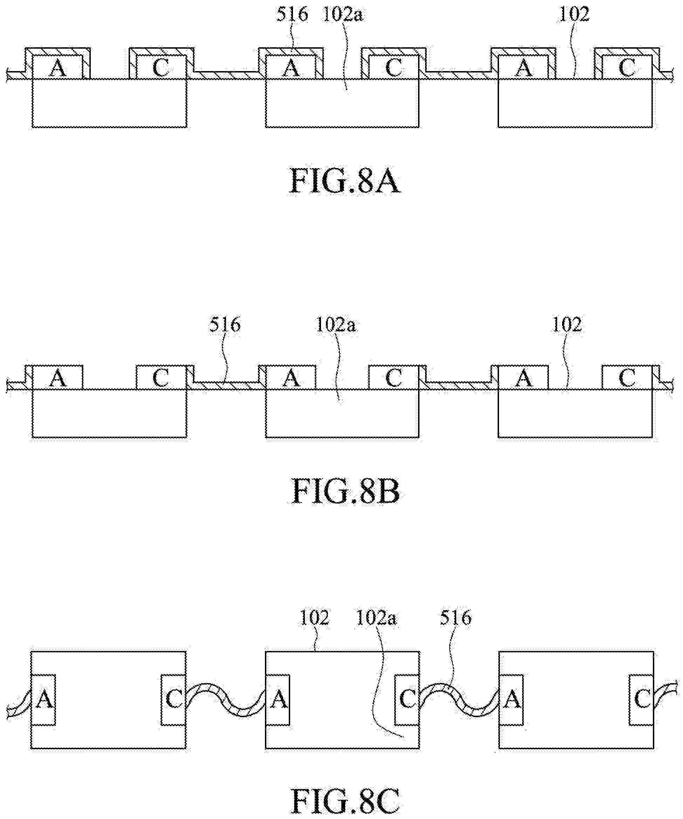

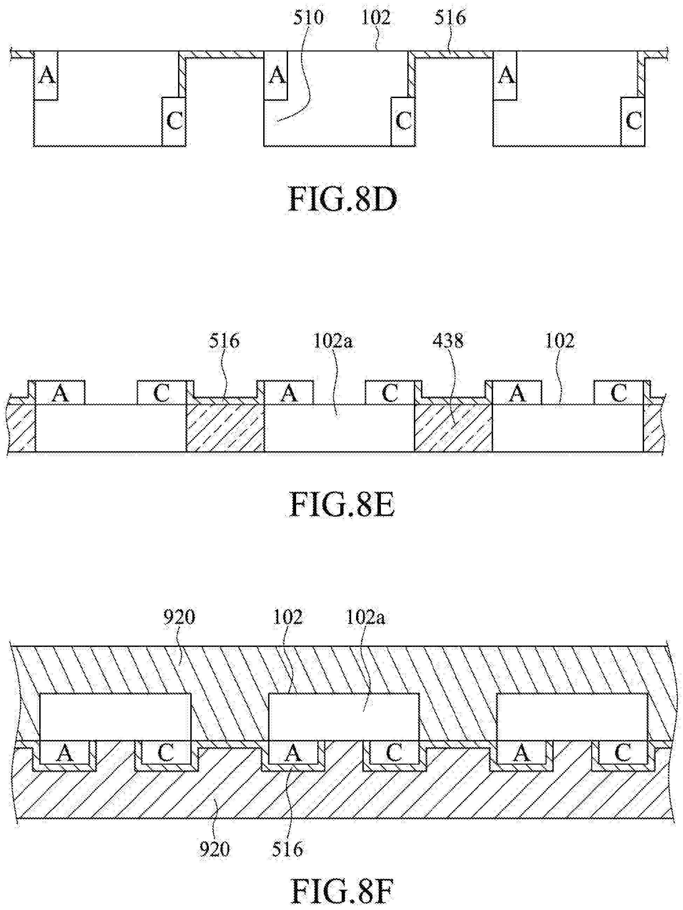

Staying on Figs. 7A-7D, when the enclosure is formed directly on the linear array of LED devices 102 by dispensing a liquid binder such as polymer coating on the LED device 102, a variety of incidents may negatively impact the quality of the LED filament produced through wire bonding. During wire bonding, the bonding wire is attached at both ends to the ohmic contacts of the LED device 102 using a combination of downward pressure, ultrasonic energy, and in some cases heat, to make a weld. The LED device 102 could be inadvertently shattered or burned during wire bonding. Moreover, ohmic contacts of the LED device 102, if having a tarnished or uneven surface, will comprise bond strength and subject the LED filament to potential failure. Furthermore, the bonding could be dislocated when the liquid polymer is being dispensed on the bonding wire attaching, otherwise properly or improperly, to the adjacent LED devices 102. To mitigate such problems, in some embodiments, interconnections between the LED devices 102 are made with glue wires made from electrically conductive glue continuously applied between the anode and cathode contacts of adjacent LED devices 102. Electrically conductive glue is formed by doping electrically conductive particles in an elastic binder. The electrically conductive particle can be gold or silver. Preferably, the electrically conductive particle is made from optically transmissive materials such as nano-silver, nano-carbon tubes and graphene. In some embodiments, wavelength conversion particles are blended in the electrically conductive glue for enhanced light conversion. The elastic binder can be silicone, epoxy or polyimide. Preferably, the elastic binder for the electrically conductive glue is the same material from which the enclosure is made. The glue wire is thus seamlessly integrated into the enclosure and is made capable of stretching or compressing in perfect sync with the enclosure. The glue wire can be fabricated with the aid of glue dispenser capable of 3-D maneuvers. Figs. 8A and 8B are side views of the linear array of the LED devices 102 where, for example, the anode A and cathode C contacts are provided on the same side of the LED die 102a. In Fig. 8A, the glue wire 516 connecting the adjacent LED devices 504 covers substantially the entire surface of the anode A and cathode C contacts. In Fig. 8B, the glue wire 516 connecting the adjacent LED devices 102 partially covers the anode A and cathode C contacts. Figs. 8C and 8D are top views of the linear array of LED devices 102 where the anode A and cathode C contacts are provided on the same side of the LED die 102a. In Figs. 8A and 8B, the glue wire 516 follows a straight line to connect the adjacent LED devices 504. In some embodiments, the glue wire 516 includes a curve of any kind depending for absorbing potentially destructive mechanical energy. Preferably, the sinuosity of the curve us from 3 to 8. Most preferably, the sinuosity of the curve is from 2 to 6. In Fig. 8C, the glue wire 516 is drawn to define an S-shaped curve between the LED devices 102 it connects in anticipation of deformation resulting from the LED filament being stretched or compressed. In Fig. 8D, when the anode A and cathode C contacts are not exactly aligned along the longitudinal axis of the linear array of the LED devices 102, the glue wire 516 makes a turn-for example-at the corner of the LED device 102 to complete the electrical connection for the adjacent LED devices 102. In Fig. 8E, the linear array of LED devices 504 includes a plurality of platforms 438 to fill the gap between the adjacent LED devices 102. Preferably, the platform 438 is made from the same material from which the enclosure is made. The upper surface of the platform 438 provides a continuous path for the glue wire 516 to run from the anode A contact of the LED devices 102 to the cathode C contact of the adjacent LED device 102. In Fig. 8F, alternatively, a mold 920 is made to follow the contour of the anode A and cathode C contacts of the linear array of LED devices 102. The mold 920, when properly deployed, defines a gap between the mold 920 and the linear array of LED devices 102. The glue wire 516 is formed by filling the gap with electrically conductive glue. In some embodiments, the anode A and cathode C contacts-potentially blocking light where they are disposed over the diode region-are eliminated from the LED die 102a. The glue wire 516 is thus configured to connect the p-junction of an LED device 102 and the n-junction of an adjacent LED device 102.

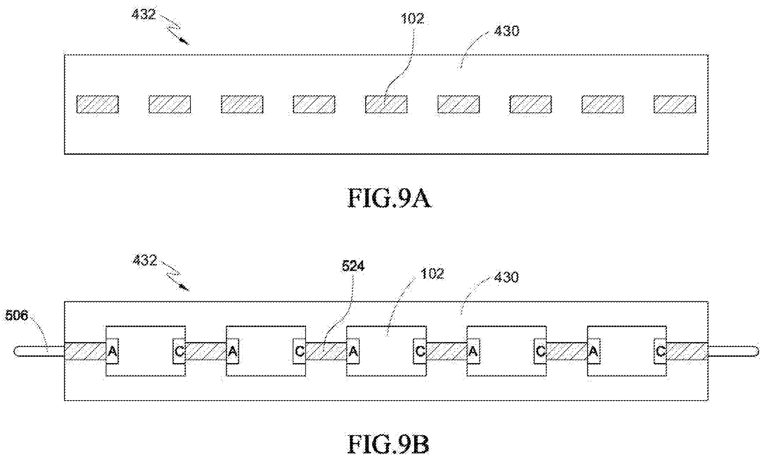

In yet another embodiment, interconnections between the LED devices is made with a strip of flexible printed circuit (FPC) film 432. Fig. 9A is a top view of the FPC film 432 prior to connecting with the linear array of LED devices and the electrical connector. Fig. 9B is a top view of the FPC film 432 after connecting with the linear array of LED devices 504 and the electrical connectors 506. The strip of FPC film 432 includes a plurality of conductive tracks 524 laminated onto a strip of thin and nonconductive substrate 430. The strip of FPC film 432 mechanically supports the linear array of LED devices 504 with the strip of nonconductive substrate 430. The conductive track 524 electrically connects the linear array of LED devices 504 by connecting the anode A contact of the LED device 102 to the cathode contact C of the adjacent LED device 102. The non-conductive substrate 430 is an optically transmissive film, preferably having transmittance of 92% or more. For example, the nonconductive substrate 430 is a thin film made from Polyimide. The conductive track 524 can be made from electrical conductors such as indium tin oxide (ITO), silver nanoparticles or carbon nanotubes (CNTs). In an embodiment, the conductive track 524 is made from silver nanoparticles doped with gold for reliable connection with the ohmic contact of the LED device 504. The conductive track 524 can come in many patterns. For example, in Fig. 9A the conductive track 524 defines a set of slanted parallel lines. In Fig. 9B, the conductive track 524 defines a slanted grid. Preferably, the conductive track 524 has a thickness of from 1 nm to 1 mm. Preferably, the line in the set of the parallel lines and the grid has a width of from 1 $\mu$m to 1 cm. Some light is blocked by the conductive track 524 even when the conductive track 524 is made from transparent materials such as ITO. In some embodiments, the plurality of conductive tracks 524 cover less than 100% of the nonconductive substrate 430 to maximize the light traveling both ways through the nonconductive substrate 430. Preferably, the ratio of the total area covered by the plurality of conductive tracks 524 to the area of the FPC film 432 is from 0.1% to 20%. The strip of FPC film 432 is suitable for the LED filament designed to be bendable. When the conductive track 524 is properly patterned, e.g. a set of slanted parallel lines, a reliable electrical connection for the linear array of LED devices 102 is assured because a broken line would not break the connection.

According to an embodiment of the present invention, the method of making the LED filament includes the following steps:

S20: Arrange a linear array of LED devices 102 spaced apart from one another and an electrical connector 506 on a mount surface;

S22: Electrically and physically connect the linear array of LED devices 102 and the electrical connector 506; and

S24: Dispose the linear array of LED devices 102 in an enclosure.

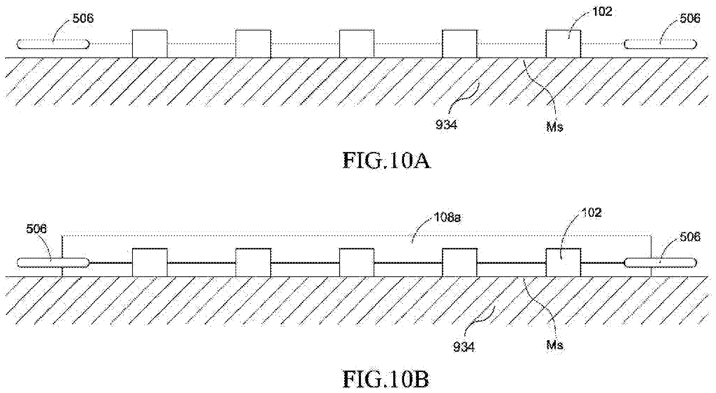

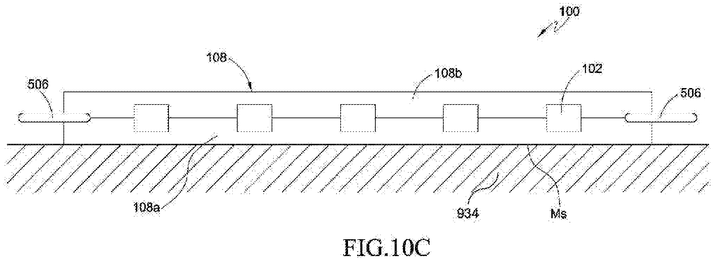

S20 and S22 have been performed in Fig. 10A. S24 is being performed in Fig. 10B. In Fig. 10C, S20, S22 and S24 have all been performed. The mount surface Ms is any surface capable of supporting the linear array of LED devices 102 and the electrical connectors 506 throughout the steps of the method. Usually, the mount surface Ms is a substantially planar surface. In some embodiments, the mount surface Ms is a three dimensional surface whose shape depends on a desired totality of considerations such as: the posture the LED filament is expected to maintain in the LED light bulb; the posture each individual LED device 102 is expected to maintain in relation to the rest of the linear array of LED devices 102; the shape of the enclosure 108; the texture of the outer surface of the enclosure 108; and the position of the linear array of LED devices 504 in the enclosure 108. Each one of the linear array of LED devices 102 is properly aligned with the adjacent LED device 102 on the mount surface Ms depending on the location of the anode and cathode contacts on the LED device 504 and depending on the type of electrical connection to be made for the linear array of LED devices 102 in S22. In S22, the electrical connection is made with bond wire, conductive glue, FPC film or a combination of the above. The linear array of LED devices 102 is electrically connected in parallel, in series or in a combination of both ways.

In some embodiments where a cluster of LED filaments is assembled on a large mount surface, the method of making an LED filament further includes the following step:

S26: Depanel the cluster of LED filaments.

In S26, an LED filament depaneled from the cluster may include a linear array of LED devices or a plurality of linear arrays of LED devices depending on the application.

Staying on Figs. 10A, 10B and 10C, in an embodiment, the enclosure 108 is made from a cured transparent binder such as a cured transparent polymer. The enclosure 108 includes a first portion 108a, which is made first; and a second portion 108b, which is made later. The first portion 108a of the enclosure 108 is or is not structurally or otherwise distinguishable from the second portion 108b of enclosure 108. The mount surface Ms in S20 is provided by a panel 934 separable from the linear array of LED devices 102. The panel is made of suitable solid materials such as glass or metal. In some embodiments, the panel further includes a side wall for containing and sometimes shaping the enclosure 108 on the panel especially when, for example, a pre-curing liquid polymer is involved during manufacturing. In an embodiment, S24 includes the following steps:

S240: Dispense a fist strip of transparent polymer over the linear array of LED devices;
S242: Reverse the linear array of LED devices on the panel; and
S244: Dispense a second strip of transparent polymer over the linear array of LED devices.

Staying on Figs 10A, 10B and 10C, in S240, the first strip of liquid polymer is dispensed over the linear array of LED devices 102 to form the first portion 108a of the enclosure 108. Surface tension, which at the size of an LED device 102 is large in relation to gravitational forces, in combination with viscosity allows the strip of liquid polymer to conformally cover all corners of the linear array of LED devices 102, including the gaps between the LED devices 102. It is desirable to do a fast cure, such as a UV cure, because the normal drop in viscosity during a thermal cure would cause most liquid polymers to flow away from the linear array of LED devices 102. In S242, the linear array of LED devices 102, which is now at least partially enclosed by the first portion 108a of the enclosure, is flipped over on the panel and remains unharmed without additional care when the linear array of LED devices 102 was not adhesively attached to the panel 934 in S20. In some embodiments, the linear array of LED devices 102 was adhesively attached on the mount surface Ms of the panel 934 with adhesive materials such as photoresist for semiconductor fabrication and die bond glue. The linear array of LED devices 102 can be separated from the panel 934 after dissolving the adhesive material with proper solvents such as acetone. Residuals of adhesive material remaining on the linear array of LED devices 102 are flushed away before moving to S244. In S244, like in S240, the second strip of liquid polymer is dispensed over the linear array of LED devices 102, which has been enclosed, at least partially, by the first portion 108a of the enclosure 108. The second strip of liquid polymer is then cured and forms the second portion 108b of enclosure 108. We now have an LED filament 100 comprising the linear array of LED devices 102 disposed in the enclosure 108 operable to emit light when energized through the electrical connector 506.

In another embodiment, the enclosure is made from, for example, cured transparent polymer. However, the mount surface in S20 for the linear array of LED device and the electrical connector is provided by a strip of cured transparent polymer that will form the first portion of the enclosure. S20 includes the following steps:

S200: Dispense a first strip of transparent polymer on a panel; and
S202: Arrange a linear array of LED devices spaced apart from one another and an electrical connector on the first strip of transparent polymer.

In the embodiment, S24 includes the following step:
S244: Dispense a second strip of transparent polymer over the linear array of LED devices.

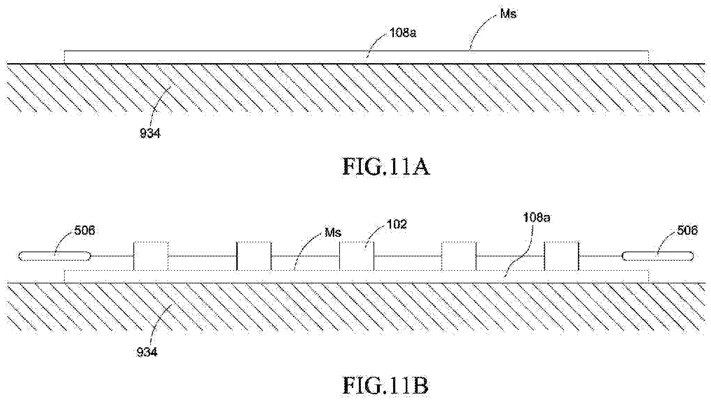

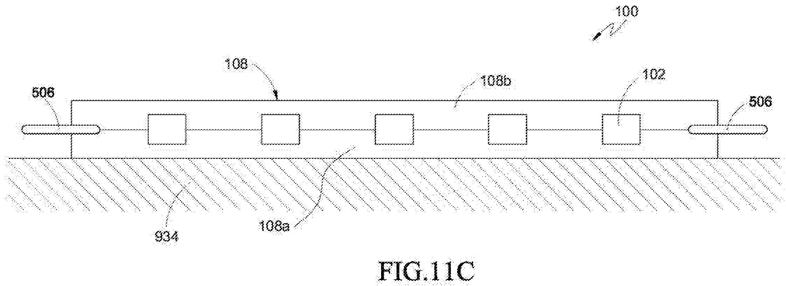

S200 has been performed in Fig. 11A. S202 has been performed in Fig. 11B. S244 has been performed in Fig. 11C. In S200, the first strip of liquid polymer is dispensed on a panel 934. The first strip of liquid polymer is then cured on the panel to form the first portion 108a of the enclosure 108. The mount surface Ms in S20 is provided by the first strip 108a of cured polymer separable from the panel 934. The first portion 108a of the enclosure 108 provides a surface capable of supporting the linear array of LED devices 102 and the electrical connectors 506 throughout the steps of the method. The first strip of liquid polymer is then cured on the panel to form the first portion 108a of the enclosure 108. The mount surface Ms in S20 is provided by the first strip of cured polymer separable from the panel 934. The panel 934 is made of suitable solid materials such as glass or metal. In other embodiments, the panel 934 further includes a side wall for containing and sometimes shaping the enclosure 108 on the panel 934 especially when, for example, pre-curing liquid polymer is involved during manufacturing. In S202, to strengthen the combination when the linear array of LED devices 102 and the electrical connector 506 are disposed on the first portion 108a of the enclosure 108, optionally, an upper surface of the first portion 108a of the enclosure 108 is melted. The linear array of LED devices 102 and the electrical connector 506 are then at least partially immersed into the first portion 108a of the enclosure 108 before the upper surface cools down. In S244, like in S200, the second strip of liquid polymer is dispensed over the linear array of LED devices 102, which has been disposed on or at least partially enclosed by the first portion 108a of the enclosure 108. The second strip of liquid polymer is then cured and forms the second portion 108b of enclosure 108. The linear array of LED devices 504, which is now enclosed by the unitary structure of the first portion 108a of the enclosure 108 and the second portion 108b of the enclosure 108, can be taken away from the panel 934 and remains unharmed without additional care when the first portion 108a of the enclosure 108 was not adhesively attached to the panel 934. In some embodiments, the first portion 108a of enclosure 108 was adhesively attached to the panel 934 with adhesive materials such as photoresist for semiconductor fabrication and die bond glue. The first portion 108a of enclosure 108 can be separated from the panel 934 after dissolving the adhesive material with proper solvents such as acetone. Residuals of adhesive material remaining on first portion 108a of the enclosure 108 are flushed away. We now have an LED filament 100 comprising the linear array of LED devices 504 disposed in the enclosure 108 operable to emit light when energized through the electrical connector 506.

In some embodiments, the first portion of the tubular in S200 is configured to be capable of withstanding potential destructions resulting from manufacturing procedures such as wire bonding. In some embodiments, the first portion of the tubular includes a hardener. For example, the hardener includes a pre-determined concentration of particles harder than the liquid polymer in which the particles are embedded. Light conversion particles such as phosphor participles are harder than the binder materials such as silicone and resin. Thus, the first portion of the tubular can be made harder by increasing the concentration of the light conversion particles in the transparent binder. In an embodiment, the first portion of enclosure is configured to have a Shore hardness of from D20 to D70 when the ratio of the volume of the light conversion particles in the first portion of the enclosure to the volume of the transparent binder in the first portion of the enclosure is from 20% to 80%. Alternatively, the ratio of the weight of the light conversion particles in the first portion of the enclosure to the weight of the transparent binder in the first portion of the enclosure is from 20:80 to 99:1. In other embodiments, the first portion of the enclosure is thickened such that the thickness enables the first portion of the enclosure to withstand potential destructions resulting from manufacturing procedures such as wire bonding. Preferably, the thickness of the first portion of the enclosure is from 0.01 to 2 mm. Most preferably, the thickness of the first portion of the enclosure is from 0.1 to 0.5 mm.

In yet another embodiment, the enclosure is made from, for example, cured transparent polymer. However, the mount surface in S20 for the linear array of LED device and the electrical connector is provided by a strip of cured transparent polymer that will form a first portion of the enclosure. S20 includes the following steps:

S210: Dispense a first strip of transparent polymer on a panel;

S212: Dispose a strip of FPC film on the first strip of transparent polymer; and

S214: Arrange a linear array of LED devices spaced apart from one another and an electrical connector on the strip of FPC film.

In the embodiment, S24 includes the following step:

S244: Dispense a second strip of transparent polymer over the linear array of LED devices.

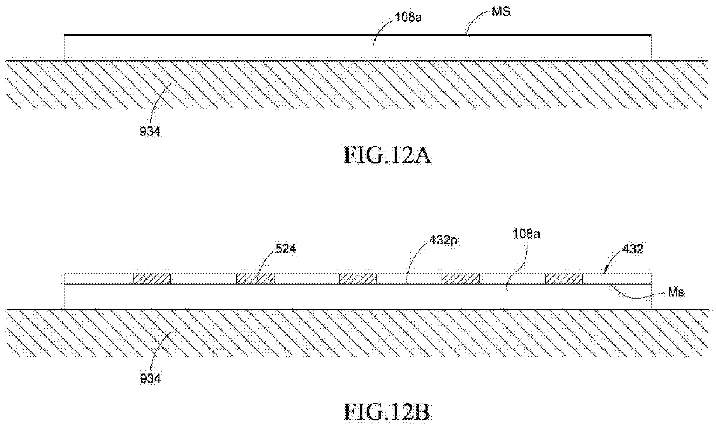

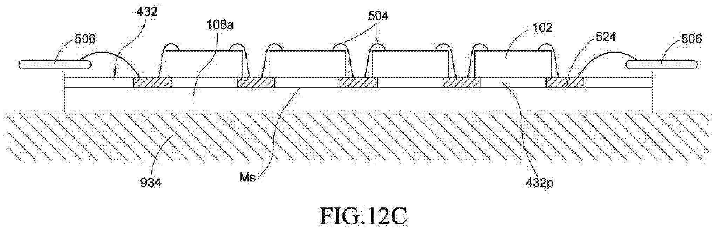

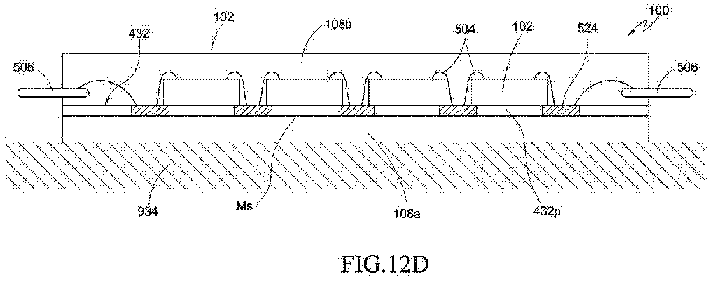

S210 has been performed in Fig. 12A. S212 has been performed in Fig. 12B. S214 has been performed in Fig. 12C. S244 has been performed in Fig. 12D. In S210, the first strip of liquid polymer is dispensed on a panel 934. The panel 934 is made of suitable solid materials such as glass or metal. In other embodiments, the panel 934 further includes a side wall for containing and sometimes shaping the enclosure 108 on the panel 934 especially when, for example, pre-curing liquid polymer is involved during manufacturing. The first strip of liquid polymer is then cured on the panel 934 to form the first portion 108a of the enclosure 108. The mount surface Ms in S20 is provided by the first strip of cured polymer separable from the panel 934. The first portion 108a of the enclosure provides a surface capable of supporting the linear array of LED devices 504 and the electrical connector 506 throughout the steps of the method. In S212, to strengthen the combination when the strip of FPC film 432 is disposed on the first portion 108a of the enclosure 108, optionally, an upper surface of the first portion 108a of the enclosure is melted. The strip of FPC film 432 is then at least partially immersed into the first portion 108a of the enclosure 108 before the upper surface cools down. In some embodiments, the strip of PFC film 432 includes a linear array of apertures 432p punched by, for example, a stamping press. Optionally, the aperture 432p is dimensionally smaller than the LED device 504. In these embodiments, each of the linear array of LED devices 102 straddles exactly one of the linear array of the apertures 432p. Thus, light coming from the linear array of LED devices 102 will not be blocked by the strip of FPC film 432. In S22, a combination of wire bonding and FPC film 432 is employed to electrically and connect the linear array of LED devices 102. The bonding wire 514 is attached to a conductive track 524 of the strip of FPC film 432 on a first end and attached to an ohmic contact of the LED device 504 on a second end. In S244, like in S210, the second strip of liquid polymer is dispensed over the linear array of LED devices 102, which has been disposed on or at least partially enclosed by the first portion 108a of the enclosure 108. The second strip of liquid polymer is then cured and forms the second portion 108b of enclosure 108. The linear array of LED devices 102, which is now enclosed by the unitary structure of the first portion 108a of the enclosure 108 and the second portion 108b of the enclosure 108, can be taken away from the panel 934 and remains unharmed without additional care when the first portion 108a of the enclosure 108 was not adhesively attached to the panel 934. In some embodiments, the first portion 108a of enclosure 108 is adhesively attached to the panel 934 with adhesive materials such as photoresist for semiconductor fabrication and die bond glue. The first portion 108a of enclosure 108 can be separated from the panel after dissolving the adhesive material with proper solvents such as acetone. Residuals of adhesive material remaining on first portion 108a of the enclosure 108 are flushed away. We now have an LED filament 500 comprising the linear array of LED devices 102 disposed in the enclosure 108 operable to emit light when energized through the electrical connector 506.

In an embodiment, the enclosure is a monolithic structure. In some embodiments, the monolithic structure shares a uniform set of chemical and physical properties throughout the entire structure. Being structurally indivisible, the monolithic structure need not be a uniform structure. In other embodiments, the monolithic structure includes a first portion and a second portion having a different property from the first portion. In another embodiment, the enclosure includes a set of otherwise divisible layers or modules interconnected to form a unitary structure of the enclosure. In Figs. 14 to 19, the enclosure includes a set of interconnected layers configured to form a unitary structure of the enclosure. In Figs. 20 to 23C, the enclosure includes a set of interconnected modules configured to form a unitary structure of enclosure.

In an embodiment, the enclosure includes a wavelength conversion layer, such as a phosphor film layer or a phosphor glue layer. The wavelength conversion layer includes a transparent binder 422 in which a plurality of light conversion particles 424, such as phosphor particles, are embedded. The phosphor particles may be formed from any suitable phosphor capable of converting light of one wavelength into another wavelength. Cerium(III)-doped YAG is often used for absorbing the light from the blue LED device 106 and emits in a broad range from greenish to reddish, with most of output in yellow. This yellow emission combined with the remaining blue emission gives the white light, which can be adjusted to color temperature as warm (yellowish) or cold (blueish) white. The pale yellow emission of the Ce3+:YAG can be tuned by substituting the cerium with other rare earth elements such as terbium and gadolinium and can even be further adjusted by substituting some or all of the aluminium in the YAG with gallium. Alternatively, some rare-earth doped Sialons are photoluminescent and can serve as phosphors. Europium(II)-doped β-SiAlON absorbs in ultraviolet and visible light spectrum and emits intense broadband visible emission. Its luminance and color does not change significantly with temperature, due to the temperature-stable crystal structure. Thus, it is suitable for using as green down-conversion phosphor for white-light LED filaments; a yellow variant is also available. To generate white light, a blue LED device is used with a yellow phosphor, or with a green and yellow SiAlON phosphor and a red CaAlSiN3-based (CASN) phosphor. In an embodiment, the wavelength conversion layer is configured to convert light emitting from the LED device into light having a color temperature from 2400 to 2600 K by, for example, embedding in the transparent binder an appropriate combination of yellow-and-green phosphor and red phosphor.

The amount of light absorbed and re-emitted by the light conversion particles is generally proportional to the amount of light conversion particles that the light passes through before egressing the LED filament. However, if the light passes through too much light conversion particles, part of the re-emitted light can be blocked from emitting from the LED filament, by the excess light conversion particles. This reduces the overall light emitting efficiency of the LED filament. The amount of light conversion particles that the LED light passes through can be varied by varying the concentration of light conversion particles, the thickness of the wavelength conversion layer, or both. In an embodiment, light from the linear array of LED devices passes through a sufficient amount of light conversion particles so that substantially all of the light is absorbed and re-emitted at a different wavelength of light. At the same time, the re-emitted light does not pass through an excess light conversion material so that the re-emitted light is not blocked from emitting from LED filament. By providing a sufficient amount of light conversion particles to provide full conversion without blocking, the light conversion particles are in state of optimal conversion. The amount of light conversion particles for optimal conversion depends on the size and luminous flux of the LED filament. The greater the size and luminous flux, the greater the amount of light conversion particles needed. Under optimal conversion, the light emitted from the LED filament is composed primarily of photons produced by the light conversion particles. Preferably, the ratio of the volume of the light conversion particles in the wavelength conversion layer to the volume of the transparent binder in the wavelength conversion layer is from 20:80 to 99:1. Preferably, the ratio of the weight of the light conversion particles in the wavelength conversion layer to the weight of the transparent binder in the wavelength conversion layer is from 20% to 50%. In some embodiments, however, it may be desirable to allow a small portion of the light to be transmitted through the light conversion particles without absorption for purposes of modifying the chromaticity of the resulting radiation of the LED filament. For example, the LED filament emits less than 10% of the emission power of primary radiation in the absence of the light conversion material particles. In other words, the conversion particles absorb 90% or more of the light from the linear array of LED devices.

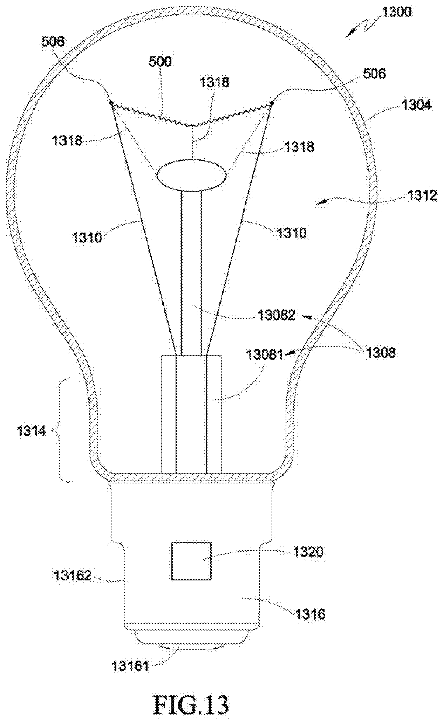

Fig. 13 shows an LED light bulb 1300 having an LED filament 1302 of the present invention as the light source. In an embodiment, the LED light bulb 1300 comprises a light transmissive envelope 1304, a base 1306, a stem press 1308, an LED filament 1302 and a plurality of lead wires 1310. The light transmissive envelope 1304 is a bulbous shell made from light transmissive materials such as glass and plastic. The light transmissive envelope 1304 includes a bulbous main chamber 1312 for housing the LED filament 1302 and sometimes a neck 1314 dimensionally adapted for attaching to the base 1306. At least part of the 1306 base is metal and includes a plurality of electrical contacts 1316 for receiving electrical power from a lampholder. The light transmissive envelope 1304 is mounted with its neck 1314 on the base 1306. The stem press 1308 is mounted on the base 1306 within the light transmissive envelope 1304 for holding the lead wire 1310 and the LED filament 1302 in position while keeping the positive and negative currents insulated from each other. The lead wire 1310 extends in a substantially axial direction from the base 1306 through the neck 1314 all the way into the main chamber 1312. The lead wire 1310 physically and electrically connects the electrical contact 1316 of the base 1306 and an electrical connector 506 of the LED filament. Electrical power is communicated from the lampholder to the base 1306 and all the way to the LED filament 1302 through the lead wire 1310 when the base 1306 and the lampholder are properly connected. The LED light bulb 1300 is thus configured to emit light omnidirectionally. In some embodiments, the LED light bulb 1300, including exactly one LED filament 1302, is configured to emit light omnidirectionally. In other embodiments, the LED light bulb 1300, including a plurality of LED filaments 1302, is configured to emit light omnidirectionally. In addition to brining electrical power for the LED filament 1302, the lead wire 1310 also supports the LED filament 1302 to main a desired posture in the main chamber 1312.

In some embodiment where the lead wire 1310 alone do not provide sufficient support, the LED light bulb 1300 further includes a plurality of support wires 1318 to help the LED filament 1302 maintain a desired posture in the main chamber 1312. In some embodiments, the support wire 1318 is made of carbon spring steel for additional damping protection. Preferably, the support wire 1318 is not in electrical communication with any part of the LED light bulb 1300. Thus, negative impact resulting from thermal expansion or heat is mitigated. When the LED filament 1302 defines a sinuous curve in the main chamber 1312, the lead wire 1310 supports the LED filament 1302 either at the crest of the curve, the trough of the curve or anywhere between the crest and the trough. The support wire 1318 attaches to the LED filament 1302 in a variety of ways. For example, the lead wire 1310 includes a hook or claw at a tip. The throat of the hook is snugly closed around the LED filament. Alternatively, the claw is snugly closed around the LED filament.

In an embodiment, the LED light bulb include exactly two lead wires 1310. The base includes a top end, a bottom end and a side surface. The light transmissive envelope 1304 is mounted with its neck 1314 on the top end of the base 1306. The base 1306 includes a foot electrical contract 1316 at the bottom end and a base electrical contact 1316 on the side surface. A first lead wire 1310 physically and electrically connects the foot electrical contact 1316 and a first electrical connector 506f of the LED filament 1302. A second lead wire 1310 physically and electrically connects the base electrical contact 1316 and a second electrical connector 506s of the LED filament 1302. For example, the lead wire 1310 and the electrical contact 506 is fastened together by soldering. The filler metal includes gold, silver, silver-based alloy or tin. Alternatively, when the electrical connector 506 includes an aperture and the lead wire 1310 includes a hook structure at a tip, the lead wire 1310 and the electrical connector 506 is fastened by closing the throat of the hook against the aperture. In some embodiments, the LED light bulb 1300 further includes a rectifier 1320, which is in electrical connection with the electrical contact 1316 of the base 1306 and the lead wire 1310, for converting AC electricity from the lampholder into DC electricity to drive the LED filament 1302.

Preferably, the base 1306 has a form factor compatible with industry standard light bulb lampholder. Specifications for light bulb bases and sockets largely overseen by two organizations. The American National Standards Institute (ANSI) is an organization that publishes C81.61 and C81.62, while International Electrotechnical Commission (IEC) publishes 60061-1 and 60061-2. Edison screw lamp base and lampholder examples include but are not limited to the E-series described in ANSI C81.61 and C81.62: E5 midget, E10 miniature, E11 mini-candelabra, E12 candelabra, E17 intermediate, E26/24 single-contact medium, E26d double-contact medium, E26/50x39 skirted medium, E26/53x39 extended skirted medium, E29/53x39 extended skirted admedium, E39 single-contact mogul, E39d double-contact mogul, EP39 position-oriented mogul, and EX39 exclusionary mogul. Multiple-pin lamp base and lampholder examples include but are not limited to the G-series described in ANSI C81.61 and C81.62: GY two-pin for T, G4 two-pin for single-ended TH, GU4 two-pin for MR11 GLS lamps, GZ4 two-pin for projection lamps, G5 fluorescent miniature two-pin, 2G7 four-pin compact fluorescent, GZ10 bipin, G16t three-contact lug for PAR lamps, G17t three-pin prefocus for incandescent projection lamps. Bayonet lamp base and lampholder examples include but are not limited to the B-series described in ANSI C81.61 and C81.62: B/BX8.4d small instrument panel, BA9/12.5 miniature, BAW9s for HY21W, BA15s candelabra single contact, BAZ15d double contact with offset, and BY22d multipurpose sleeved double contact.

In an embodiment, the light transmissive envelope 1304 is made from a light transmissive material with good thermal conductively, e.g. glass, plastic. In another embodiment, the light transmissive envelope 1304 is configured to absorb a portion of the blue light emitted by the LED filament to obtain a warmer color temperature. To make the light warmer, for example, the light transmissive envelope 1304 is made from a material doped with yellow particles. Alternatively, the light transmissive envelope is coated with a yellow film. In yet another embodiment, the light transmissive envelope 1304, which is hermetically connected to the base 1306, is charged with a gas having greater thermal conductivity than the air such as hydrogen, nitrogen and a mixture of both. In additional to greater heat dissipation, humidity, potentially undermining the electronics of the LED light bulb 1300, is thus removed from the light transmissive envelope 1304. In an embodiment, hydrogen accounts for from 5% to 50% of the volume of the light transmissive envelope 1304. In still another embodiment, the light transmissive envelope 1304 is sealed at an internal pressure of from 0.4 to 1.0 ATM.

The stem press 1308 is made from an electrically insulative material such as glass or plastic. The shape and dimension of the stem press 1308 depends a totality of considerations such as the number of LED filaments 1302 the LED light bulb 1300 has, the posture the LED filament 1302 is expected to maintain in the main chamber 1312; the manner the lead wire 1310 supports the LED filament 1302; the number of lead wires 1310 the LED light bulb 1300 has; whether the LED light bulb 1300 further includes support wires 1318; and whether or how a heatsink finds itself in the LED light bulb. In an embodiment, the stem press 1308 extends barely above the base. In another embodiment, the stem press extends above the base 1306 and into the neck 1314. In yet another embodiment, the stem press 1308 extends above the base 1306, through the neck 1314 and into the main chamber 1312. In some embodiments, the stem press 1308 is made from an electrically insulative material have good thermal conductivity such as aluminium oxide and aluminium nitride. In other embodiments, the stem press 1308 includes an opening for evacuating the air from the light transmissive envelope 1304 and for charging the light transmissive envelope 1304 with the desired amount of gas.

In some embodiments, the LED light bulb further includes a heatsink. The heatsink is made from materials have good thermal conductivity such as metal, thermal ceramics and thermal plastic. In some embodiments, the stem press, the base or both is made from a same material from which the heatsink is made. In other embodiments, an integral piece including a combination of at least two of the stem press, the base and the heat sink is formed with a same material to reduce the thermal resistance of the LED light bulb. The heatsink is in thermal communication with the LED filament and ambient air for transferring heat coming from the LED device to the ambient air. Preferably, the heatsink is in thermal communication with, in addition to the LED filament and ambient air, the stem press, the lead wire, the support wire, the base or any combination of the above.

The LED filament is designed to maintain a posture within the chamber to obtain an omnidirectional light emission. In Fig. 44A, the LED light bulb comprises a light transmissive envelope, a base, a stem press, exactly one LED filament, exactly a pair of lead wires, a heatsink and a rectifier. The heatsink is disposed between the light transmissive envelope and the base. The rectifier is disposed within the heatsink. The stem press includes a stump-like structure projecting from the base. The LED filament defines an arc extending substantially vertically in the light transmissive envelope. For easy reference, a Cartesian coordinate system is oriented for the LED light bulb where: (1) the interface connecting the light transmissive envelope and heatsink falls on the x-y plane; and (2) the z-axis, also the central axis of the LED light bulb, intersects the interface at point O. In the embodiment, the end point of the arc reaches as high as point H1 on the y-axis. The distance between the end points of the LED filament on the x-y plane is D. The length of LED filament on the y-axis is A. The posture of the LED filament in the LED light bulb is defined by all points in the set (0, y, z+H1), where z goes up from 0 to A and then from A back to 0 as y goes from -D/2 to 0 and then from 0 to D/2. The length of the heatsink along the z-axis is L1. The length of the combination of the light transmissive envelope and the heatsink along the z-axis is L2. The greater the ratio L1/L2 is, the LED light bulb is configured to have a better heat dissipation but potentially compromised filed of angle when the LED filament is elevated to a higher position within the light transmissive envelope. Preferably, the ratio L1/L2 is from 1/30 to 1/3.

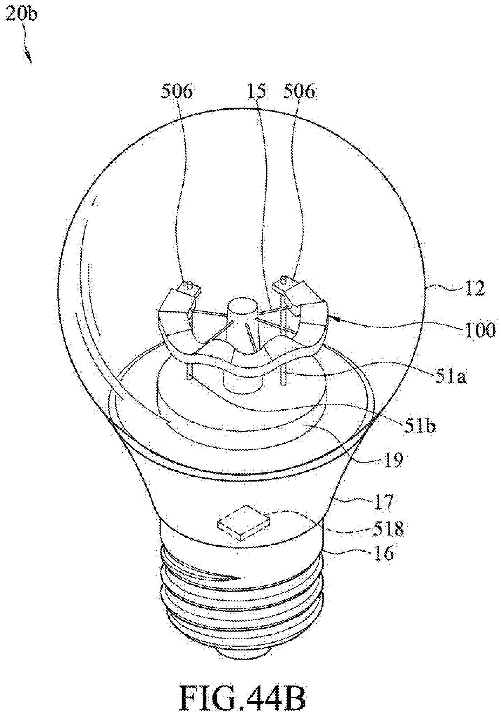

In Fig. 44B, the LED light bulb comprises a light transmissive envelope, a base, a stem press, exactly one LED filament, exactly a pair of lead wires, a heatsink, a rectifier and a plurality of support wires. The heatsink is disposed between the light transmissive envelope and the base. The rectifier is disposed within the heatsink. The stem press, unlike the one in Fig. 12A, further includes a post portion for elevating the LED filament to a desired position in the light transmissive envelope. The plurality of support wires radiate (horizontally, for example) from the post portion to form a spoke-and-hub structure in the light transmissive envelope. The support wire is attached to the post portion at a first end and to the LED filament at a second end. In the embodiment, the LED filament defines a sinuous curve along an arc meandering substantially horizontally in the light transmissive envelope. The sinuous curve oscillates in the range from $H1+A1$ to $H1-A1$ on the y-axis, where $H1$ represents the average height of the LED filament in the LED light bulb and $A1$ the amplitude of the sinuous curve the LED filament defines. The plurality of support wires have a same length $R$. The posture of the LED filament in the LED light bulb is defined by all points in the set $(x, y, z + H1)$, where $-R =< x =< R$; $-R =< y =< R$; and $-A1 =< z =< A1$. The LED filament, seen through the light transmissive envelope, is aesthetically pleasing when it is glowing or not. Moreover, omnidirectional light emission is made possible with only one LED filament having a posture like this. The quality as well the cost for producing omnidirectional LED light bulbs is thus improved because fewer interconnections of parts are needed when only one LED filament is involved.

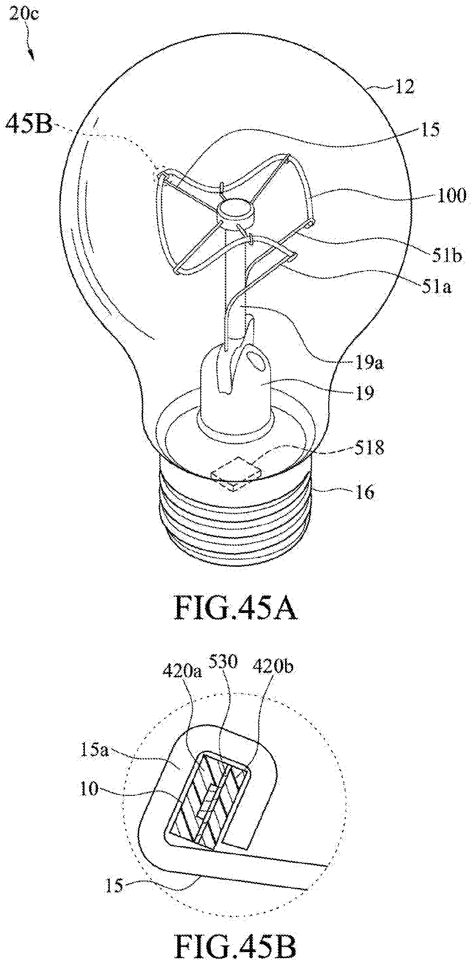

In Fig. 45A, the LED light bulb comprises a light transmissive envelope, a base, a stem press, exactly one LED filament, exactly a pair of lead wires, a rectifier and a plurality of support wires. The light transmissive envelope has a bulbous main chamber for housing the LED filament and a neck for connecting the light transmissive envelope to the base. The rectifier is disposed within the base. The plurality of support wires radiate (slightly deviating from the horizon, for example) from the post portion to form a spoke-and-hub structure in the light transmissive envelope. The support wire is attached to the post portion at a first end and to the LED filament at a second end. In the embodiment, the LED filament defines a sinuous curve along an arc meandering substantially horizontally in the light transmissive envelope. The sinuous curve oscillates in the range from $H2+A2$ to $H2-A2$ on the y-axis, where $H2$ represents the average height of the LED filament in the LED light bulb and $A2$ the amplitude of the sinuous curve the LED filament defines. $A2$ is greater than $A1$; likewise, $H2$ is greater than $H1$. Consequently, the stem press in Figs. 44A and 44B is a shorter structure projecting from projecting from the base. By contrast, the stem press we need in Fig. 45A to elevate the LED filament to a higher position in the main chamber becomes a longer structure having, for example, a basal portion and an elongated post portion. The plurality of support wires have a same length $R$. The posture of the LED filament in the LED light bulb is defined by all points in the set $(x, y, z + H2)$, where $-R =< x =< R$; $-R =< y =< R$; and $-A2 =< z =< A2$.

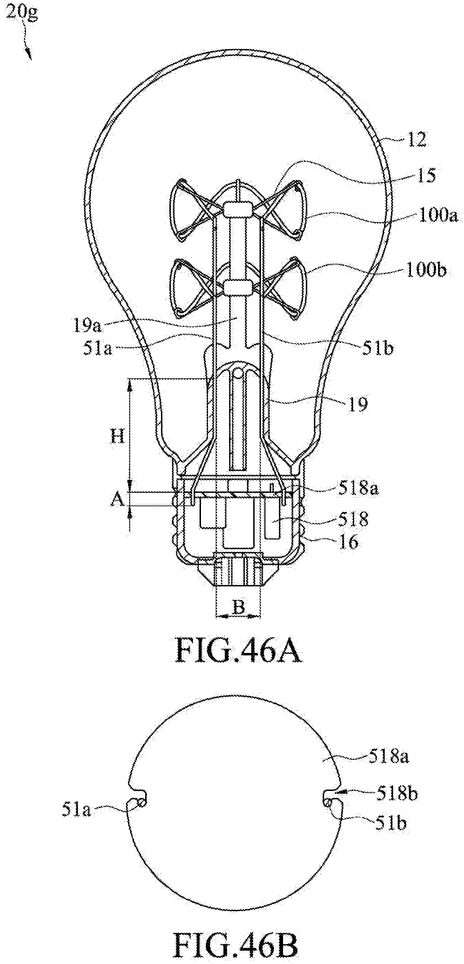

In Fig. 46A, the LED light bulb comprises a light transmissive envelope, a base, a stem press, an upper LED filaments, a lower LED filament, an upper set of lead wires, a lower set of lead wire, a rectifier and exactly two sets of support wires. The light transmissive envelope has a bulbous main chamber for housing the LED filament and a neck for connecting the light transmissive envelope to the base. The rectifier is disposed within the base. The set of support wires radiate (slightly deviating from the horizon, for example) from the post portion to form a spoke-and-hub structure in the light transmissive envelope. The support wire is attached to the post portion at a first end and to the LED filament at a second end. The upper set of support wires is configured to hold the upper LED filament in position. The lower set of support wires is configured to hold the lower LED filament in position. Other things equal, a shorter LED filament is needed to produce the same luminosity of omnidirectional light with the LED light bulb in Fig. 46A than the LED light bulb in Fig. 45A. Likewise, the LED light bulb in Fig. 46A is amenable to a smaller girth than the LED light bulb in Fig. 45A. In the embodiment, the LED filament defines a sinuous curve along an arc meandering substantially horizontally in the light transmissive envelope. The higher LED filament defines a higher sinuous curve oscillating in the range from $H3+A3$ to $H3-A3$ on the y-axis, where $H3$ represents the average height of the higher LED filament in the LED light bulb and $A3$ the amplitude of the first sinuous curve the higher LED filament defines. The lower LED filament defines a lower sinuous curve oscillating in the range from $H4+A3$ to $H4-A3$ on the y-axis, where $H4$ represents the average height of the lower LED filament in the LED light bulb and $A3$ the amplitude of the lower sinuous curve the lower LED filament defines. $H4$ is less than $H3$ on the y-axis, making one LED filament higher in the light transmissive envelope than the other one. $A3$ is chosen to be, for example, the same as that of the higher sinuous curve. The plurality of support wires have a same length $R$. The posture of the higher LED filament in the LED light bulb is defined by all points in the set $(x, y, z+H3)$, where $-R =< x =< R$; $-R =< y =< R$; and $-A3 =< z =< A3$. The posture of the lower LED filament in the LED light bulb is defined by all points in the set $(x, y, z+H4)$, where $-R =< x =< R$; $-R =< y =< R$; and $-A3 =< z =< A3$.

In the embodiment in Fig. 46A, the rectifier, which is disposed in the base, includes a circuit board in electrical communication with the lead wire. The pair of lead wires are parallelly spaced apart from each other. The upper portion of the lead wire is attached to the pair of LED filaments. The intermediate portion of the lead wire is fixedly attached to the basal portion of the stem press by passing through the basal portion. The lower portion of the lead wire is fixedly attached to the rectifier. In an embodiment, the circuit board includes an L-shaped aperture cut into the circumference of the circuit board. The lead wire includes a hook at the tip. The hook is configured to interlock the aperture for reliable soldering between the lead wire and the circuit board. The lead wire has a proper length for connecting the circuit board and the LED filament. In an embodiment, for purposes of safety, the lead wire has a length determined by D (mm). $D = A + \sqrt{(B-3.2)^2 + C^2}$, where 3.2 is the electricity safety spacing; A is the aggregate of the thickness of the circuit board and the length of the lead wire projecting downwards from the circuit board; B is the distance between the pair of lead wires; and C is distance from the entry point of the lead wire into the basal portion to the entry point of lead wire into the circuit board. Preferably, the length of the lead wire we need to reach the lower LED filament (L1) is from 0.5D to 2D. Most preferably, L1 is from 0.75D to 1.5D. The length of the lead wire we need to reach the upper LED filament (L2) is L1+(H3-H4).

In some embodiments, a layer of reflective materials, e.g. white paint, is coated to the support wire, the stem press, the upper surface of the base in the light transmissive envelope or any combination of the above for directing light outwards. In other embodiments, a layer of graphene, which has good thermal conductivity, is coated to the support wire, the stem press, the upper surface of the base in the light transmissive envelope or any combination of the above for better heat dissipation.

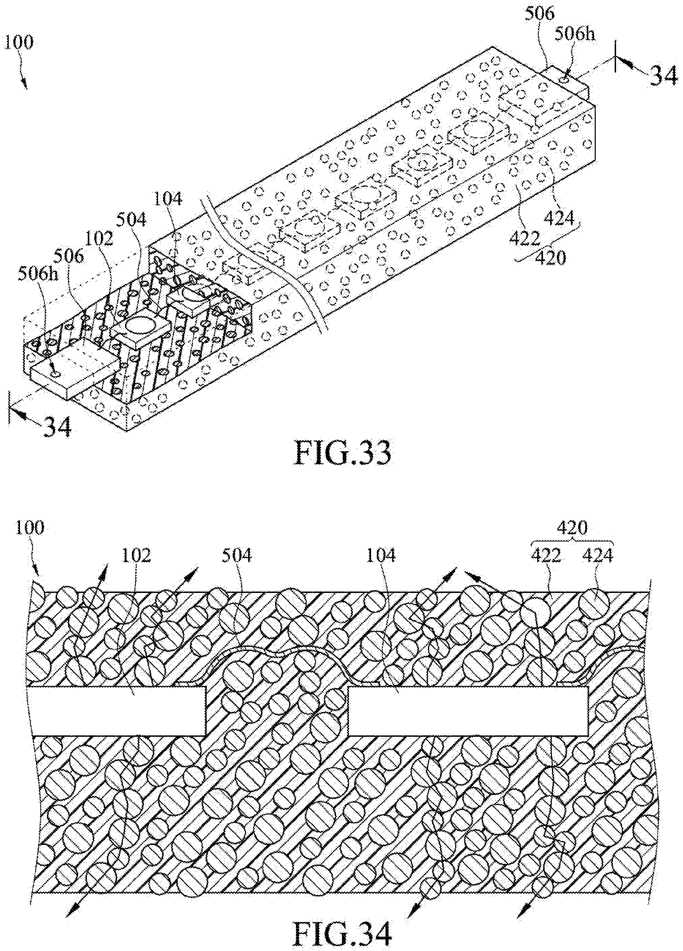

Please refer to FIGs. 33 and 34. FIG. 33 illustrates a perspective view of an LED filament with partial sectional view according to a first embodiment of the present disclosure while FIG. 34 illustrates a partial cross-sectional view at section 34-34 of FIG. 33. According to the first embodiment, the LED filament 100 comprises a plurality of LED chips 102, 104, at least two conductive electrodes 506, and a light conversion coating 420. The conductive electrodes 506 are disposed corresponding to the plurality of LED chips 102, 104. The LED chips 102, 104 are electrically coupled together. The conductive electrodes 506 are electrically connected with the plurality of LED chips 102, 104. The light conversion coating 420 coats on at least two sides of the LED chips 102, 104 and the conductive electrodes 506. The light conversion coating 420 exposes a portion of two of the conductive electrodes 506. The light conversion coating 420 comprises an adhesive 422 and a plurality of phosphors 424.

LED filament 100 emits light while the conductive electrodes 506 are applied with electrical power (electrical current sources or electrical voltage sources). In this embodiment, the light emitted from the LED filament 100 is substantially close to 360 degrees light like that from a point light source. An LED light bulb 20a, 20b, illustrated is in FIGs. 44A and 44B, utilizing the LED filament 100 is capable of emitting omnidirectional light, which will be described in detailed in the followings.

As illustrated in the FIG. 33, the cross-sectional outline of the LED filament 100 is rectangular. However, the cross-sectional outline of the LED filament 100 is not limited to rectangular, but may be triangle, circle, ellipse, square, diamond, or square with chamfers.

Each of LED chips 102, 104 may comprise a single LED die or a plurality of LED dies. The outline of the LED chip 102, 104 may be, but not limited to, a strip shape. The number of the LED chips 102, 104 having strip shapes of the LED filament 100 could be less, and, correspondingly the number of the electrodes of the LED chips 102, 104 is less, which can improve the illuminating efficiency since the electrodes may shield the illumination of the LED chip, thereby affecting the illumination efficiency. In addition, the LED chips 102, 104 may be coated on their surfaces with a conductive and transparent layer of Indium Tin Oxide (ITO). The metal oxide layer contributes to uniform distribution of the current diffusion and to increase of illumination efficiency. Specifically, the aspect ratio of the LED chip may be 2:1 to 10:1; for example, but not limited to, 14 × 28 or 10 × 20. Further, the LED chips 102, 104 may be high power LED dies and are operated at low electrical current to provide sufficient illumination but less heat.

The LED chips 102, 104 may comprise sapphire substrate or transparent substrate. Consequently, the substrates of the LED chips 102, 104 do not shield/ block light emitted from the LED chips 102, 104. In other words, the LED chips 102, 104 are capable of emitting light from each side of the LED chips 102, 104.

The electrical connections among the plurality of LED chips 102, 104 and the conductive electrodes 506, in this embodiment, may be shown in FIG. 33. The LED chips 102, 104 are connected in series and the conductive electrodes 506 are disposed on and electrically and respectively connected with the two ends of the series-connected LED chips 102, 104. However, the connections between the LED chips 102, 104 are not limited to that in FIG. 33. Alternatively, the connections may be that two adjacent LED chips 102, 104 are connected in parallel and then the parallel-connected pairs are connected in series.

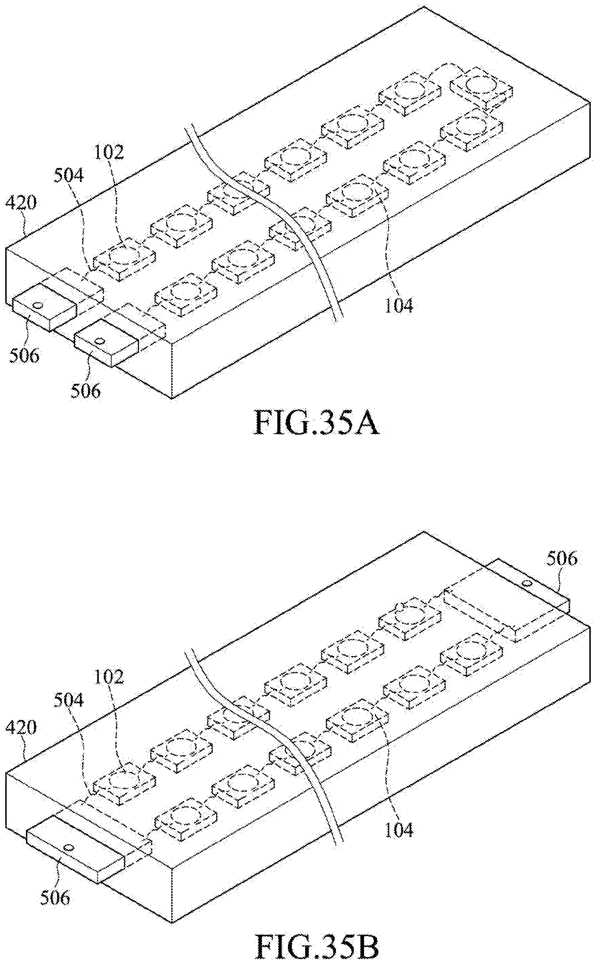

According to this embodiment, the conductive electrodes 506 may be, but not limited to, metal electrodes. The conductive electrodes 506 are disposed at two ends of the series-connected LED chips 102, 104 and a portion of each of the conductive electrodes 506 are exposed out of the light conversion coating 420. The arrangement of the conductive electrodes 506 is not limited to the aforementioned embodiment. Please refer to FIGs. 35A and 35B which illustrate disposition of metal electrodes and a plurality of LED chips according to other embodiments of the LED filament. In the embodiment of FIG. 35A, the LED chips 102, 104 are connected in series and the two ends of the series-connected LED chips 102, 104 are positioned at the same side of the LED filament 100 to form an U shape. Accordingly, the two conductive electrodes 506 are positioned at the same side as the ends of the series-connected LED chips 102, 104. According to the embodiment of FIG. 35B, the LED chips 102, 104 are disposed along two parallel LED strips and the LED chips 102, 104 along the same LED strip are connected in series. Two conductive electrodes 506 are disposed at two ends of the two parallel and series-connected LED chips 102, 104 and electrically connected to each of ends of the series-connected LED chips 102, 104. In this embodiment of FIG. 35B, there are, but not limited to, only two conductive electrodes 506. For examples, the LED filament 100, in practices, may comprise four sub-electrodes. The four sub-electrodes are connected to four ends of the series-connected LED chips 102, 104, respectively. The sub-electrodes may be connected to anode and ground as desired. Alternatively, one of two conductive electrodes 506 may be replaced with two sub-electrodes, depending upon the design needs.

Please further refer to FIG. 44A. The conductive electrodes 506 has through holes 506h (shown in FIG. 33) on the exposed portion for being connected with the conductive supports 51a, 51b of the LED light bulb 20a.

Please refer to FIGs. 33 and 34 again. According to this embodiment, the LED filament 100 further comprises conductive wires 540 for electrically connecting the adjacent LED chips 102, 104 and conductive electrodes 506. The conductive wires 540 may be gold wires formed by a wire bond of the LED package process, like Q-type. According to FIG. 34, the conductive wires 540 are of M shape. The M shape here is not to describe that the shape of the conductive wires 540 exactly looks like letter M, but to describe a shape which prevents the wires from being tight and provides buffers when the conductive wires 540 or the LED filament 100 is stretched or bended. Specifically, the M shape may be any shape formed by a conductive wire 540 whose length is longer than the length of a wire which naturally arched between two adjacent LED chips 102, 104. The M shape includes any shape which could provide buffers while the conductive wires 104 are bended or stretched; for example, S shape.

The light conversion coating 420 comprises adhesive 422 and phosphors 424. The light conversion coating 420 may, in this embodiment, wrap or encapsulate the LED chips 102, 104 and the conductive electrodes 506. In other words, in this embodiment, each of six sides of the LED chips 102, 104 is coated with the light conversion coating 420; preferably, but not limited to, is in direct contact with the light conversion coating 420. However, at least two sides of the LED chips 102, 104 may be coated with the light conversion coating 420. Preferably, the light conversion coating 420 may directly contact at least two sides of the LED chips 102, 104. The two directly-contacted sides may be the major surfaces which the LED chips emit light. Referring to FIG. 33, the major two surfaces may be the top and the bottom surfaces. In other words, the light conversion coating 420 may directly contact the top and the bottom surfaces of the LED chips 102, 104 (upper and lower surfaces of the LED chips 102, 104 shown in FIG. 34). Said contact between each of six sides of the LED chips 102, 104 and the light conversion coating 420 may be that the light conversion coating 420 directly or indirectly contacts at least a portion of each side of the LED chips 102, 104.

Specifically, one or two sides of the LED chips 102, 104 may be in contact with the light conversion coating 420 through die bond glue. The light conversion coating 420 may further comprise heat dissipation particles (such as nanoparticle oxide) to improve the effect of heat dissipation. In following embodiments, the heat dissipation particles may be nanoparticle oxide. In some embodiments, the die bond glue may be mixed with phosphors to increase efficiency of light conversion. The die bond glue may be silica gel or silicone resin mixed with silver powder or heat dissipating powder to increase effect of heat dissipation thereof. The adhesive 422 may be silica gel. In addition, the silica gel may be partially or totally replaced with polyimide, resin materials (e.g., silicone resin), or other transparent material with greater transmittance (e.g., glass or graphene oxide) to improve the toughness of the light conversion coating 420 and to reduce possibility of cracking or embrittlement.

The phosphors 424 of the light conversion coating 420 absorb some form of radiation to emit light. For instance, the phosphors 424 absorb light with shorter wavelength and then emit light with longer wavelength. In one embodiment, the phosphors 424 absorb blue light and then emit yellow light. The blue light which is not absorbed by the phosphors 424 mixes with the yellow light to form white light. According to the embodiment where six sides of the LED chips 102, 104 are coated with the light conversion coating 420, the phosphors 424 absorb light with shorter wavelength out of each of the sides of the LED chips 102, 104 and emit light with longer wavelength. The mixed light (longer and shorter wavelength) is emitted from the outer surface of the light conversion coating 420 which surrounds the LED chips 102, 104 to form the main body of the LED filament 100. In other words, each of sides of the LED filament 100 emits the mixed light.

The light conversion coating 420 may expose a portion of two of the conductive electrodes 506. Phosphors 424 are harder than the adhesive 422. The size of the phosphors 424 may be 1 to 30 um (micrometer) or 5 to 20 um. The size of the same phosphors 424 are generally the same. In FIG. 34, the reason why the cross-sectional sizes of the phosphors 424 are different is the positions of the cross-section for the phosphors 424 are different. The adhesive 422 may be transparent, for example, epoxy resin, modified resin or silica gel, and so on.

The composition ratio of the phosphors 424 to the adhesive 422 may be 1:1 to 99: 1, or 1: 1 to 50: 1. The composition ratio may be volume ratio or weight ratio. Please refer to FIG. 34 again. The amount of the phosphors 424 is greater than the adhesive 422 to increase the density of the phosphors 424 and to increase direct contacts among phosphors 424. The arrow lines on FIG. 34 show thermal conduction paths from LED chips 102, 104 to the outer surfaces of the LED filament 100. The thermal conduction paths are formed by the adjacent and contacted phosphors. The more direct contacts among the phosphors 424, the more thermal conduction paths forms, the greater the heat dissipating effect the LED filament 100 has, and the less the light conversion coating becomes yellow. Additionally, the light conversion rate of the phosphors 424 may reach 30% to 70% and the total luminance efficiency of the LED light bulb 20a, 20b is increased. Further, the hardness of the LED filament 100 is increased, too. Accordingly, the LED filament 100 may stand alone without any embedded supporting component like rigid substrates. Furthermore, the surfaces of cured LED filament 100 are not flat due to the protrusion of some of the phosphors 424. In other words, the roughness of the surfaces and the total surface area are increased. The increased roughness of the surfaces improves the amount of light passing the surfaces. The increased surface area enhances the heat dissipating effect. As a result, the overall luminance efficiency of the LED light filament 100 is raised. In some embodiments, the surface of the light conversion coating may be of a lens shape. Different lens shape may cause different optical effects. In some embodiments, there may be one or more gaps inside the light conversion coating to improve the effect of heat dissipation. In another embodiment, the percentage of the adhesive 422 (or other transparent resins) by weight may be 60 wt% or less, and the percentage of the phosphors 424 by weight may be 30 wt% or greater

Next, LED chips 102, 104 may comprise LED dies which emit blue light. The phosphors 424 may be yellow phosphors (for example Garnet series phosphors, YAG phosphors), so that the LED filament 100 may emit white light. In practices, the composition ratio of phosphors 424 to the adhesive 422 may be adjusted to make the spectrum of the white light emitted from the LED filament 100 closer to that emitted from incandescent bulbs. Alternatively, the phosphors 424 may be powders which absorb blue light (light with shorter wavelength) and emit yellow green light (hereinafter referred to yellow green powders) or emit red light (hereinafter referred to red powders) (light with longer wavelength). The light conversion coating 420 may comprise less red powders and more yellow green powders, so that the CCT (corrected color temperature) of the light emitted from the LED filament 100 may close to 2,400 to 2,600 K (incandescent light). The ratio of the red powders and yellow green powders may be 1:5 to 1:7.

As mention above, a desired deflection of the LED filament 100 may be achieved by the adjustment of the ratio of phosphors 424 to the adhesive 422. For instance, the Young's Modulus (Y) of the LED filament 100 may be between $0.1 \times 10^{10}$ to $0.3 \times 10^{10}$ Pa. If necessary, the Young's Modulus of the LED filament 100 may be between $0.15 \times 10^{10}$ to $0.25 \times 10^{10}$ Pa. Consequently, the LED filament 100 would not be easily broken and still possess adequate rigidity and deflection.

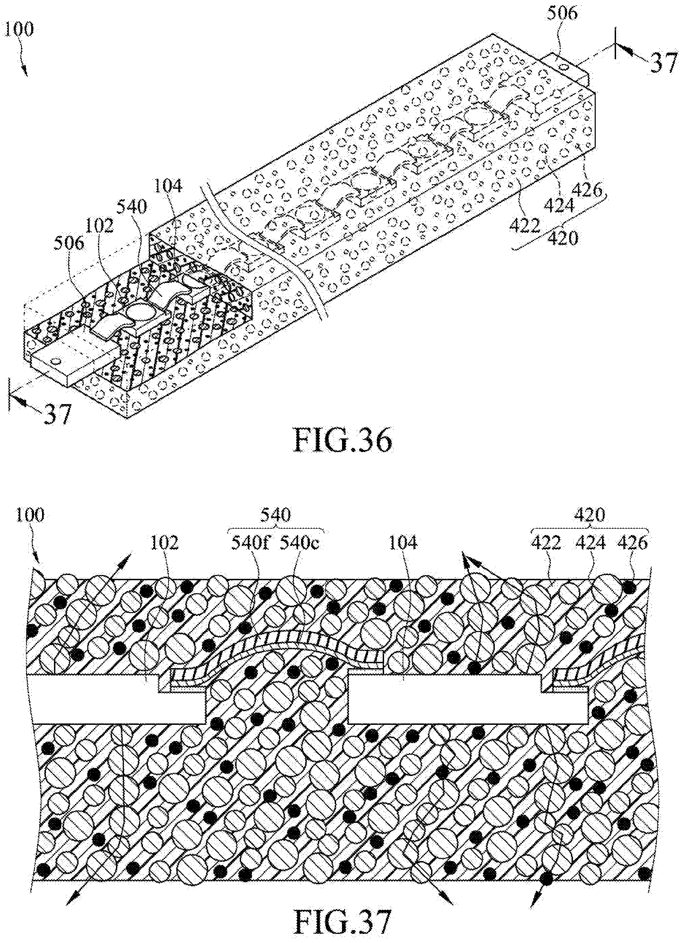

Please refer to FIGs. 36 to 37. FIG. 36 illustrates a perspective view of an LED light bulb with partial sectional view according to a second embodiment of the LED filament and FIG. 37 illustrates a partial cross-sectional view at section 37-37 of FIG. 36.

According to the second embodiment of the LED filament 100, the LED filament 100 comprises a plurality of LED chips 102, 104, at least two conductive electrodes 506, and a light conversion coating 420. The conductive electrodes 506 are disposed corresponding to the plurality of LED chips 102, 104. The plurality of LED chips 102, 104 and the conductive electrodes 506 are electrically connected therebetween. The light conversion coating 420 coats on at least two sides of the LED chips 102, 104 and the conductive electrodes 506. The light conversion coating 420 exposes a portion of two of the conductive electrodes 506. The light conversion coating 420 comprises an adhesive 422, a plurality of inorganic oxide nanoparticles 426 and a plurality of phosphors 424.

The size of the plurality of inorganic oxide nanoparticles 426 is around 10 to 300 nanometers (nm) or majorly is around 20 to 100 nm. The size of the plurality of inorganic oxide nanoparticles 426 is lesser than that of the phosphors 424. The plurality of the inorganic oxide nanoparticles 426 which server as heat dissipation particles may be, but not limited to, aluminium oxides ($Al_2O_3$), silicon oxide ($SiO_2$), zirconium oxide (Zirconia, $ZrO_2$), titanic oxide ($TiO_2$), Calcium oxide (CaO), strontium oxide (SrO), and Barium oxide (BaO). The inorganic oxide nanoparticles 426 may also be other heat dissipation particles having greater thermal conductivity or/and thermal emissivity for heat dissipation and transmittance. For example, the reaction metals of the aforementioned oxide can be replaced by nitride generated by the reaction of nitrogenization, such as Aluminum nitride (AIN). The average size of the inorganic nanoparticles may be from 10 to 300 nm. The size of most of the inorganic nanoparticles is from 20 to 100 nm. In addition, there are heat dissipation nanoparticles with sizes less than 100 nm. Further, the size of the heat dissipation nanoparticles may be less than 100 um.

As shown in FIG. 37, the inorganic oxide nanoparticles 426 and the phosphors 424 are mixed with the adhesive 422. The unit prices and the hardness of the inorganic oxide nanoparticles 426 and the phosphors 424 are different. Therefore, a desired deflection, thermal conductivity, hardness, and cost of the LED filament 100 may be reached by adjustment of the ratio of the adhesive 422, phosphors 424 to the inorganic oxide nanoparticles 426 affects. In addition, due that the size of the inorganic oxide nanoparticles 426 is lesser than that of the phosphors 424, the inorganic oxide nanoparticles 426 may fill into the gaps among the phosphors 424. Hence, the contact area among the phosphors 424 and the inorganic oxide nanoparticles 426 is increased and thermal conduction paths are increased as shown by arrow lines on FIG. 37, too. The thermal conductivity of typical transparent glue may be 0.2 W/mk to 3 W/mk. The thermal conductivity of a phosphor film/phosphor glue formed with phosphor powders/heat dissipation particles may be 0.5 W/mk to 3 W/mk. Further, the inorganic oxide nanoparticles 426 may deflect or scatter light incident thereon.

The light deflection and scattering make the light emitted from phosphors 424 mixed more uniformly and the characteristics of the LED filament 100 becomes even better. Furthermore, the impedance of the inorganic oxide nanoparticles 426 is high and no electrical leakage would happen through the inorganic oxide nanoparticles 426.

In some embodiments, the phosphors 424 are substantially uniformly distributed in the adhesive 422 (for instance, in silica gel, the polyimide or resin materials). Each of the phosphors 424 may be partially or totally wrapped by the adhesive 422 to improve the cracking or embrittlement of the light conversion coating 420. In the case that not each of the phosphors 424 is totally wrapped by the adhesive 422, the cracking or embrittlement of the light conversion coating 420 is still improved. In some embodiments, silica gel may be mixed with the polyimide or resin materials to form the light conversion coating 420.

The LED filament 100 further comprises a plurality of circuit film 540 (or call as transparent circuit film) for electrically and correspondingly connected among the plurality of LED chips and the conductive electrodes. Specifically, the plurality of circuit film 540 is electrically connecting the adjacent LED chips 102, 104 and conductive electrodes 506. The light conversion coating 420 may encapsulate the plurality of circuit film 540.

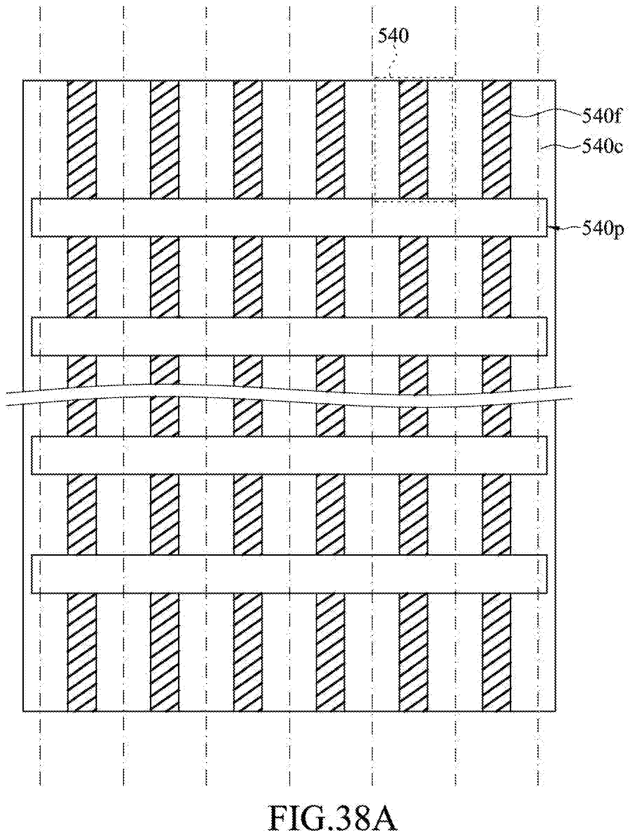

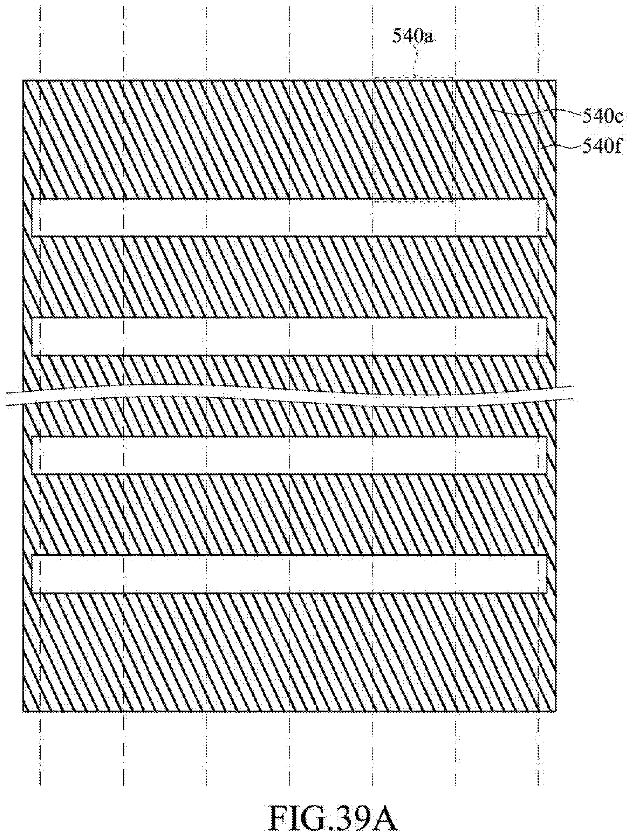

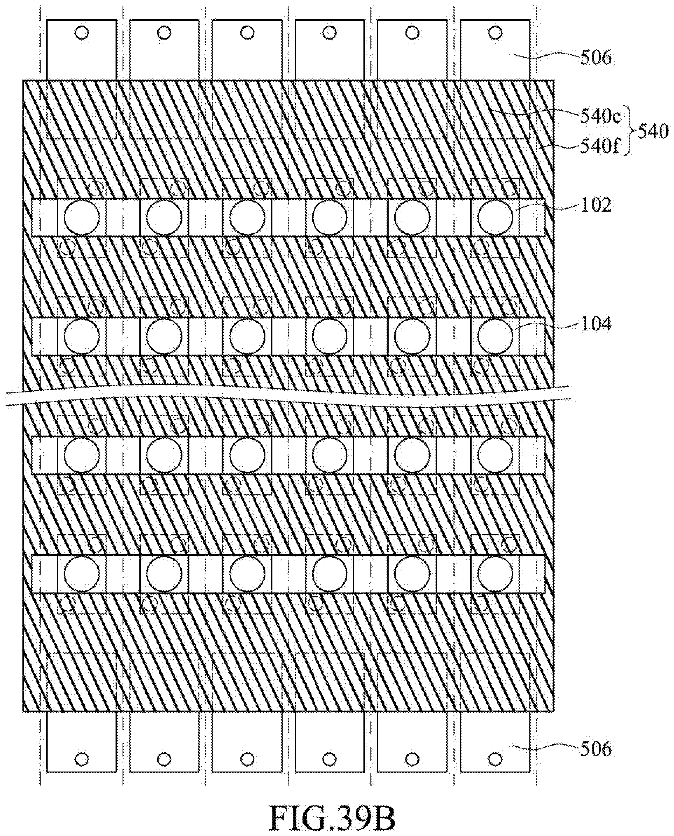

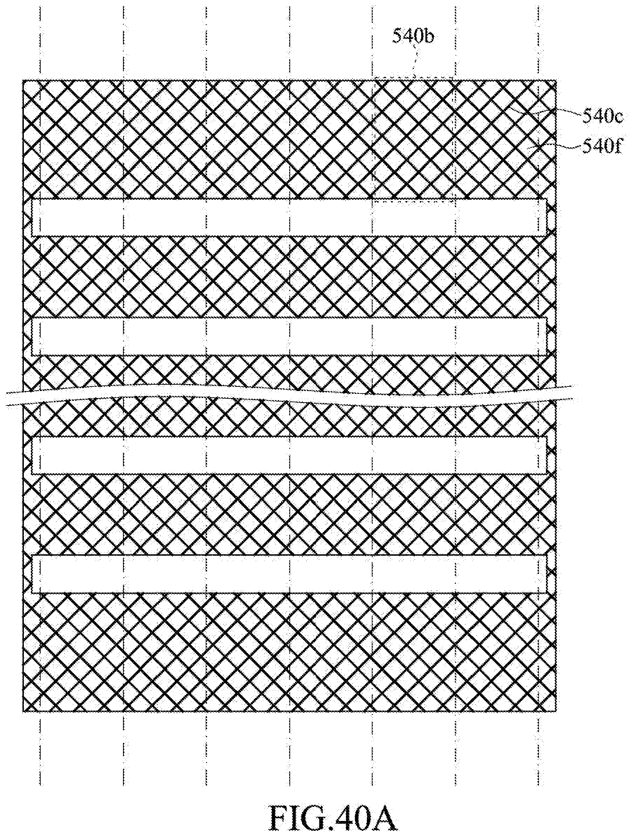

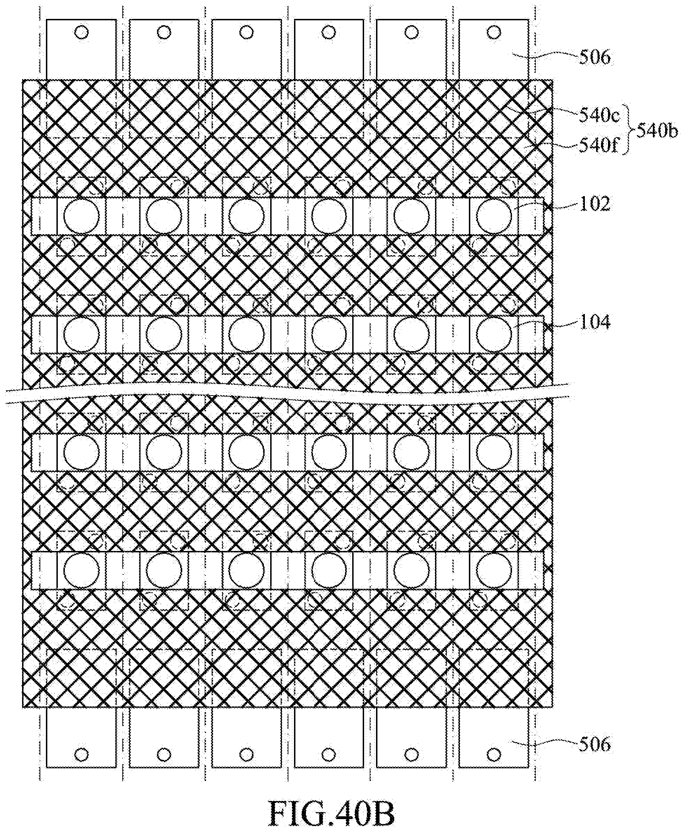

Please refer to FIGs. 38A. FIG. 38A illustrates a first embodiment of the uncut circuit film according to the second embodiment of the LED filament 100. Each of the circuit films 540 comprises a first film 540f and a conductive circuit 540c disposed on the first film 540f. The first film 540f in one embodiment may be, but not limited to, a thin film. In order to be easily understood the embodiments, the following description uses thin film as an example for the first film 540f. However, the thin film 540f is not the only embodiment for the first film 540f. The thin film 540f may be a transparent or translucent film. The transparent film may allow light emitted from the LED chips 102, 104 and/or phosphors 424 to pass. The conductive circuits 540c are electrically and correspondingly connected among the plurality of LED chips 102, 104 and the conductive electrodes 506. In this embodiment, the conductive circuits 540c are of bar shape and substantially parallel to each other. However, the conductive circuits 540c may be in other shape or pattern. Please refer to FIG. 39A which illustrates a second embodiment of the uncut circuit film according to the second embodiment of the LED filament. Each of the circuit films 540a comprises a thin film 540f and a conductive circuit 540c disposed on the thin film 540f. The conductive circuits 540c are substantially parallel lines electrically connected with pads of adjacent LED chips 102, 104 as shown in FIG. 39B. Please refer to FIG. 40A which illustrates a third embodiment of the uncut circuit film according to the second embodiment of the LED filament. Each of the circuit films 540b comprises a thin film 540f and a conductive circuit 540c disposed on the thin film 540f. The conductive circuits 540c are crossover lines electrically connected with pads of adjacent LED chips 102, 104 as shown in FIG. 40B. The width of the lines may be 10 micrometers (um) and the thickness of the lines may be 2 um. The pattern or shape of the conductive circuits 540c are not limited to the above-mentioned embodiments, any pattern or shape which is capable of connecting pads of adjacent LED chips 102, 104 and conductive electrodes 506 are feasible.

The thin film 540f may be, but not limited to, Polyimide film (PI film). Transmittance of the polyimide film is above 92%. The material of the conductive circuit 540c may be, but not limited to, indium tin oxide (ITO), nano-silver plasma, metal grids, or nano-tubes. The advantages of Silver include good reflection and low light absorption. Nano-scaled silver lines in grid shape have advantages of low resistance and high penetration of light. In addition, gold-doped nano-silver lines may enhance the adherence between the pads of the LED chips 202, 204 and the sliver lines (conductive circuits).

Please refer to FIG. 38A again. The circuit film 540 may be made by firstly forming conductive circuits 540c on a thin film 540f, and then forming slots 540p on the thin film 540f with the conductive circuits 540c.

Regarding the electrical connection among the circuit film 540, LED chips 102, 104, and the conductive electrodes 506, conductive glues may be applied on the surfaces of the LED chips 102, 104 and the conductive electrodes 506 where the conductive circuits 540c are going to electrically connect. The conductive glues may be, but not limited to, silver paste, solder paste (tin paste), or conductive glues doped with conductive particles. Then, dispose the circuit film 540 on the LED chips 102, 104 and the conductive electrodes 506 with adequate alignment and cure the circuit film 540 and the conductive glues by heat or UV.

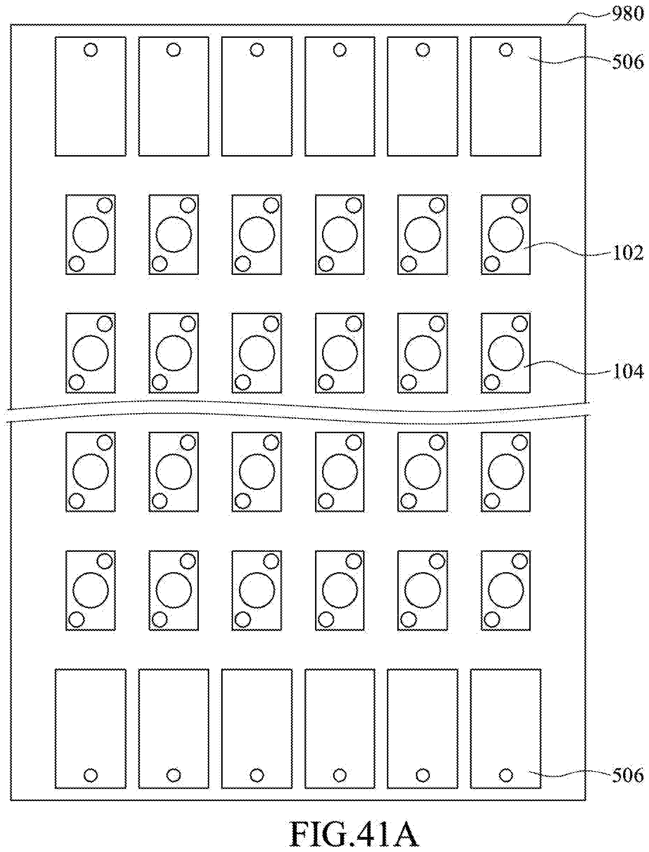

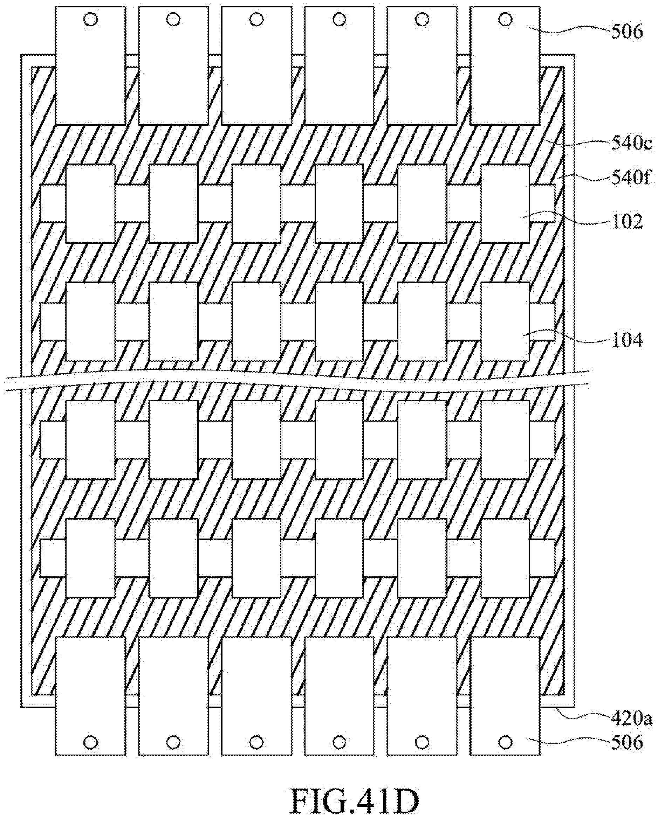

Please refer to FIGs. 41A to 41E which illustrate a manufacturing method of an LED filament according to a first embodiment. The manufacturing method of the LED filament 100 shown in FIG.36 comprises:

S20: dispose LED chips 102, 104 and at least two conductive electrodes 506 on a carrier 980, referring to FIG. 41A;

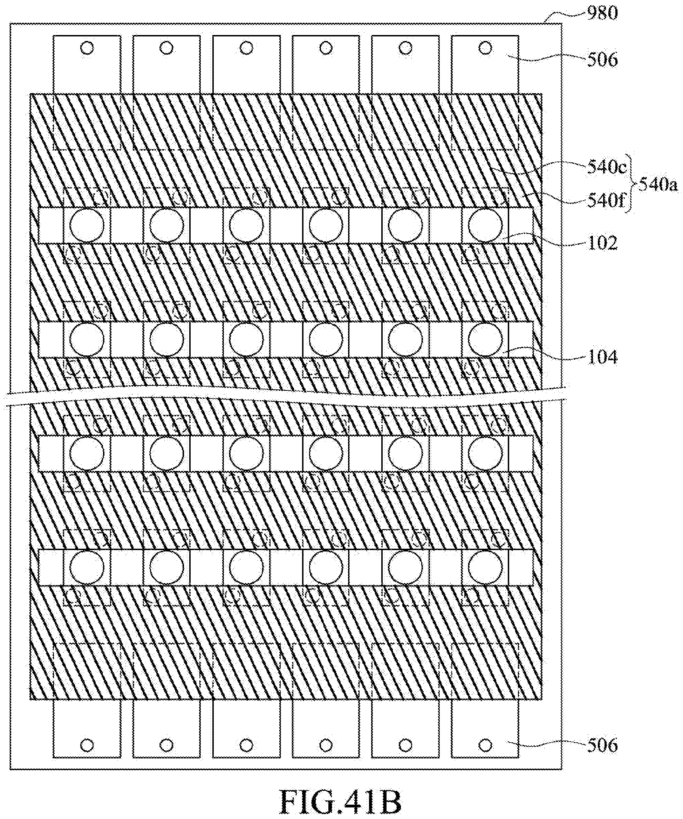

S22: electrically connect the LED chips 102, 104 with the conductive electrodes 506, referring to FIG. 41B; and

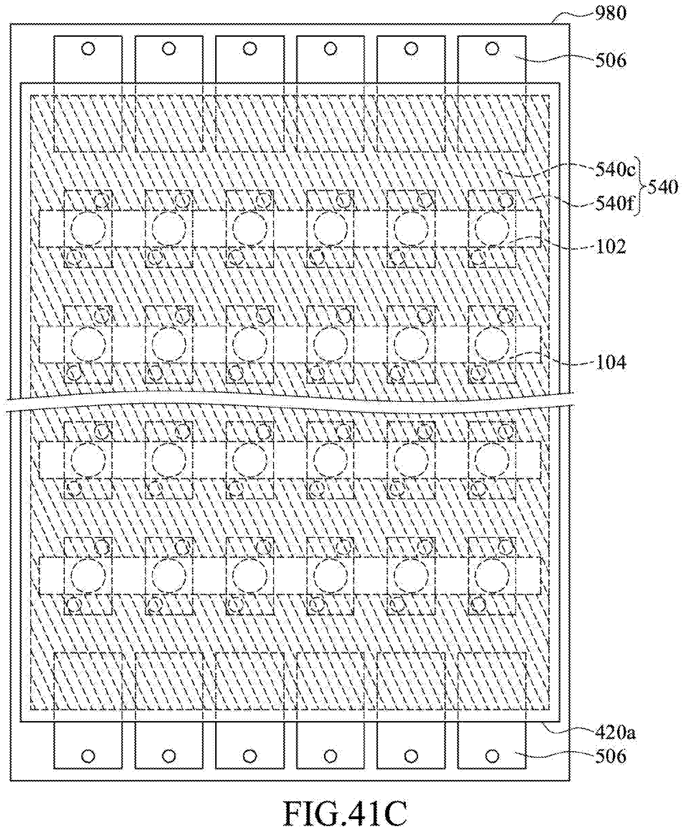

S24: dispose a light conversion coating 420 on the LED chips 102, 104 and the conductive electrodes 506. The light conversion coating 420 coats on at least two sides of the LED chips 102, 104 and the conductive electrodes 506. The light conversion coating 420 exposes a portion of at least two of the conductive electrodes 506. The light conversion coating 420 comprises adhesive 422 and a plurality of phosphors 424, referring to FIG. 41C to 41E.

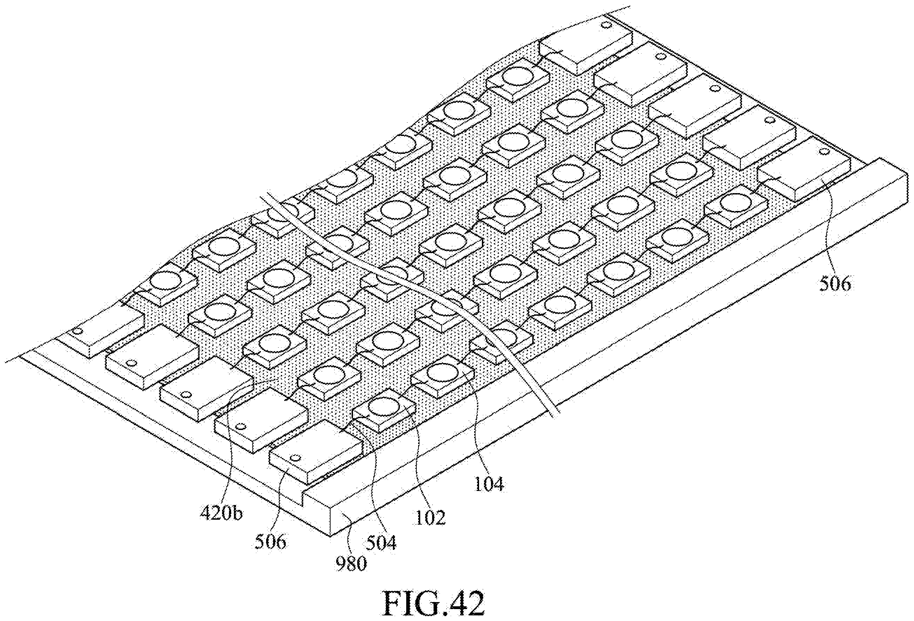

In S20, the plurality of LED chips 102, 104 are disposed in a rectangular array. Each column of the LED chips 102, 104, at the end of the manufacturing process, may be cut into a single LED filament 100. During disposition of the LED chips 102, 104, the anodes and cathodes of the LED chips 102, 104 should be properly orientated for later connected in series or parallel. The carrier 980 may be, but not limited to, glass substrate or metal substrate. The carrier 980 may be, but not limited to, a plate like that shown in FIG. 41A, or a plate with a groove like the carrier 980 shown in FIG. 42. The groove is for being disposed with the base layer 420b.

In S22, the uncut circuit film 540a is similar to the circuit film 540a shown in FIG. 39A. The LED chips 102, 104 and the conductive electrodes 506 are electrically connected by the parallel conductive lines. Alternatively, the circuit film 540, 240b shown, respectively, in FIG. 38A or 40A may be used in S22. The conductive wires 540 shown in FIG. 34 can be used in S22, too.

In S24, the light conversion coating 420 may be coated on the LED chips 102, 104 and the conductive electrodes 506 by different method. Firstly, taking FIG. 41C to 41E as an example, the manufacturing method of S24 comprises:

S240: coat a light conversion sub-layer (top layer 420a) on a surface of the LED chips 102, 104 and the conductive electrodes 506 which is not contact with the carrier 980;
S242: flip over the LED chips 102, 104 and the conductive electrodes 506 disposed with the top layer 420a; and
S244: coat a light conversion sub-layer (base layer 420b) on a surface of the LED chips 102, 104 and the conductive electrodes 506 which are not coated with the top layer 420a.

In order to distinguish the light conversion sub-layers in S240 and in S244, the light conversion sub-layer in S240 is referred to top layer 420a and the light conversion sub-layer in S244 is referred to base layer 420b hereinafter.

In S240, after the LED chips 102, 104 and the conductive electrodes 506 are coated with the top layer 420a, the adhesive 422 and the phosphors 424 will fill out the gaps among the LED chips 102, 104 and the conductive electrodes 506. Then, proceed with a curing process to harden the top layer which encapsulates the upper part of the LED chips 102, 104 and the conductive electrodes 506 and exposes a portion of at least two of the conductive electrodes 506. The curing process may be done by heat or UV.

In S242, the flip-over of the semi-finished piece may be done by two different ways in accordance with different situations. Concerning the first flip-over way, the LED chips 102, 104 and the conductive electrodes 506 are disposed on the carrier 980 without any adherences with the carrier 980. S242 can be done by flip the cured semi-finished piece over directly. Then, place the flipped-over semi-finished piece on the carrier 980 again. (The semi-finished piece is the cured the LED chips 102, 104 and the conductive electrodes 506 covered with the top layer 420a.)

As for the second way, glues are applied on the carrier 980. The glues are, for instance, photoresist in semiconductor process, or die bond glues. The glues (photoresist or die bond glues) is for temporarily fixing the LED chips 102, 104 and the conductive electrodes 506 on the carrier 980. The glue may be removed by acetone or solvent and the semi-finished piece is separated from the carrier 980. If necessary, the remained glues may be removed by an additional cleaning process.

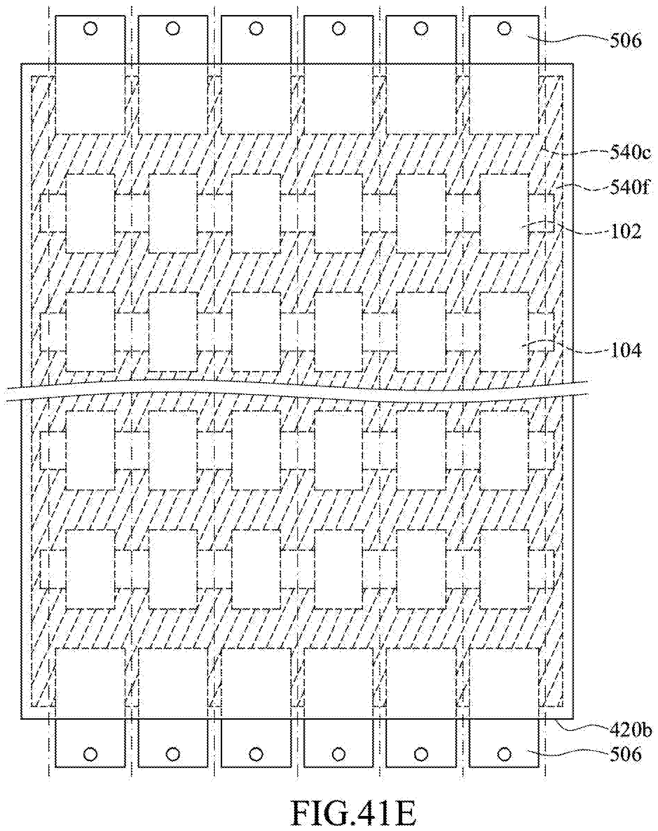

In S244, referring to FIG. 41E, cure the base layer 420b after the base layer 420b is coated on the surface of the LED chips 102, 104 and the conductive electrodes 506.

Referring to FIG. 41C, the top layer 420a is slightly greater than the uncut circuit film 540a. However, it is not a requirement. The sizes of the top layer 420a may be the same as or lesser than that of the uncut circuit film 540a. Referring to FIG. 41E, the area of the top layer 420a is substantially the same as that of the base layer 420b. It is not a requirement, either. In implementation, the area of the top layer 420a may be greater or lesser than the area of the base layer 420b. FIG. 41E illustrates a semi-finished LED filament where a plurality of LED filaments 100 are integrated into one piece.

After S24, the method may further comprise S26: cut the semi-finished LED filament along the dot-and-dash lines shown in FIG. 41E. Each cut portion is an LED filament 100. The semi-finished LED may be cut every other two dot-and-dash lines.

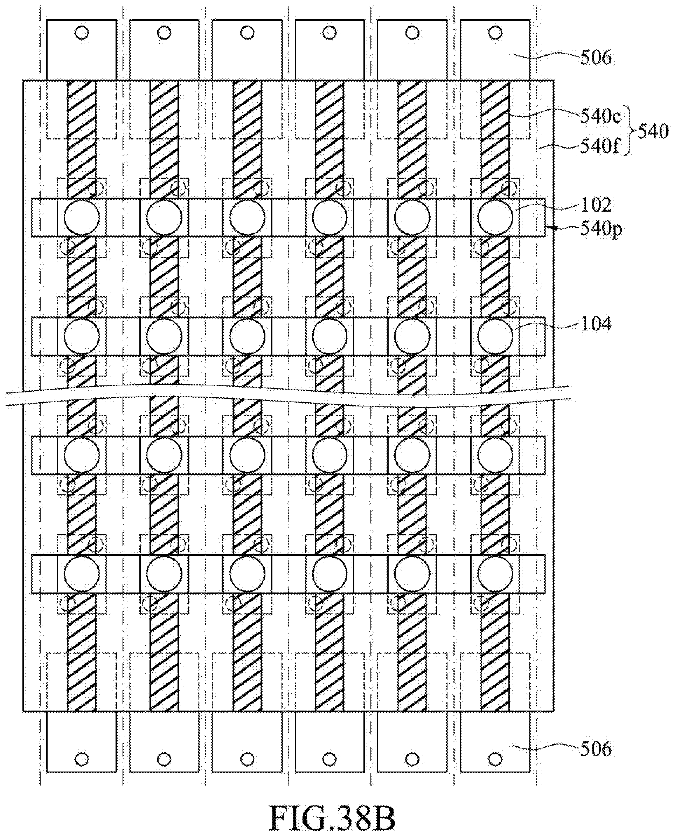

FIGs. 38B, 39B and 40B illustrate uncut circuit films 540, 540b of FIGs. 38A, 39A and 40A covering the LED chips 102, 104 and the conductive electrodes 506 with proper alignment.

The method of FIGs. 41A to 41E illustrates each LED filament are disposed in a rectangular array manner. Alternatively, the disposition of S20 may be a single column of LED chips 102, 104. In the consequence, S26 may be omitted.

Please refer to FIG. 42 for the second embodiment of the manufacturing method for the LED filament 100. The method comprises:

S20A: coat a light conversion sub-layer (a base layer 420b) on a carrier 980;
S20B: dispose LED chips 102, 104 and conductive electrodes 506 on the base layer 420b;
S22: electrically connect the LED chips 102, 104 with the conductive electrodes 506; and
S24: coat a light conversion sub-layer (top layer 420a) on the LED chips 102, 104 and the conductive electrodes 506. The top layer 420a coats on the LED chips 102, 104 and the conductive electrodes 506. The top layer 420a and the base layer 420b expose a portion of at least two of the conductive electrodes 506. The light conversion coating 420 (top layer 420a and the base layer 420b) comprises adhesive 422 and a plurality of phosphors 424.

As shown in FIG. 42, the base layer 420b is a part of the light conversion coating 420 and comprises an adhesive 422 and phosphors 424. In the embodiment of FIG. 42, the base layer 420b is, but not limited to, coated on the carrier 980 with a groove. Alternatively, the carrier 980 can be omitted. In other words, the base layer 420b may be place on a work table without any carrier 980. The LED chips 102, 104 and the conductive electrodes 506 are disposed on the base layer 420b. Additionally, before the step S20B, the phosphor film formed by curing the base layer 420b can be manufactured in advance and is attached to a periphery of the carrier by adhesives later. In such case, the phosphor film is partially attached to the carrier and thus is easily separated from the carrier in a stamping manner during the process of filament cutting and carrier removing.

The thickness of the base layer 420b may be 50 to 100 um. The composition ratio of phosphors 424 to the adhesive 422 can be adjusted and the thickness of the base layer 420b may be around 60 to 80 um. After S20, a pre-curing process may be used to slightly cure the base layer 420b so that the LED chips 102, 104 and the conductive electrodes 506 can be fixed on the base layer 420b. Besides, the LED chips 102, 104 and the conductive electrodes 506 may be fixed on the base layer 420b by die bond glues.

After the electrical connection of S22, the top layer 420a is coated on the LED chips 102, 104 and the conductive electrodes 506 and then a curing process is proceeded with to cure the top layer 420a. Consequently, the flip-over of S242 and glue-removing process are omitted.

According to the embodiment of FIG. 42, after S24, the process of S26 may be proceeded with.

The base layer 420b is used for carrying the LED chips 102, 104 and the conductive electrodes 506 and its thickness may be 0.5 to 3 millimeters (mm) or 1 to 2 mm.

The composition ratio of phosphors 424 to the adhesive 422 may be adjusted accordingly to make the base layer 420b hard enough to sufficiently carry the LED chips 102, 104 and the conductive electrodes 506 and for the following process like wire bond. The Shore D Hardness of the base layer 420b may be at least 60 HD. Hence, the overall LED filament 100 will have enough hardness, rigidity and deflection. The electrical conductivity of the connection among the LED chips 102, 104 and the conductive electrodes 506 can be maintained even though the LED filament 100 is bent.

In accordance with the embodiment of FIG. 42, the hardness of the cured base layer 420b is better to be sufficient to carry the LED chips 102, 104 and the conductive electrodes 506 and to support for the wire bonding process. However, the top layer 420a is not required to have the same hardness as the base layer 420b. Accordingly, the adjustment of ratio of the phosphors 424 to the adhesive 422 is more flexible. Alternatively, the light conversion coating 420 may comprise inorganic oxide nanoparticles (not shown in FIG. 42).

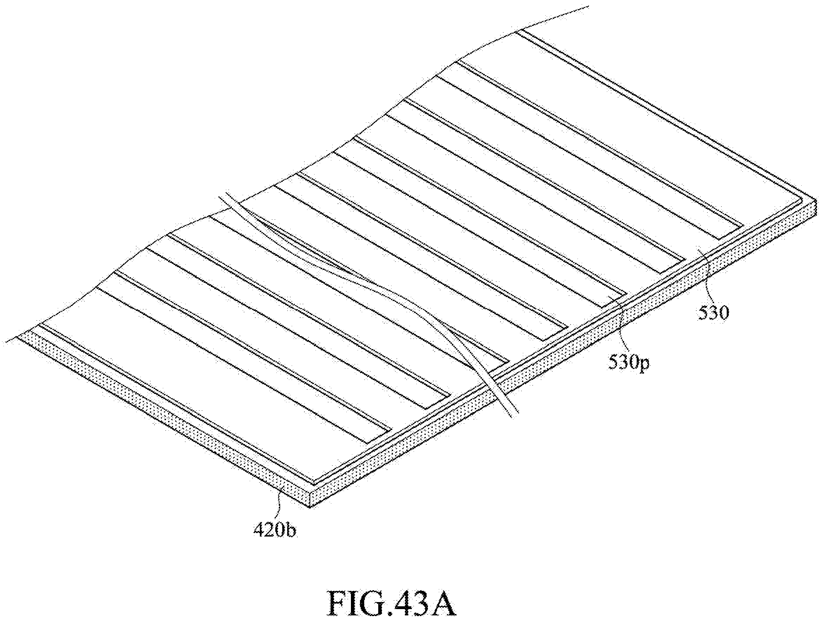

Next, please refer to FIGs. 43A to 43E which illustrate a manufacturing method of an LED filament according to a third embodiment. The manufacturing method for an Led filament 100 comprises:

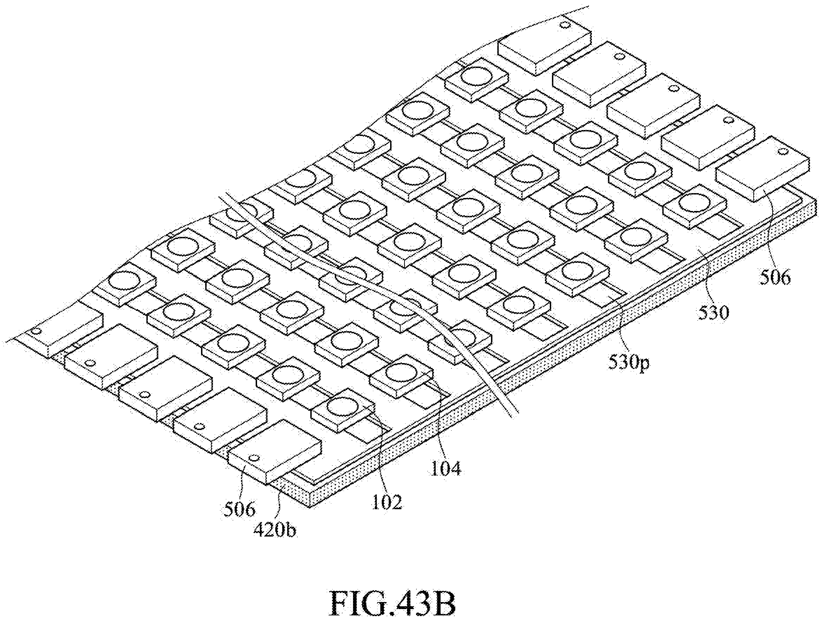

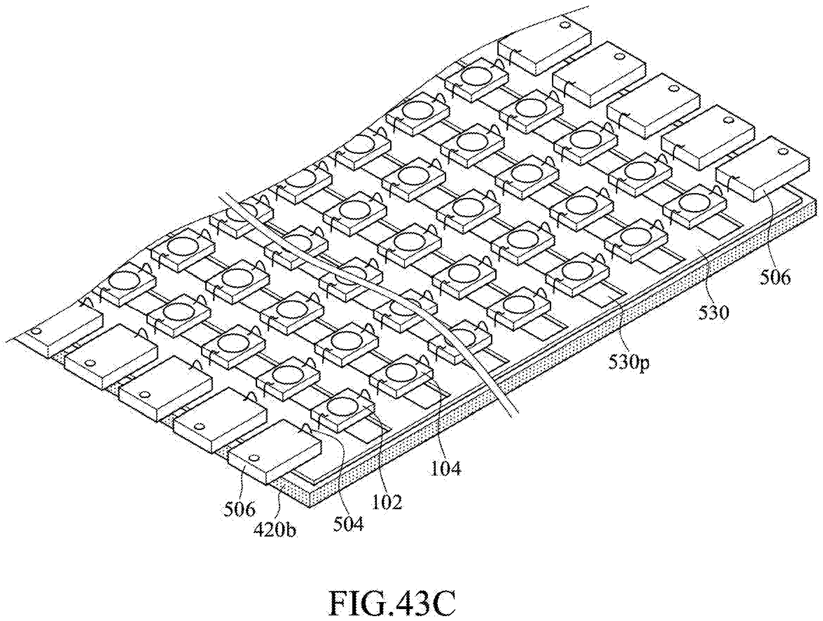

S202: dispose conductive foil 530 on a light conversion sub-layer (base layer 420b), referring to FIG. 43A;
S204: dispose a plurality of LED chips 102, 104 and a plurality of conductive electrodes 506 on the conductive foil 530, referring to FIG. 43B;
S22: electrically connect the LED chips 102, 104 with the conductive electrodes 506, referring to FIG. 43C; and
S24: coat a light conversion sub-layer (top layer 420a) on the surfaces of the LED chips 102, 104 and the conductive electrode 506 where may be not in contact with the conductive foil 530. The light conversion coating 420 (including the base layer 420b and the top layer 420a) coats on at least two sides of the LED chips 102, 104 and the conductive electrodes 506. The light conversion coating 420 exposes a portion of at least two of the plurality of conductive electrodes 506. The light conversion coating 420 comprises adhesive 422 and phosphors 424.

Please refer to FIG. 43A, the light conversion coating of S202 is called as the base layer 420b. The conductive foil 530 may have a plurality of openings 530p. The width of each of the openings 530p may be lesser than the length of the LED chips 102, 104 and each of the openings 530p is aligned with the portion of the LED chips 102, 104 which emits light. Therefore, light emitted from LED may pass through the openings 530p without any shielding or blocking.

The conductive foil 530 may be, but not limited to, a copper foil coated with silver. The openings 530p may be formed by punching or stamping on a copper foil.

Before S202, the method may comprise a prestep: dispose the base layer 420b on a carrier (like 980 of FIG. 42) or on a work table.

In S204, please refer to FIG. 11B. The LED chips 102, 104 and the conductive electrodes 506 are disposed on the conductive foil 530. As above-mentioned, the light emitting portions of the LED chips 102, 104 are better to align with the openings 530p.

Please refer to FIG. 43C. The electrical connection of S22 may be accomplished by wire bonding process like that shown in FIG. 33. As shown in FIG. 43C, the LED chips 102, 104 and the conductive electrodes 506 are electrically connected together in series.

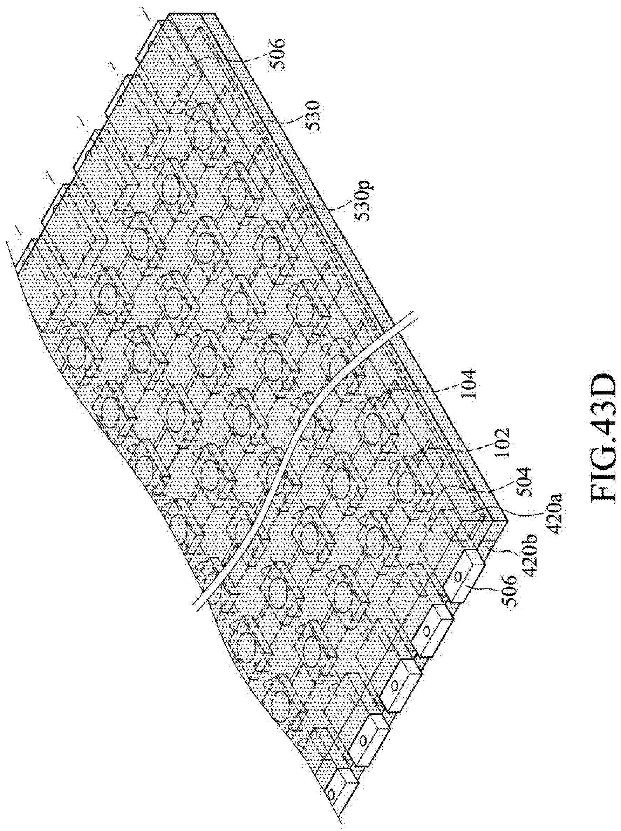

Next, please refer to FIG. 43D. Like the embodiment of FIG. 42, the light conversion sub-layer may be referred to top layer 420a. The top layer 420a fills out the gaps among the LED chips 102, 104 and the conductive electrodes 506 including the gaps under the LED chips 102, 104 and the openings 530p.

Regarding the disposition of the top layer 420a, there are a few methods to proceed with. The first one is to coat a mixture of the adhesive 422 and the phosphors 424 on the LED chips 102, 104 and the conductive electrodes 506. The second one is to firstly coat a layer of phosphors 424 on the LED chips 102, 104 and the conductive electrodes 506, and secondly coat a layer of adhesive 422 thereon (two disposition steps). Thereafter, cure the layer of adhesive 422 and the layer of phosphors 424. The third one is to repeat the above two disposition steps until a required thickness is reached. Thereafter, a curing process is proceeded with. In comparison with the three methods, the uniformity of the light conversion coating 420 done by the third method might be better. Additionally, the disposition (coating) of the adhesive 422 or the phosphors 424 may be done by spraying.

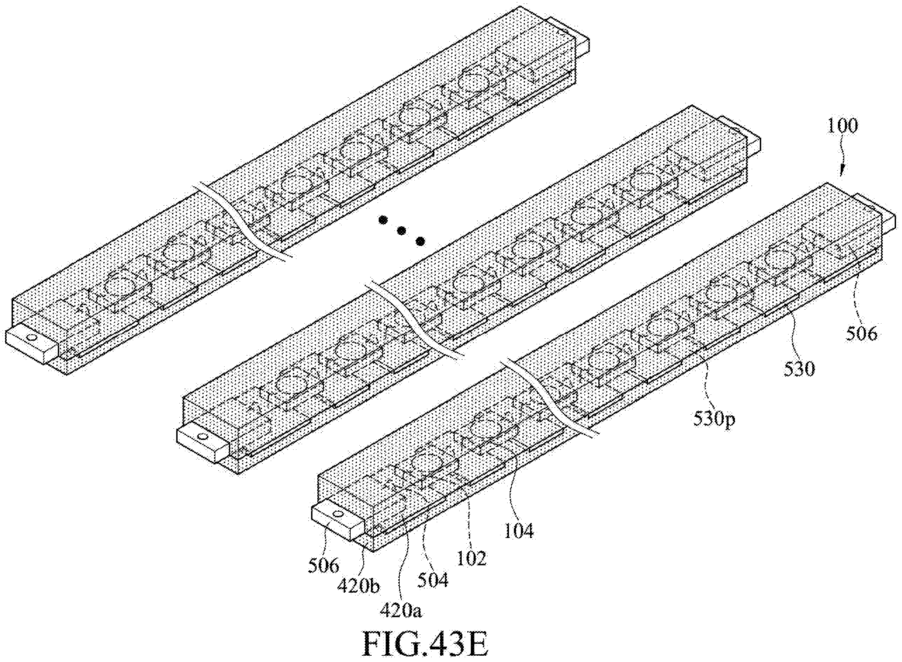

After S24, a cut process may be proceeded with, referring to FIG. 43E. Cut LED filaments 100 are manufactured as shown in FIG. 43E.

In accordance with the embodiment of FIG. 43A to 43E, the LED chips 102, 104 and the conductive electrodes 506 are electrically connected together through conductive foil 530 and conductive wire 540. The flexibility of the electrical connections is enhanced. Accordingly, when the LED filament 100 is bent, the electrical connections would not be easily broken.

Please refer to FIG. 44A and 44B which illustrate a perspective view of LED light bulb applying the LED filaments according to a first and a second embodiments. The LED light bulb 20a, 20b comprises a bulb shell 12, a bulb base 16 connected with the bulb shell 12, at least two conductive supports 51a, 51b disposed in the bulb shell 12, a driving circuit 518 electrically connected with both the conductive supports 51a, 51b and the bulb base 16, and a single LED filament 100 disposed in the bulb shell 12.

The conductive supports 51a, 51b are used for electrically connecting with the conductive electrodes 506 and for supporting the weight of the LED filament 100. The bulb base 16 is used to receive electrical power. The driving circuit 518 receives the power from the bulb base 16 and drives the LED filament 100 to emit light. Due that the LED filament 100 emits light like the way a point light source does, the LED light bulb 20a, 20b may emit omnidirectional light. In this embodiment, the driving circuit 518 is disposed inside the LED light bulb. However, in some embodiments, the driving circuit 518 may be disposed outside the LED bulb.

The definition of the omnidirectional light depends upon the area the bulb is used and varies over time. The definition of the omnidirectional light may be, but not limited to, the following example. Page 24 of Eligibility Criteria version 1.0 of US Energy Star Program Requirements for Lamps (Light Bulbs) defines omnidirectional lamp in base-up position requires that light emitted from the zone of 135 degree to 180 degree should be at least 5% of total flux (lm), and 90% of the measured intensity values may vary by no more than 25% from the average of all measured values in all planes (luminous intensity (cd) is measured within each vertical plane at a 5 degree vertical angle increment (maximum) from 0 degree to 135 degree). JEL 801 of Japan regulates the flux from the zone within 120 degrees along the light axis should be not less than 70% of total flux of the bulb.

In the embodiment of FIG. 44A, the LED light bulb 20a comprises two conductive supports 51a, 51b. In an embodiment, the LED light bulb may comprise more than two conductive supports 51a, 51b depending upon the design.

The bulb shell 12 may be shell having better light transmittance and thermal conductivity; for example, but not limited to, glass or plastic shell. Considering a requirement of low color temperature light bulb on the market, the interior of the bulb shell 12 may be appropriately doped with a golden yellow material or a surface inside the bulb shell 12 may be plated a golden yellow thin film for appropriately absorbing a trace of blue light emitted by a part of the LED chips 102, 104, so as to downgrade the color temperature performance of the LED bulb 20a, 20b. A vacuum pump may swap the air as the nitrogen gas or a mixture of nitrogen gas and helium gas in an appropriate proportion in the interior of the bulb shell 12, so as to improve the thermal conductivity of the gas inside the bulb shell 12 and also remove the water mist in the air. The air filled within the bulb shell 12 may be at least one selected from the group substantially consisting of helium (He), and hydrogen ($H_2$). The volume ratio of Hydrogen to the overall volume of the bulb shell 12 is from 5% to 50%. The air pressure inside the bulb shell may be 0.4 to 1.0 atm (atmosphere).

According to the embodiments of FIG. 44A and 44B, each of the LED light bulbs 20a, 20b comprises a stem 19 in the bulb shell 12 and a heat dissipating element (i.e. heat sink) 17 between the bulb shell 12 and the bulb base 16. In the embodiment, the bulb base 16 is indirectly connected with the bulb shell 12 via the heat dissipating element 17. Alternatively, the bulb base 16 can be directly connected with the bulb shell 12 without the heat dissipating element 17. The LED filament 100 is connected with the stem 19 through the conductive supports 51a, 51b. The stem 19 may be used to swap the air inside the bulb shell 12 with nitrogen gas or a mixture of nitrogen gas and helium gas. The stem 19 may further provide heat conduction effect from the LED filament 100 to outside of the bulb shell 12. The heat dissipating element 17 may be a hollow cylinder surrounding the opening of the bulb shell 12, and the interior of the heat dissipating element 17 may be equipped with the driving circuit 518. The exterior of the heat dissipating element 17 contacts outside gas for thermal conduction. The material of the heat dissipating element 17 may be at least one selected from a metal, a ceramic, and a plastic with a good thermal conductivity effect. The heat dissipating element 17 and the stem 19 may be integrally formed in one piece to obtain better thermal conductivity in comparison with the traditional LED light bulb whose thermal resistance is increased due that the screw of the bulb base is glued with the heat dissipating element.

Referring to FIG. 44A, the height of the heat dissipating element 17 is L1 and the height from the bottom of the heat dissipating element 17 to the top of the bulb shell 12 is L2. The ratio of L1 to L2 is from 1/30 to 1/3. The lower the ratio, the higher the cutoff angle of illumination of the light bulb. In other words, the lower ratio increases the higher light-emission angle and the light from the bulb is closer to omnidirectional light.

Please referring to FIG. 44B, the LED filament 100 is bent to form a portion of a contour and to form a wave shape having wave crests and wave troughs. In the embodiment, the outline of the LED filament 100 is a circle when being observed in a top view and the LED filament 100 has the wave shape when being observed in a side view. Alternatively, the outline of the LED filament 100 can be a wave shape or a petal shape when being observed in a top view and the LED filament 100 can have the wave shape or a line shape when being observed in a side view. In order to appropriately support the LED filament 100, the LED light bulb 20b further comprises a plurality of supporting arms 15 which are connected with and supports the LED filament 100. The supporting arms 15 may be connected with the wave crest and wave trough of the waved shaped LED filament 100. In this embodiment, the arc formed by the filament 100 is around 270 degrees. However, in other embodiment, the arc formed by the filament 100 may be approximately 360 degrees. Alternatively, one LED light bulb 20b may comprise two LED filaments 100 or more. For example, one LED light bulb 20b may comprise two LED filaments 100 and each of the LED filaments 100 is bent to form approximately 180 degrees arc (semicircle). Two semicircle LED filaments 100 are disposed together to form an approximately 360 circle. By the way of adjusting the arc formed by the LED filament 100, the LED filament 100 may provide with omnidirectional light. Further, the structure of one-piece filament simplifies the manufacturing and assembly procedures and reduces the overall cost.

In some embodiment, the supporting arm 15 and the stem 19 may be coated with high reflective materials, for example, a material with white color. Taking heat dissipating characteristics into consideration, the high reflective materials may be a material having good absorption for heat radiation like graphene. Specifically, the supporting arm 15 and the stem 19 may be coated with a thin film of graphene.

Please refer to FIG. 45A and FIG. 46A. FIG. 45A illustrates a perspective view of an LED light bulb according to a third embodiment of the present disclosure. FIG. 46A illustrates a cross-sectional view of an LED light bulb according to a fourth embodiment of the present disclosure. According to the third embodiment, the LED light bulb 20c comprises a bulb shell 12, a bulb base 16 connected with the bulb shell 12, two conductive supports 51a, 51b disposed in the bulb shell 12, a driving circuit 518 electrically connected with both the conductive supports 51a, 51b and the bulb base 16, a stem 19, supporting arms 15 and a single LED filament 100. The LED light bulb 20d of the fourth embodiment is similar to the third embodiment illustrated in FIG. 45A and comprises two LED filaments 100a, 100b arranged at the different vertical level in FIG. 46A. The LED filaments 100a, 100b are bent to form a contour from the top view of FIG. 46A.

The cross-sectional size of the LED filaments 100, 100a, 100b is small than that in the embodiments of FIG. 44A and 44B. The conductive electrodes 506 of the LED filaments 100, 100a, 100b are electrically connected with the conductive supports 51a, 51b to receive the electrical power from the driving circuit 518. The connection between the conductive supports 51a, 51b and the conductive electrodes 506 may be a mechanical pressed connection or soldering connection. The mechanical connection may be formed by firstly passing the conductive supports 51a, 51b through the through holes 506h (shown in FIG. 33 and secondly bending the free end of the conductive supports 51a, 51b to grip the conductive electrodes 506. The soldering connection may be done by a soldering process with a silver-based alloy, a silver solder, a tin solder.

Similar to the first and second embodiments shown in FIGs. 44A and 44B, each of the LED filaments 100, 100a, 100b shown in FIG.45A/46A is bent to form a contour from the top view of FIGs. 45A and 46A. In the embodiments of FIGs. 45A, 46A, each of the LED filaments 100, 100a, 100b is bent to form a wave shape from side view. The shape of the LED filament 100 is novel and makes the illumination more uniform. In comparison with a LED bulb having multiple LED filaments, single LED filament 100 has less connecting spots. In implementation, single LED filament 100 has only two connecting spots such that the probability of defect soldering or defect mechanical pressing is decreased.

The stem 19 has a stand 19a extending to the center of the bulb shell 12. The stand 19a supports the supporting arms 15. The first end of each of the supporting arms 15 is connected with the stand 19a while the second end of each of the supporting arms 15 is connected with the LED filament 100, 100a, 100b. Please refer to FIG. 45B which illustrates an enlarged cross-sectional view of the dashed-line circle of FIG. 45A. The second end of each of the supporting arms 15 has a clamping portion 15a which clamps the body of the LED filament 100, 100a, 100b. The clamping portion 15a may, but not limited to, clamp at either the wave crest or the wave trough. Alternatively, the clamping portion 15a may clamp at the portion between the wave crest and the wave trough. The shape of the clamping portion 15a may be tightly fitted with the outer shape of the cross-section of the LED filament 100, 100a, 100b. The dimension of the inner shape (through hole) of the clamping portion 15a may be a little bit smaller than the outer shape of the cross-section of the LED filament 100, 100a, 100b. During manufacturing process, the LED filament 100, 100a, 100b may be passed through the inner shape of the clamping portion 15a to form a tight fit. Alternatively, the clamping portion 15a may be formed by a bending process. Specifically, the LED filament 100, 100a, 100b may be placed on the second end of the supporting arm 15 and a clamping tooling is used to bend the second end into the clamping portion to clamp the LED filament 100, 100a, 100b.

The supporting arms 15 may be, but not limited to, made of carbon steel spring to provide with adequate rigidity and flexibility so that the shock to the LED light bulb caused by external vibrations is absorbed and the LED filament 100 is not easily to be deformed. Since the stand 19a extending to the center of the bulb shell 12 and the supporting arms 15 are connected to a portion of the stand 19a near the top thereof, the position of the LED filaments 100 is at the level close to the center of the bulb shell 12. Accordingly, the illumination characteristics of the LED light bulb 20c are close to that of the traditional light bulb including illumination brightness. The illumination uniformity of LED light bulb 20c is better. In the embodiment, at least a half of the LED filaments 100 is around a center axle of the LED light bulb 20c. The center axle is coaxial with the axle of the stand 19a.

In the embodiment, the first end of the supporting arm 15 is connected with the stand 19a of the stem 19. The clamping portion of the second end of the supporting arm 15 is connected with the outer insulation surface of the LED filaments 100, 100a, 100b such that the supporting arms 15 are not used as connections for electrical power transmission. In an embodiment where the stem 19 is made of glass, the stem 19 would not be cracked or exploded because of the thermal expansion of the supporting arms 15 of the LED light bulb 20c. Additionally, there may be no stand in an LED light bulb. The supporting arm 15 may be fixed to the stem or the bulb shell directly to eliminate the negative effect to illumination caused by the stand.

The supporting arm 15 is thus non-conductive to avoid a risk that the glass stem 19 may crack due to the thermal expansion and contraction of the metal filament in the supporting arm 15 under the circumstances that the supporting arm 15 is conductive and generates heat when current passes through the supporting arm 15.

In different embodiments, the second end of the supporting arm 15 may be directly inserted inside the LED filament 100 and become an auxiliary piece in the LED filament 100, which can enhance the mechanical strength of the LED filament 100. Relative embodiments are described later.

Since the inner shape (shape of through hole) of the clamping portion 15a fits the outer shape of the cross-section of the LED filament 100, the orientation of the cross-section of the LED filament 100, if necessary, may be properly adjusted. As shown in FIG. 45B, the top layer 420a is fixed to face around ten o'clock direction such that illumination surfaces of the LED filament 100 are facing substantially the same direction.

Please refer to FIG. 46B which illustrates the circuit board of the driving circuit of the LED light bulb from the top view of FIG. 46A according to the fourth embodiment of the present disclosure. The driving circuit 518 comprises a circuit board 518a which is fixed to the bulb base 16. The conductive supports 51a, 51b are electrically connected with the circuit board 518a and passes through the stand 19a to be electrically connected with the conductive electrodes 506 of the LED filament 100a, 100b. The circuit board 518a comprises notches 518b. The notches 518b are of hook shape. The size of the tip of the notches 518b is slightly smaller than that of the cross-section of the conductive supports 51a, 51b for fixing the conductive supports 51a, 51b. The tip of the notches 518b is beneficial to the soldering between the circuit board 518a and the conductive supports 51a, 51b.

In the embodiments of FIGs. 45A and 46A, the length of the conductive supports 51a, 51b is better to meet the below equation to prevent two conductive supports 51a, 51b from short circuit or to prevent the conductive supports 51a, 51b from unable to reach the circuit board 518a.

$$L=A+\sqrt{(\llbracket(B-3.2)\rrbracket^2+H^2\,)}$$

Wherein, referring to FIG. 46A, 3.2 is the electricity safety spacing; L is the calculated length of the conductive supports 51a, 51b and its unit is mini-meter; A is the sum of the thickness of the circuit board 518a and the height of the portion of the conductive supports 51a, 51b exposed from the surface of the circuit board 518a; B is the horizontal distance between the two conductive supports 51a, 51b; and H is the height from the circuit board 518a to the point the conductive supports 51a, 51b enters the stem 19. The actual length of the conductive supports 51a, 51b may be, but not limited to, between 0.5L and 2L, and more particularly between 0.75L and 1.5L.

In the embodiment of FIG. 46A, the LED light bulb 20d has two LED filaments 100a, 100b disposed on different vertical levels. The conductive supports 51a, 51b for the upper LED filaments 100a has a length Z=L + Y. Y is the distance between the upper LED filament 100a and the lower LED filament 100b.

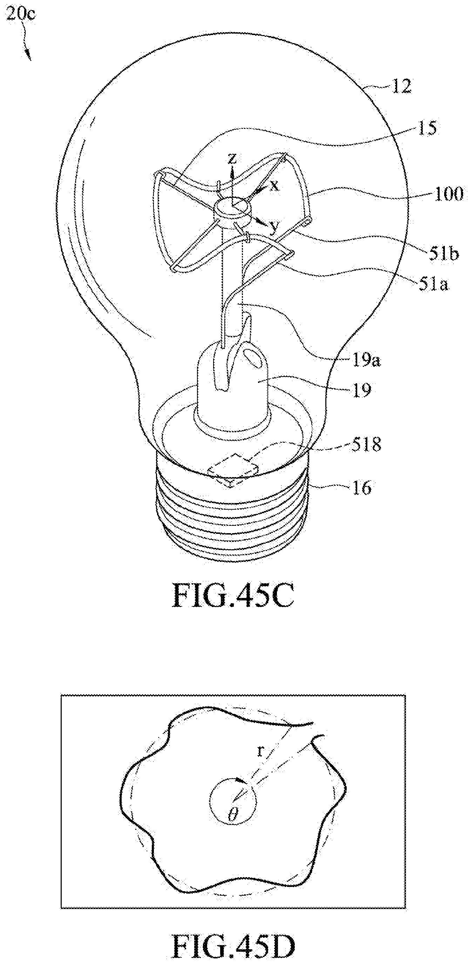

Please refer to FIG. 45C. FIG. 45C is a perspective view of an LED light bulb according to an embodiment of the present invention. The LED light bulb 20c shown in FIG. 45C is similar to that shown in FIG. 45A but is added with a xyz coordinates. The LED light bulb 20c shown in FIG. 45C can be referred to the aforementioned description of the LED light bulb 20c shown in FIG. 45A, and it is thus unnecessary to go into details repeatedly. The LED filament 100 shown in FIG. 45C is curved to form a circular shape in a top view while the LED filament is curved to form a wave shape in a side view. The wave shaped structure is not only novel in appearance but also guarantees that the LED filament 100 illuminates evenly. In the meantime, the single LED filament 100, comparing to multiple LED filaments, requires less joint points (e.g., pressing points, fusing points, or welding points) for being connected to the conductive supports 51a, 51b. In practice, the single LED filament 100 (as shown in FIG. 45C) requires only two joint points respectively formed on the two conductive electrodes, which effectively lowers the risk of fault welding and simplifies the process of connection comparing to the mechanically connection in the tightly pressing manner.

Please refer to FIG. 45D. FIG. 45D is a projection of a top view of an LED filament of the LED light bulb 20c of FIG. 45C. As shown in FIG. 45D, in an embodiment, the LED filament may be curved to form a wave shape observed in a top view to surround the center of the light bulb or the stem. In different embodiments, the LED filament observed in the top view can form a quasi-circle or a quasi U shape.

In an embodiment, the LED light bulb 20c shown in FIG. 45C may be a light bulb with an A size. The two joint points for electrical connection between the two conductive supports 51a, 51b and the LED filament 100 is spaced by a distance, which is within 3 cm and is preferably within 2 cm. The LED filament 100 surrounds with the wave shape; therefore, the LED filament 100 may generate an effect of an omnidirectional light, and the two joint points may be close to each other such that the conductive supports 51a, 51b are substantially below the LED filament 100. Visually, the conductive supports 51a, 51b keeps a low profile and is integrated with the LED filament 100 to show an elegance curvature. While being observed from a side of the LED filament 100 in the LED light bulb 20c, a distance between the highest point and the lowest point of the wave of the LED filament 100 is from 2.2 cm to 3.8 cm and is preferably from 2.2 cm to 2.8 cm. Thus it could be ensured that there would be a space for heat dissipation above the LED filament 100.

As shown in FIG. 45C, the shape of the LED filament 100 may satisfy a curve equation. The position of the LED filament 100 in space relates to the Cartesian coordinates (i.e., an xyz coordinates) shown in FIG. 1. An x-y plane of the xyz coordinates is a plane passing through a top of the stem 19 (i.e., a top of the stand 19a in the embodiment in which the stand 19a is deemed as a part of the stem 19). An origin of the xyz coordinates is at the top of the stem 19 (the origin may be at a center of a sphere body of a bulb shell of a light bulb without any stems). The x-y plane is perpendicular to a height direction of the LED light bulb 20c.

The two conductive electrodes (i.e., the welding points, the joint points, the contacting points, or the fusing points) are symmetrically disposed at two sides of a y-axis of the xyz coordinates. A z-axis of the xyz coordinates is coaxial with stem 19 (or is coaxial with a central axis passing through a horizontal plane of the LED light bulb 20c). The shape of the LED filament 100 varies along an x-direction, a y-direction, and a z-direction according to t, and t is a variable between 0 and 1. A position of points of the LED filament 100 in the xyz coordinates is defined as X, Y, and Z and satisfies the curve equation. Herein, the term "points of the LED filament" means "most of points of the LED filament", or "more than 60% of points of the LED filament." The curve equation is:

$$X = m1 * \cos(t * 360),$$

$$Y = m2 * \sin(t * 360),$$

$$Z = n * \cos(t * 360 * k),$$

The LED filament 100 varies along the x-direction, the y-direction, and the z-direction according to t. When X=0, |Y|max=m2 (a max value of |Y| is m2), and |Z|max=n (a max value of |Z| is n). When Y=0, |X|max=m1 (a max value of |X| is m1), and |Z|max=n (the max value of |Z| is n). When Z=0, |X|max=m1 (the max value of |X| is m1), and |Y|max=m2 (the max value of |Y| is m2). m1 is a length (projection length) in the x-direction, and 24≤m1≤27 (mm). m2 is a length (projection length) in the y-direction, and 24≤m2≤27 (mm). Based upon the above configuration, the LED filament 100 in the bulb shell 12 may provide good luminous flux. n is a height of the highest point of the LED filament 100 from the x-y plane in the z-direction, and 0 < n≤14 (mm). Based upon the above condition, wires in turning points of the LED filament 100 may hard to break. k is a number of the highest point(s). The more the supporting arms (or supporting bars), the hard the manufacture is; therefore, k is configured as: 2≤k≤8. A curve line drawn by the above curve equation may be deemed as a reference for the LED filament 100 being distributed in space. According to conditions of different arts and equipment, the configuration of the LED filament 100 in practice may have about 0 to 25% in spatial difference different from the reference based upon the curve equation. Certain region(s) on the filament with supporting point(s) may be relatively highest point(s) and lowest point(s). The spatial difference of the certain region(s) may be less, e.g., 0 to 20%. In an embodiment, r is the radius of a cross section of the bulb shell on the horizontal plane. Cross sections of the bulb shell on the horizontal plane from the bottom to the top of the bulb shell along the height direction may have varied radii, and the radius r is the one with the largest value. In such case, the values of m1, m2, and n may be set as: 0.8*r≤m1≤0.9*r; 0.8*r≤m2≤0.9*r; 0<n≤0.47*r. Additionally, p is the radius of an interface of the bulb base utilized for being connected to the bulb shell, G is the length of the LED filament, and, in such case, the values of G may be set as: 1.2*p≤G≤5.6*r. Based upon the above setting, the LED filament may not only achieve the aforementioned effect, but may also need the least length and the least number of the LED chips. As a result, the cost of materials for the manufacture of the LED light bulb may reduce, and the temperature of the LED light bulb during operation can be suppressed.

In another embodiment, as shown in FIG. 45D, a projection of the LED filament 100 on the x-y plane may be deemed as a quasi-circle. r is a distance from a center point defined by the projection to the projection itself. r is deemed as a radius of the projection the LED filament 100. θ is an angle of an arc formed by the projection. θ of a projection point of one of the two ends of the LED filament 100 is 0. The arc angle θ is from 180° to 360°. In certain embodiments, the LED filament 100 may be adjusted via the height in the z-axis to form an arc of which θ is greater than 360°. According to different arts and equipment, the radius r of the projection of the LED filament 100 may have variations with about ±20% difference. A relation between the LED filament 100 varying along the z-axis and θ satisfies a function: $Z=n*cos(k\theta+\pi)$, wherein n is a height of the highest point from the x-y plane in the z-direction, and $0<n\leq14$ (mm); k is a number of the highest point(s), and $2\leq k\leq8$. According to different arts and equipments, these parameters may have variations with about ±20% difference.

Additionally, the inner shape (the hole shape) of the clamping portion 15a fits the outer shape of the cross section of the LED filament 100; therefore, based upon a proper design, the cross section may be oriented to face towards a predetermined orientation. For example, as shown in FIG. 45B, the top layer 420a of the LED filament 100 is oriented to face towards ten o'clock. A lighting face of the whole LED filament 100 may be oriented to face towards the same orientation substantially to ensure that the lighting face of the LED filament 100 is visually identical. The LED filament 100 comprises a main lighting face and a subordinate lighting face corresponding to the LED chips. If the LED chips in the LED filament 100 are wire bonded and are aligned in line, a face of the top layer 420a away from the base layer 420b is the main lighting face, and a face of the base layer 420b away from the top layer 420a is the subordinate lighting face. The main lighting face and the subordinate lighting face are opposite to each other. When the LED filament 100 emits light, the main lighting face is the face through which the largest amount of light rays passes, and the subordinate lighting face is the face through which the second largest amount of light rays passes. In the embodiment, there is, but is not limited to, a conductive foil 530 formed between the top layer 420a and the base layer 420b, which is utilized for electrical connection between the LED chips. In the embodiment, the LED filament 100 wriggles with twists and turns while the main lighting face is always towards outside. That is to say, any portion of the main lighting face is towards the bulb shell 12 or the bulb base 16 at any angle, and the subordinate lighting face is always towards the stem 19 or towards the top of the stem 19 (the subordinate lighting face is always towards inside). Whereby, the LED light bulb 20c as a whole may generate an effect of an omnidirectional light close to a 360 degrees illumination.

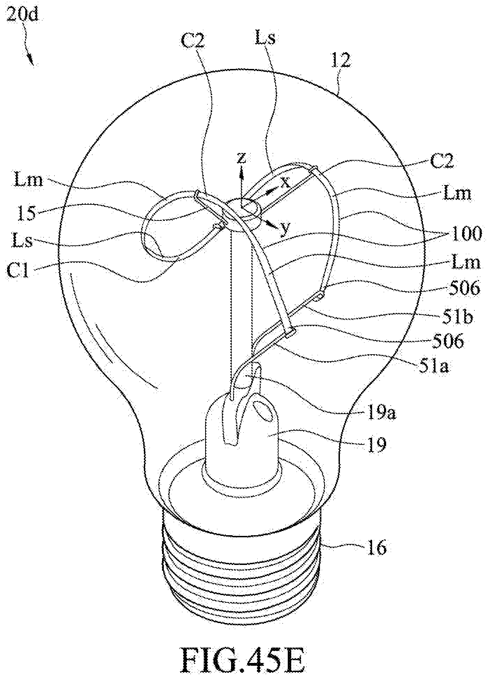

Please refer to 45E. FIG. 45E is a perspective view of an LED light bulb according to an embodiment of the present invention. The LED light bulb 20d shown in FIG. 45E is analogous to the LED light bulb 20c shown in FIG. 45A and 45C. As shown in FIG. 45E, the LED light bulb 20d comprises a bulb shell 12, a bulb base 16 connected to the bulb shell 12, two conductive supports 51a, 51b disposed in the bulb shell 12, supporting arms 15, a stem 19, and one single LED filament 100d. The stem 19 comprises a stem bottom and a stem top opposite to each other. The stem bottom is connected to the bulb base 16. The stem top extends to inside of the blub shell 12 (to the center of the bulb shell 12). For example, the stem top may be substantially located at a center of the inside of the bulb shell 12. In the embodiment, the stem 19 comprises the stand 19a. Herein the stand 19a is deemed as a part of the whole stem 19 and thus the top of the stem 19 is the same as the top of the stand 19a. The two conductive supports 51a, 51b are connected to the stem 19. The LED filament 100d comprises a filament body and two conductive electrodes 506. The two conductive electrodes 506 are at two opposite ends of the filament body. The filament body is the part of the LED filament 100d without the conductive electrodes 506. The two conductive electrodes 506 are respectively connected to the two conductive supports 51a, 51b. The filament body is around the stem 19. An end of the supporting arm 15 is connected to the stem 19 and another end of the supporting arm 15 is connected to the filament body.

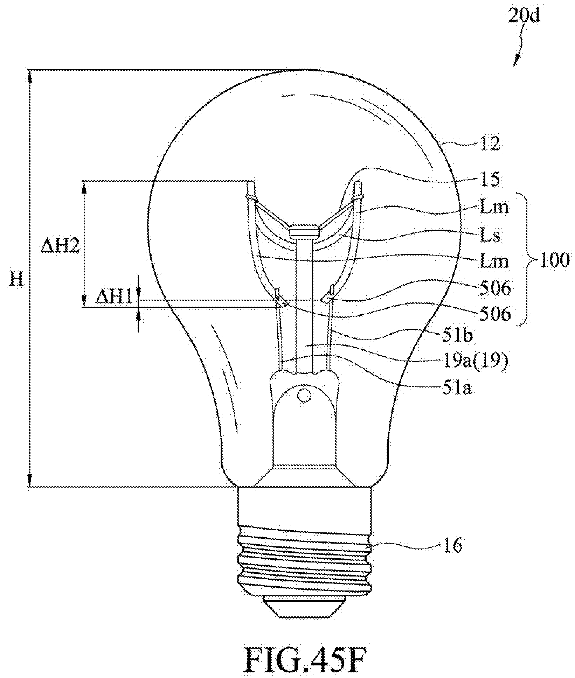

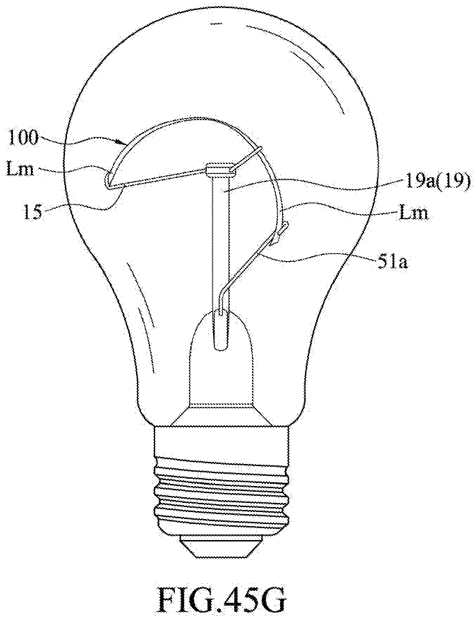

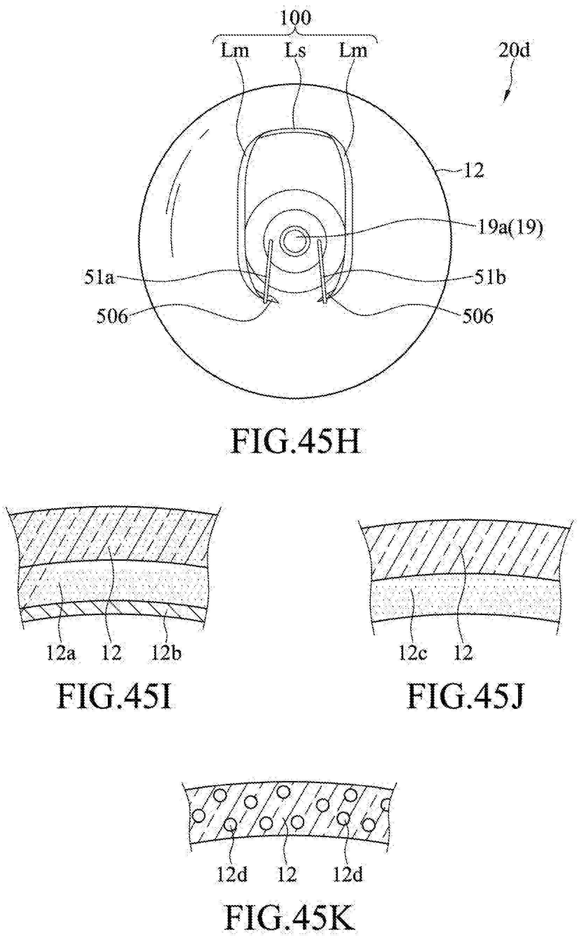

Please refer to FIG. 45E to FIG. 45H. FIG. 45F is a front view of an LED light bulb of FIG. 45E. FIG. 45G is a side view of the LED light bulb of FIG. 45E. FIG. 45H is a top view of the LED light bulb of FIG. 45E. In a height direction of the LED light bulb 20d (i.e., the z-direction), H is a distance from a bottom of the bulb shell 12 to a top of the bulb shell 12, and a first height difference ΔH1 is defined between the two conductive electrodes 506. The first height difference ΔH1 is from 0 to 1/10H. In other words, the minimum of the height difference between the two conductive electrodes 506 may be 0 and, in such case, the two conductive electrodes 506 are at the same level. The maximum of the height difference between the two conductive electrodes 506 may be 1/10H. Preferably, the first height difference ΔH1 may be from 0 to 1/20H. In an embodiment, the first height difference ΔH1 may be from 0 mm to 5 mm. In addition, the first height difference ΔH1 may be from 1 mm to 5 mm. Further, the first height difference ΔH1 may be from 1 mm to 2 mm.

In an embodiment, the minimum straight-line distance between the two conductive electrodes 506 is less than 3 cm. In the height direction, the two conductive electrodes 506 are located between 1/2H and 3/4H from the bottom of the bulb shell 12.

As shown in FIG. 45F, the filament body is curved and rises and falls to form a highest point and a lowest point. A second height difference ΔH2 is defined between the highest point and the lowest point. In the embodiment, the lowest point of the filament body is an end adjacent to the conductive electrode 506. In another embodiment, if the filament body has a downward curving portion (which is curved towards the bulb base 16) lower than the conductive electrodes 506 in the z-direction, the lowest point is on the downward curving portion of the filament body. The first height difference ΔH1 is less than the second height difference ΔH2. The second height difference ΔH2 is from 2/10H to 4/10H. In an embodiment, the second height difference ΔH2 is from 2.2 cm to 3.8 cm, and, preferably, the second height difference ΔH2 is from 2.2 cm to 2.8 cm.

In an embodiment, all of the highest point(s) and the lowest point(s) are between 1/3H to 4/5H from the bottom of the bulb shell in the height direction (i.e., the z-direction). Additionally, the filament body between the two conductive electrodes 506 is a lighting segment. More than 50% (preferably 95%) of a height of the lighting segment is higher than the two conductive electrodes 506 in the height direction. Preferably, more than 30% of the height of the lighting segment is higher than the stem top of the stem 19 (i.e., the top of the stand 19a) in the height direction.

In an embodiment, when the LED light bulb 20d is projected to a side projection plane parallel with the height direction of the LED light bulb 20d (the z-direction), a filament side projection of the filament body on the side projection plane (which may be referred to FIG. 45F and FIG. 45G) comprises a highest point and a lowest point. A height difference is defined between the highest point and the lowest point of the filament side projection in the height direction. The height difference is from 1/8 to 3/8 of the height H of the bulb shell 12.

In an embodiment, when the LED light bulb 20d is projected to a horizontal projection plane perpendicular to the height direction of the LED light bulb 20d (which may be referred to FIG. 45H), a filament horizontal projection of the filament body on the horizontal projection plane is of a quasi-circle or a quasi U shape. As shown in FIG. 45H, the filament horizontal projection of the filament body on the horizontal projection plane is of a quasi U shape. In addition, a shortest distance between the two ends of the filament horizontal projection (two projection points of the two conductive electrodes 506 on the horizontal projection plane) is from 0 cm to 3 cm.

In an embodiment, the filament body is around the stem 19 by an angle greater than 270 degrees. For example, as shown in FIG. 45D and FIG. 45H, The arc angle θ of the projection of the filament body on the x-y plane is greater than 270 degrees. Consequently, the effect of illumination is better. In different embodiments, as shown in FIG. 45D, r is the distance from the center point defined by the filament horizontal projection to the projection itself. θ is an arc angle formed by the filament horizontal projection, and θ is greater than or equal to 30 degrees and is less than or equal to 360 degrees. In an embodiment, a number of the LED filament 100 is one, and, in such case, when the LED light bulb 20d is projected to a projection plane at a particular angle (which may be referred to a side view of the LED light bulb 20d), a projection of the two conductive supports 51a, 51b overlaps (only the conductive support 51a is shown in FIG. 45G while the conductive supports 51a, 51b overlap with each other), a projection of the filament body crosses over two sides of a projection of the stem 19, and the projection of the two conductive supports 51a, 51b is at one of the two sides of the projection of the stem 19. Because the projections of the conductive supports 51a, 51b are at the same side of the projection of the stem 19, i.e., there is no conductive support at the other side of the projection of the stem 19, the light emitted from the LED filament 100 is hard to be blocked, and it is easier to align or correct the posture of the LED light bulb 20d.

In an embodiment, the filament body comprises multiple LED chips which are wire bonded and are aligned in line, and, as aforementioned, the filament body is defined with the main lighting face and the subordinate lighting face opposite to each other in accordance with the LED chips. In the embodiment, as shown in FIG. 45E to FIG. 45H, the filament body comprises a main lighting face Lm and a subordinate lighting face Ls. Any portion of the main lighting face Lm is towards the bulb shell 12 or the bulb base 16 at any angle, and any portion of the subordinate lighting face Ls is towards the stem 19 or towards the top of the stem 19, i.e., the subordinate lighting face Ls is towards inside of the LED light bulb 20d or towards the center of the bulb shell 12. In other words, when a user observes the LED light bulb 20d from outside, the user would see the main lighting face Lm of the LED filament 100d at any angle. Based upon the configuration, the effect of illumination is better.

In the embodiment, as shown in FIG. 45E to FIG. 45H, the shape of the LED filament 100d satisfies the aforementioned curve equation: X=m1*cos(t*360), Y=m2*sin(t*360), and Z=n*cos(t*360*k). The curve equation can be referred to the above description, and it is unnecessary to go into details.

In addition, as shown in FIG. 45E, the LED filament 100d may be defined as the following description according to its appearance. The filament body of the LED filament 100 comprises at least one first curving segment C1 and at least two second curving segments C2. The first curving segment C1 is between the two second curving segments C2. The two conductive electrodes 506 are respectively at an end of each of the two second curving segments C2 away from the first curving segment C1. In the embodiment, multiple supporting arms 15 are respectively connected to bended portions of the first curving segment C1 and the second curving segment C2 to well support different curving segments of the filament body. The first curving segment C1 curves towards a first direction and the second curving segments C2 curve towards a second direction. The first curving segment C1 and the two second curving segments C2 form a wave shaped annular structure.

In the embodiment, as shown in FIG. 45E, the first direction is towards the bulb base 16, and the second direction is away from the bulb base 16. In other words, referred to FIG. 45E, the first curving segment C1 curves downwardly (i.e., the bended portion of the first curving segment C1 is closer to the bulb base 16), and the second curving segments C2 curve upwardly (i.e., the bended portion of the second curving segment C2 is more away from the bulb base 16). In different embodiments, the first direction is away from the bulb base 16, and the second direction is towards the bulb base 16. In other words, the first curving segment C1 curves upwardly and the second curving segments C2 curve downwardly.

In the embodiment, when the LED light bulb 20d is respectively projected to a first side projection plane and a second side projection plane perpendicular to each other and both parallel with the height direction (the z-direction) of the LED light bulb 20d, a projection of the first curving segment C1 and the two second curving segments C2 on the first side projection plane is of a reversed U shape, and a projection of the first curving segment C1 and the two second curving segments C2 on the second side projection plane is of a U shape or an M shape. The first side projection plane may be referred to the side view shown in FIG. 45G, and the filament body shown in FIG. 45G is of a reversed U shape. The second side projection plane may be referred to the front view shown in FIG. 45F, and the filament body shown in FIG. 45F is of an M shape. If a height of a lowest point of the bended portion of the first curving segment C1 is close to that of the conductive electrodes 506, the filament body shown in FIG. 45F is of a U shape. In the embodiment, as shown in FIG. 45H, the projection of the first curving segment C1 and the second curving segments C2 on the horizontal projection plane of the LED light bulb 20d is of a U shape or a reversed U shape (which is a reversed U shape in FIG. 45H according the direction of observation). The horizontal projection plane is perpendicular to the height direction of LED light bulb 20d (the z-direction) and is parallel with the x-y plane.

Please refer to FIG. 45I to FIG. 45K. FIG. 45I is a partially enlarged, cross-sectional view of a bulb shell of an LED light bulb according to a first embodiment of the present invention. FIG. 45J is a partially enlarged, cross-sectional view of a bulb shell of an LED light bulb according to a second embodiment of the present invention. FIG. 45K is a partially enlarged, cross-sectional view of a bulb shell of an LED light bulb according to a third embodiment of the present invention. The bulb shell 12 comprises an adhesive layer 12a and a diffusing film 12b. The adhesive layer 12a is disposed between the bulb shell 12 and the diffusing film 12b. The adhesive layer 12a may be utilized for enhancing the solidity between the diffusing film 12b and the bulb shell 12. The diffusing film 12b may be utilized for diffusing light rays passing through the bulb shell 12 such that the LED light bulb 20c, 20d may create a more even illumination effect. In addition, the diffusing film 12b may also attach to the bulb shell 12 directly without the adhesive layer 12a. The diffusing film 12b may be attached to an outside or an inside of the bulb shell 12. In other embodiments, the diffusing film 12b may be replaced by a color toning film. The color toning film is capable of adjusting the color temperature of light emitted from the LED light bulb 20c, 20d. Alternatively, the diffusing film 12b may also have the capability of adjusting the color temperature. In such case, for example, the diffusing film 12b may be added with light conversion substances. The light conversion substances may be wavelength conversion particles.

As shown in FIG. 45J, in an embodiment, the bulb shell 12 may comprise an adhesive film 12c to improve the safety of the bulb shell. The adhesive film 12c may be attached to an outside or an inside of the bulb shell 12. In the embodiment, the adhesive film 12c is located at the inside of the bulb shell 12. The material of the adhesive film 12c may be calcium carbonate or strontium phosphate. The thickness of the adhesive film 12c relates to the weight of the LED light bulb 20c, 20d. If the LED light bulb 20c, 20d is provided with a heat dissipator (e.g., heat dissipating fins between the bulb shell 12 and the bulb base 16) and the heat dissipator has a weight over 100 grams (the heat dissipator includes 70% of heat conductive glue of 0.7 W/m*K to 0.9 W/m*K), the thickness of the adhesive film 12c may be between 200 $\mu$m and 300 $\mu$m. When the heat dissipator has no heat conductive glue and has a weight below 80 grams, the thickness of the adhesive film 12c may be from 40 $\mu$m to 90 $\mu$m, which is sufficient to prevent explosion. Considering the explosion proof of the Light bulb, a lower bound of the thickness relates to the weight of the light bulb; however, an upper bound of the thickness greater than 300 $\mu$m may result in a poor transmittance of light and an increased cost of material. The material of the adhesive film 12c may be a combination of calcium carbonate and strontium phosphate. During the manufacturing process of the adhesive film 12c, organic solvent may be added and mixed. When the bulb shell 12 is broken, broken pieces of the bulb shell 12 can be connected by the adhesive film 12c to avoid breaches so as to prevent users from electric shock due to accidently contacting conductive components inside the broken light bulb.

As shown in FIG. 45K, in an embodiment, the bulb shell 12 may comprise light conversion substances 12d in order to changing the color temperature of light emitted from the LED light bulb 20c, 20d. The bulb shell 12 is capable of adjusting the color temperature of light emitted from the LED light bulb 20c, 20d by the light conversion substances 12d. The light conversion substances 12d are mixed with the bulb shell 12. In other words, the light conversion substances 12d are added into an original material of the bulb shell 12 during the manufacturing process of the bulb shell 12.

In different embodiments, the color temperature of light emitted from the LED light bulb 20c, 20d may be adjusted by phosphor powders in a phosphor powder glue/film of the LED light filament 100, 100d around the LED chips. In addition, the bulb shell 12, the stem 19, or the stand 19a could also be utilized for adjusting the color temperature. For example, the light conversion substances 12d may be added in a fritting process while the bulb shell 12 is made by glass to form the blub shell 12 with the light conversion substances 12d, as shown in FIG. 45J. Alternatively, the color toning film with the light conversion substances can be applied to the inside or the outside of the transparent glass. The stem 19/stand 19a may also be mixed with the light conversion substances 12d.

According to the color temperature, the LED light bulb may be divided into two types, which are for decoration and for illumination. While the LED light bulb is mainly for decoration, the color temperature may be 1700K to 2700K, and the general color rendering index (Ra) may be 70 to 100 and preferably be 90 to 100. While the LED light bulb is mainly for illumination, the color temperature may be 2500K to 3500K, the luminaire efficiency may be 80 lumens/watt to 100 lumens/watt, and the general color rendering index (Ra) may be 60 to 100 and preferably be 80 to 100. The light conversion substance (e.g., the light conversion substances 12d shown in FIG. 45J) may be, for example, phosphor powders or dyes (e.g., nanoparticles of silver compound, gold, titanium, silver enclosed by gold, or gold enclosed by silver).

Additionally, a diffusing film (e.g., the diffusing film 12b shown in FIG. 45I or a diffusing coating) may be applied to the outside or the inside of the bulb shell 12. Alternatively, the diffusing film may be applied to the stem 19 or the stand 19a; therefore, the diffusion of light rays may be increased. A main material of the diffusing film may be any one of, a combination of any two of, or a combination of any three of calcium carbonate, halogen calcium phosphate, and aluminum oxide. The diffusing coating mainly formed by calcium carbonate and adequate solution may have a better effect of diffusion and transmittance (the transmittance may be up to 90%). While the diffusing film 12b is applied to the outer surface of the bulb shell 12, the friction between the diffusing coating and the bulb base 16 (alternatively the heat dissipator or plastic lamp holder) below the bulb shell 12 is increased, and the issue that the bulb shell 12 may be loose is significantly resolved.

In different embodiments, the composition of the diffusing coating comprises calcium carbonate, strontium phosphate (e.g., white powders of CMS-5000), thickener, and ceramic activated carbon. (e.g., colorless liquid of ceramic activated carbon of SW-C) during compounding, Specifically, while the diffusing coating is mainly made by calcium carbonate compounded with thickener, ceramic activated carbon, and deionized water and is applied to an inner surface or an outer surface of the bulb shell, the thickness of the coating is between 20

μm and 300 μm and preferably is between 20 μm and 30 μm. The diffusing film formed by the above materials may have transmittance about 90%. In general, the transmittance of the diffusing film may range from 85% to 96%. In addition, the diffusing film not only achieves the effect of light diffusing, but also achieves the effect of electric insulation. While the bulb shell is provided with the diffusing film, the risk of electric shock to users in the case of the glass shell being broken is lowered. The diffusing film diffuses light rays while the light source emits light, such that light rays from the light source passing through the diffusing film may be distributed circumferentially to avoid dark spaces and to bring the comfort of illumination. Additionally, different effects may be achieved while the diffusing coating is made by different materials or has different thickness.

In another embodiment, the diffusing coating is mainly made by calcium carbonate and compounded with a few of reflecting material (e.g., strontium phosphate or barium sulfate), thickener, ceramic activated carbon, and deionized water. The compounded diffusing coating is applied to the bulb shell. The mean thickness of the diffusing coating may be between 20 μm and 30 μm. The diffusing file is to make light diffused. In terms of micro observation, the phenomenon of diffusion is the refection of light rays being reflected by particles. The size of particles of reflecting materials such as strontium phosphate or barium sulfate is much greater than that of the calcium carbonate. Thus the diffusing coating added with a few of reflecting material is significantly beneficial of increasing the effect of diffusion.

Nevertheless, in other embodiments, the diffusing coating can be mainly made by halogen calcium phosphate or aluminum oxide. The size of particles of calcium carbonate is substantially between 2 μm and 4 μm. The size of particles of halogen calcium phosphate and aluminum oxide are substantially respectively between 4 μm and 6 μm and between 1 μm and 2 μm. For example, the mean thickness of the diffusing coating mainly made by calcium carbonate is substantially between 20 μm and 30 μm while the transmittance is required to be between 85% and 92%. Under the same requirement of the transmittance (between 85% and 92%), the mean thickness of the diffusing coating mainly made by halogen calcium phosphate is substantially between 25 μm and 35 μm, and the mean thickness of the diffusing coating mainly made by aluminum oxide is substantially between 10 μm and 15 μm. While the transmittance is required to be greater, e.g., greater than 92%, the diffusing coating mainly made by calcium carbonate, halogen calcium phosphate, or aluminum oxide is required to be thinner.

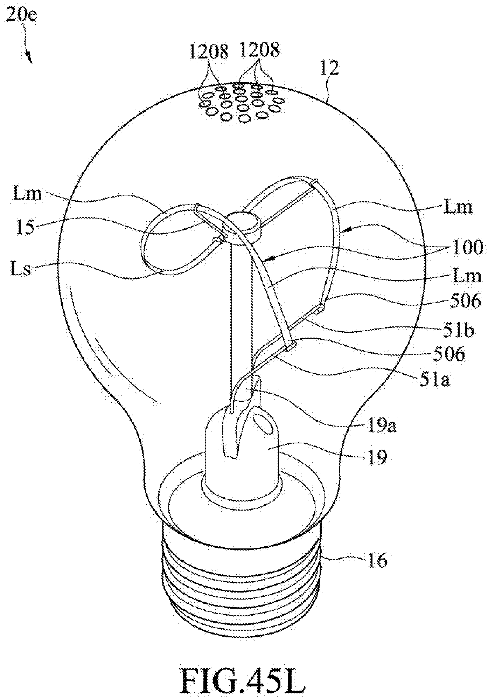

Please refer to FIG. 45L. FIG. 45L is a perspective view of an LED light bulb according to another embodiment of the present invention. The difference between the LED light bulb 20e shown in FIG. 45L and the LED light bulb 20d shown in FIG. 45E is that the bulb shell 12 of the LED light bulb 20e shown in FIG. 45L further comprises a plurality of ventilation hole 1208. The ventilation holes 1208 penetrate through the bulb shell 12. The ventilation holes 1208 are distributed on the top of the bulb shell 12 in the height direction and are corresponding to the position of the LED filament 100d to allow the heat of the LED filament 100d generated during operation to be dissipated by air flow through the ventilation holes 1208. In different embodiments, the bulb shell 12 may further comprise a ventilation hole disposed on the bottom of the bulb shell 12.

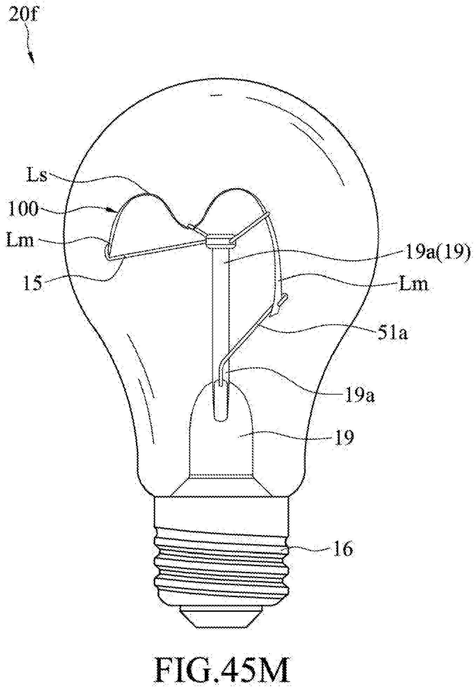

Please refer to FIG. 45M. FIG. 45M is a side view of an LED light bulb according to yet another embodiment of the present invention. The difference between the LED light bulb 20f shown in FIG. 45M and the LED light bulb 20d shown in FIG. 45E is that the shape of the LED filament 100 is different from that of the LED filament 100 shown in FIG.45E. Nevertheless, the variations of the shapes of the LED filaments 100 of FIG.45E/45M satisfy the aforementioned curve equation. In the embodiment, the LED filament 100 of FIG.45M has more bending portions than the LED filament 100 of FIG.45E has. In other embodiments, the shape of the LED filament of the LED light bulb may be varied and is not limited to the embodiments shown in the drawings if the shape of the LED filament satisfies the curve equation.

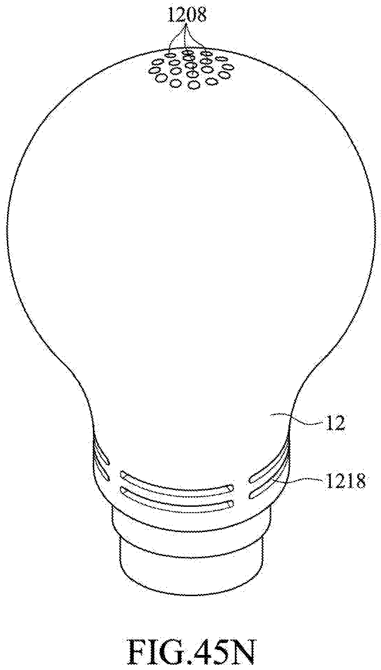

Please refer to FIG. 45N. FIG. 45N is a perspective view of a bulb shell of an LED light bulb according to an embodiment of the present invention. In the embodiment, the bulb shell 12 comprises two sets of ventilation holes 1208, 1218. The ventilation holes 1208 are disposed on the top of the bulb shell 12 in the height direction of the LED light bulb. The ventilation holes 1218 are disposed on the bottom of the bulb shell 12 in the height direction of the LED light bulb. In an embodiment, an area of an opening of the ventilation hole 1208 on the top of the bulb shell 12 is between 100 mm$^2$ and 500 mm$^2$ and is preferably between 150 mm$^2$ and 450 mm$^2$. An area of an opening of the ventilation hole 1218 on the bottom of the bulb shell 12 is between 200 mm$^2$ and 1200 mm$^2$ and is preferably between 450 mm$^2$ and 1000 mm$^2$. The two sets of ventilation holes 1208, 1218 are benefit to the convection of air.

**Claims**

1. An LED light bulb, comprising:

   a bulb shell (12);
   a bulb base (16) connected to the bulb shell;
   a stem (19) disposed inside the bulb shell;
   at least two conductive supports (51a,51b) connected to the stem;
   an LED filament (100) comprising a plurality of LED chips (102,104) and two conductive electrodes (506); and
   a plurality of supporting arms (15), each of the supporting arms comprising a first end connected to the stem and a second end connected to the LED filament;

**characterized in that** each surface of the LED chips are covered by a top layer (420a) and a base layer (420b), the top layer comprises an adhesive and a plurality of phosphors, the base layer comprises an adhesive and a plurality of phosphors;

wherein the second end of each of the supporting arms comprises a clamping portion (15a) which clamps the body of the LED filament and the inner shape of the clamping portion is fitted with the outer shape of the LED filament, such that the orientation of the cross-section of the LED filament is properly adjusted to face toward a predetermined direction;

wherein the LED filament is flexible LED filament and is bent to form a three-dimensional shape in the bulb shell, such that the LED light bulb emits omnidirectional light;

wherein points of the LED filament in an xyz coordinates are defined as X, Y, and Z and the three-dimensional shape satisfies a curve equation, an origin of the xyz coordinates is at the stem top, an x-y plane of the xyz coordinates passes through the stem top and is perpendicular to the height direction, a z-axis of the xyz coordinates is coaxial with the stem, and the two conductive electrodes are disposed at two sides of a y-axis of the xyz coordinates, the curve equation is:

$$X = m1*\cos(t*360),$$

where m1 is 24 < m1 < 27mm,

$$Y = m2*\sin(t*360),$$

where m2 is 24 < m2 < 27mm,

$$Z = n*\cos(t*360*k),$$

where n is $0 < n \leq 14$mm, wherein, t is a variable between 0 and 1, the LED filament varies along an x-direction, a y-direction, and a z-direction according to t; wherein, when X=0, a max value of |Y| is m2, and a max value of |Z| is n; wherein, when Y = 0, a max value of |X| is m1, the max value of |Z| is n; wherein, when Z = 0, the max value of |X| is m1, and the max value of |Y| is m2; wherein, m1 is a length in the x-direction, m2 is a length in the y-direction, n is a height of the highest point from the x-y plane in the z-direction, and k is a number of the highest point (s) where k is an integer and $2 \leq k \leq 8$.

**2.** The LED light bulb of claim 1, wherein cross sections of the bulb shell on the horizontal plane from the bottom to the top of the bulb shell along the height direction have varied radii, r is the largest value of the varied radii, wherein m1 is set as :

$$0.8*r \le m1 \le 0.9*r.$$

**3.** The LED light bulb of claim 1, wherein cross sections of the bulb shell on the horizontal plane from the bottom to the top of the bulb shell along the height direction have varied radii, r is the largest value of the varied radii, wherein m2 is set as :

$$0.8*r \le m2 \le 0.9*r.$$

**4.** The LED light bulb of claim 1, wherein cross sections of the bulb shell on the horizontal plane from the bottom to the top of the bulb shell along the height direction have varied radii, r is the largest value of the varied radii, wherein n is set as : 0< n≤0.47*r.

**5.** The LED light bulb of any of claims 1-4, wherein a face of the top layer is the main lighting face (Lm), the LED filament is wriggled with twists and turns while the main lighting face (Lm) is oriented toward the bulb shell or the bulb base at any angle.

**Patentansprüche**

**1.** Eine LED-Glühlampe, die Folgendes umfasst:

eine Lampenhülle (12);
eine Lampenbasis (16), die mit der Lampenhülle verbunden ist;
einen Stiel (19), der innerhalb der Lampenhülle angeordnet ist;
mindestens zwei leitende Stützen (51a, 51b), die mit dem Stiel verbunden sind;
ein LED-Filament (100), das eine Vielzahl von LED-Chips (102, 104) und zwei leitende Elektroden (506) umfasst; und
eine Vielzahl von Stützarmen (15), wobei jeder der Stützarme ein erstes Ende, das mit dem Stiel verbunden ist, und ein zweites Ende, das mit dem LED-Filament verbunden ist, umfasst;
**dadurch gekennzeichnet, dass** jede Oberfläche der LED-Chips mit einer Decklage (420a) und einer Basislage (420b) bedeckt ist, wobei die Decklage einen Klebstoff und eine Vielzahl von Phosphoren umfasst, wobei die Basislage einen Klebstoff und eine Vielzahl von Phosphoren umfasst;
wobei das zweite Ende von jedem der Stützarme einen Klemmabschnitt (15a) umfasst, der den Körper des LED-Filaments festklemmt, und die innere Form des Klemmabschnitts mit der äußeren Form des LED-Filaments so montiert ist, dass die Orientierung des Querschnitts des LED-Filaments korrekt angepasst ist, um einer vorbestimmten zugewandt zu sein;
wobei das LED-Filament ein flexibles LED-Filament ist und gebogen ist, um eine dreidimensionale Form in der Lampenhülle zu bilden, sodass die LED-Glühlampe omnidirektionales Licht emittiert;
wobei Punkte des LED-Filaments in xyz-Koordinaten als X, Y und Z definiert ist und die dreidimensionale Form eine Kurvengleichung erfüllt, ein Ursprung der xyz-Koordinaten an der Stieloberseite liegt, eine x-y-Ebene der xyz-Koordinaten durch die Stieloberseite verläuft und zu der Höhenrichtung perpendikular liegt, eine z-Achse der xyz-Koordinaten mit dem Stiel koaxial ist und die zwei leitenden Elektroden an zwei Seiten einer y-Achse der xyz-Koordinaten angeordnet sind, wobei die Kurvengleichung wie folgt ist:

$$X = m1 * \cos(t * 360),$$

wobei m1 24 < m1 < 27 mm ist,

$$Y = m2 * \sin(t * 360),$$

wobei m2 24 < m2 < 27 mm ist,

$$Z = n * \cos(t * 360 * k),$$

wobei n 0 < n ≤ 14 mm ist, wobei t eine Variable zwischen 0 und 1 ist, das LED-Filament entlang einer x-Richtung, einer y-Richtung und einer z-Richtung gemäß t variiert; wobei, wenn X = 0, ein max. Wert von |Y| m2 ist und ein max. Wert von |Z| n ist; wobei, wenn Y = 0, ein max. Wert von |X| m1 ist, der max. Wert von |Z| n ist; wobei, wenn Z = 0, der max. Wert von |X| m1 ist und der max. Wert von |Y| m2 ist; wobei m1 eine Länge in der x-Richtung ist, m2 eine Länge in der y-Richtung ist, n eine Höhe des höchsten Punktes von der x-y-Ebene in der z-Richtung ist und k eine Zahl des höchsten Punktes (s) ist, wobei k eine ganze Zahl und 2 ≤ k ≤ 8.

**2.** Die LED-Glühlampe nach Anspruch 1, wobei Querschnitte der Lampenhülle auf der horizontalen Ebene von der Unterseite zu der Oberseite der Lampenhülle entlang der Höhenrichtung unterschiedliche Radien aufweisen, wobei r der größte Wert der unterschiedlichen Radien ist, wobei m1 wie folgt festgelegt ist: 0,8 * r ≤ m1 ≤ 0,9 * r.

3. Die LED-Glühlampe nach Anspruch 1, wobei Querschnitte der Lampenhülle auf der horizontalen Ebene von der Unterseite zu der Oberseite der Lampenhülle entlang der Höhenrichtung unterschiedliche Radien aufweisen, wobei r der größte Wert der unterschiedlichen Radien ist, wobei m2 wie folgt festgelegt ist: 0,8 * r ≤ m2 ≤ 0,9 * r.

4. Die LED-Glühlampe nach Anspruch 1, wobei Querschnitte der Lampenhülle auf der horizontalen Ebene von der Unterseite zu der Oberseite der Lampenhülle entlang der Höhenrichtung unterschiedliche Radien aufweisen, wobei r der größte Wert der unterschiedlichen Radien ist, wobei n wie folgt festgelegt ist: 0 < n ≤ 0,47 * r.

5. Die LED-Glühlampe nach einem der Ansprüche 1-4, wobei eine Fläche der Deckklage die Hauptlichtfläche (Lm) ist, das LED-Filament mit Windungen und Biegungen gewunden ist, während die Hauptlichtfläche (Lm) auf die Lampenhülle oder die Lampenbasis in jedem beliebigen Winkel ausgerichtet ist.

## Revendications

1. Ampoule à diode électroluminescente, comportant :

   une enveloppe d'ampoule (12) ;
   un culot d'ampoule (16) raccordé à l'enveloppe d'ampoule ;
   une tige (19) disposée à l'intérieur de l'enveloppe d'ampoule ;
   au moins deux supports conducteurs (51a, 51b) raccordés à la tige ;
   un filament à DEL (100) comportant une pluralité de puces à DEL (102, 104) et deux électrodes conductrices (506) ; et
   une pluralité de bras de support (15), chacun des bras de support comportant une première extrémité raccordée à la tige et une deuxième extrémité raccordée au filament àDEL;
   **caractérisée en ce que** chaque surface des puces à DEL est recouverte d'une couche supérieure (420a) et d'une couche de base (420b), la couche supérieure comporte un adhésif et une pluralité de phosphores, la couche de base comporte un adhésif et une pluralité de phosphores ;
   dans laquelle la deuxième extrémité de chacun des bras de support comporte une partie de serrage (15a) qui serre le corps du filament à DEL et la forme intérieure de la partie de serrage comporte la forme extérieure du filament à DEL, de telle sorte que l'orientation de la coupe transversale du filament à DEL est correctement ajustée à des fins d'orientation vers une direction prédéterminée ;
dans laquelle le filament à DEL est un filament à DEL flexible et est courbé pour réaliser une forme tridimensionnelle dans l'enveloppe d'ampoule, de telle sorte que l'ampoule à DEL émet une lumière omnidirectionnelle ;
dans laquelle des points du filament à DEL selon des coordonnées xyz sont définis comme étant X, Y et Z et la forme tridimensionnelle satisfait à une équation de courbe, une origine des coordonnées xyz se trouve au niveau de la partie supérieure de la tige, un plan x-y des coordonnées xyz passe par la partie supérieure de la tige et est perpendiculaire par rapport à la direction allant dans le sens de la hauteur, un axe z des coordonnées xyz est coaxial par rapport à la tige, et les deux électrodes conductrices sont disposées des deux côtés d'un axe y des coordonnées xyz, l'équation de courbe est :

$$X = m1 * \cos(t*360),$$

où m1 est 24 < m1 < 27 mm,

$$Y = m2 * \sin(t*360),$$

où m2 est 24 < m2 < 27 mm,

$$Z = n * \cos(t*360*k),$$

où n est 0 < n ≤ 14 mm, dans laquelle t est une variable entre 0 et 1, le filament à DEL varie le long d'une direction x, d'une direction y et d'une direction z en fonction de t ; dans laquelle, quand X=0, une valeur max de |Y| est m2, et une valeur max de |Z| est n ; dans laquelle, quand Y=0, une valeur max de |X| est m1, la valeur max de |Z| est n ; dans laquelle, quand Z =0, la valeur max de |X| est m1, et la valeur max de |Y| est m2 ; dans laquelle m1 est une longueur dans la direction x, m2 est une longueur dans la direction y, n est une hauteur du point le plus haut par rapport au plan x-y dans la direction z, et k est un nombre du (des) point(s) le(s) plus haut(s) où k est un chiffre entier et 2 ≤ k ≤ 8.

2. Ampoule à diode électroluminescente selon la revendication 1, dans laquelle les sections transversales de l'enveloppe d'ampoule sur le plan horizontal depuis la partie inférieure jusqu'à la partie supérieure de l'enveloppe d'ampoule le long de la direction allant dans le sens de la hauteur ont des rayons variés, r est la valeur la plus grande des rayons variés, dans laquelle m1 est prédéfinie comme étant :

0,8*r≤m1≤0,9*r.

3. Ampoule à diode électroluminescente selon la revendication 1, dans laquelle les sections transversales de l'enveloppe d'ampoule sur le plan horizontal depuis la partie inférieure jusqu'à la partie supérieure de l'enveloppe d'ampoule le long de la direction allant dans le sens de la hauteur ont des rayons variés, r est la valeur la plus grande des rayons variés, dans laquelle m2 est prédéfinie comme étant : 0,8*r≤m2≤0,9*r.

4. Ampoule à diode électroluminescente selon la revendication 1, dans laquelle les sections transversales de l'enveloppe d'ampoule sur le plan horizontal depuis la partie inférieure jusqu'à la partie supérieure de l'enveloppe d'ampoule le long de la direction allant dans le sens de la hauteur ont des rayons variés, r est la valeur la plus grande des rayons variés, dans laquelle n est prédéfinie comme étant : 0<n≤0,47*r.

5. Ampoule à diode électroluminescente selon l'une quelconque des revendications 1 à 4, dans laquelle une face de la couche supérieure est la face d'éclairage principale (Lm), le filament à DEL est tortillé avec des torsions et des courbures alors que la face d'éclairage principale (Lm) est orientée vers l'enveloppe d'ampoule ou le culot d'ampoule selon n'importe quel angle.

FIG.1

FIG.2

EP 3 449 177 B1

FIG.3

FIG.4

504a 102

FIG.7A

504b 102

FIG.7B

EP 3 449 177 B1

504c

102

FIG.7C

504d

102

FIG.7D

EP 3 449 177 B1

FIG.8A

FIG.8B

FIG.8C

510    102    516

FIG.8D

516    102a    438    102

FIG.8E

920    102    102a

920    516

FIG.8F

432

102

430

**FIG.9A**

432

524

102

430

506

A  C  A  C  A  C  A  C  A  C

**FIG.9B**

FIG.10A

FIG.10B

FIG.10C

FIG.11A

FIG.11B

FIG.11C

EP 3 449 177 B1

108a          MS

934

## FIG.12A

524          432p          108a          432

934

Ms

## FIG.12B

FIG.12C

FIG.12D

EP 3 449 177 B1

FIG.13

FIG.33

FIG.34

**FIG.35A**

**FIG.35B**

FIG.36

FIG.37

FIG.38A

506

540c
540f } 540

102
540p

104

506

FIG.38B

540a

540c

540f

FIG.39A

506

540c
540f } 540

102

104

506

FIG.39B

540b

540c

540f

## FIG.40A

506

540c
540f } 540b

102

104

506

**FIG.40B**

FIG.41A

980

506

540c
540a
540f

102

104

506

FIG.41B

**FIG.41C**

**FIG.41D**

FIG.41E

EP 3 449 177 B1

506

420b

506    504    102    104

980

FIG.42

FIG.43A

EP 3 449 177 B1

FIG.43B

EP 3 449 177 B1

FIG.43C

FIG.43D

FIG.43E

20a

12

100

506

51

506

51

19

17

518

16

L2

L1

**FIG.44A**

20b

506    15    506

12

100

51a

51b

19

17

518

16

## FIG.44B

20c

12

45B

15

100

51b

51a

19a

19

518

16

**FIG.45A**

420a  530  420b

15a

10

15

**FIG.45B**

20c

12

15

z
x
y

100

51b

51a

19a

19

518

16

## FIG.45C

r

θ

## FIG.45D

FIG.45E

FIG.45F

FIG.45G

FIG.45H

FIG.45I

FIG.45J

FIG.45K

**FIG.45L**

FIG.45M

1208

12

1218

FIG.45N

FIG.46A

FIG.46B

**EP 3 449 177 B1**

## REFERENCES CITED IN THE DESCRIPTION

**Patent documents cited in the description**

- CN 201610281600
- CN 201610272153
- CN 201610394610
- CN 201610586388
- CN 201610544049
- CN 201610936171
- CN 201611108722
- CN 201710024877
- CN 201710079423
- CN 201710138009
- CN 201710180574
- CN 201710234618